(19)

Europäisches Patentamt

European Patent Office

Office européen des brevets

(11) **EP 4 593 321 A1**

(12) **EUROPEAN PATENT APPLICATION**
published in accordance with Art. 153(4) EPC

(43) Date of publication:
**30.07.2025 Bulletin 2025/31**

(21) Application number: **23881346.3**

(22) Date of filing: **21.07.2023**

(51) International Patent Classification (IPC):
***H04L 7/033*** (2006.01)

(52) Cooperative Patent Classification (CPC):
**H04L 1/00; H04L 7/033**

(86) International application number:
**PCT/CN2023/108745**

(87) International publication number:
**WO 2024/087758 (02.05.2024 Gazette 2024/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 24.10.2022 CN 202211307290
06.12.2022 CN 202211559068
30.05.2023 CN 202310631032

(71) Applicant: **Huawei Technologies Co., Ltd.
Shenzhen, Guangdong 518129 (CN)**

(72) Inventors:
• **HUANG, Kechao
Shenzhen, Guangdong 518129 (CN)**

• **MA, Huixiao
Shenzhen, Guangdong 518129 (CN)**
• **YANG, Xiaoling
Shenzhen, Guangdong 518129 (CN)**
• **YAN, Zengchao
Shenzhen, Guangdong 518129 (CN)**
• **LIN, Youxi
Shenzhen, Guangdong 518129 (CN)**
• **HUANG, Qinhui
Shenzhen, Guangdong 518129 (CN)**

(74) Representative: **Huawei European IPR
Huawei Technologies Duesseldorf GmbH
Riesstraße 25
80992 München (DE)**

(54) **DATA PROCESSING METHOD AND DATA PROCESSING DEVICE**

(57)    This application discloses a data processing method and a data processing apparatus. First data processing is performed on a plurality of first data streams obtained through first FEC encoding, to obtain m second data streams. Second FEC encoding has been performed for each of the second data streams, and each codeword obtained through the second FEC encoding includes N bits, where N=K+S, K represents a quantity of information bits, and S represents a quantity of parity bits. Second data processing is separately performed on the m second data streams to obtain m third data streams. Each of the third data streams includes at least one bit sequence, each bit sequence includes P+W bits, the P bits in each bit sequence are from the second data stream, and the W bits in each bit sequence are an added alignment marker, where P=N×b. Third data processing is performed on the m third data streams to obtain Y modulated symbol streams, where modulation has been performed for each of the modulated symbol streams, and a value of a baud rate of each of the modulated symbol streams is an integer multiple of a value of an Ethernet common reference clock frequency.

[FIG. 3]

```
┌─────────────────────────────────────────────────┐
│ Perform first data processing on a plurality of  │─── 301
│ first data streams to obtain m second data streams│
└─────────────────────────────────────────────────┘
                        ↓
┌─────────────────────────────────────────────────┐
│ Separately perform second data processing on the │─── 302
│ m second data streams to obtain m third data streams│
└─────────────────────────────────────────────────┘
                        ↓
┌─────────────────────────────────────────────────┐
│ Perform third data processing on the m third data │─── 303
│ streams to obtain Y modulated symbol streams      │
└─────────────────────────────────────────────────┘
```

**Description**

This application claims priorities to Chinese Patent Application No. 202211307290.5, filed with the China National Intellectual Property Administration on October 24, 2022 and entitled "DATA PROCESSING METHOD AND DATA PROCESSING APPARATUS", to Chinese Patent Application No. 202211559068.4, filed with the China National Intellectual Property Administration on December 6, 2022 and entitled "DATA PROCESSING METHOD AND DATA PROCESSING APPARATUS", and to Chinese Patent Application No. 202310631032.0, filed with the China National Intellectual Property Administration on May 30, 2023 and entitled "DATA PROCESSING METHOD AND DATA PROCESSING APPARATUS", all of which are incorporated herein by reference in their entireties.

TECHNICAL FIELD

This application relates to the communication field, and in particular, to a data processing method and a data processing apparatus.

BACKGROUND

Continuously driven by 5G, cloud computing, big data, artificial intelligence, and the like, an Ethernet network is developing toward a larger capacity, a higher rate, and lower latency. Forward error correction (forward error correction, FEC) encoding is used to correct transmitted data, and resolve transmission bit errors to restore, from received data, original data sent by a transmitter.

Currently, a concatenated FEC-based transmission solution is provided, and a transmitter device is connected to a transmitter processing module through an attachment unit interface (attachment unit interface, AUI). The transmitter device performs first FEC encoding on to-be-transmitted data, and sends, to the transmitter processing module, data obtained through the first FEC encoding. The transmitter processing module performs second FEC encoding on the data obtained through the first FEC encoding, performs modulation and mapping on a bit sequence obtained through the second FEC encoding, to generate a corresponding modulated symbol sequence, and finally sends the generated modulated symbol sequence to a receiver through an optical fiber. Data streams received by the receiver are asynchronous and contain noise. Generally, phase locked loop (Phase Locked Loop, PLL)-based clock and data recovery (Clock and Data Recovery, CDR) is performed. To be specific, a clock is extracted from data, and "retiming" is performed on the data to remove jitter that occurs in a transmission process. Then, demodulation and decoding are performed to recover original data sent by a transmitter. However, in the existing solution, implementation of a PLL circuit used for CDR performed by the receiver is complex, and PLL jitter is high.

SUMMARY

Embodiments of this application provide a data processing method and a data processing apparatus, to simplify clock extraction and synchronization manners of a receiver, implement fast phase locking, and achieve low PLL complexity and low jitter; and to simplify operations such as frame synchronization and inner codeword synchronization of the receiver, and achieve low implementation complexity.

According to a first aspect, an embodiment of this application provides a data processing method. The method is applied to a transmitter, and includes the following steps. First, first data processing is performed on a plurality of first data streams obtained through first FEC encoding, to obtain m second data streams. m is an integer greater than 1. Second FEC encoding has been performed for each of the second data streams, and each codeword obtained through the second FEC encoding includes N bits, where N=K+S, K represents a quantity of information bits, S represents a quantity of parity bits, K is an integer greater than or equal to 1, and S is an integer greater than or equal to 1. Next, second data processing is separately performed on the m second data streams to obtain m third data streams. Each of the third data streams includes at least one bit sequence, each bit sequence includes P+W bits, the P bits in each bit sequence are from the second data stream, and the W bits in each bit sequence are an added alignment marker, where P=N×b, and b is an integer greater than or equal to 1. Further, third data processing is performed on the m third data streams to obtain Y modulated symbol streams, where Y is an integer greater than or equal to 1, modulation has been performed for each of the modulated symbol streams, and a value of a baud rate of each of the modulated symbol streams is an integer multiple of a value of a reference clock frequency.

In this implementation, the P bits are periodically obtained from the data stream obtained through concatenated FEC encoding, and the alignment marker with a length of W bits is inserted, so that the alignment marker with a length of W bits exists in every P+W bits in the data stream. The positive integers P and W are selected, so that the value of the baud rate of the modulated symbol data stream is the integer multiple of an Ethernet common reference clock (Ethernet common reference clock) frequency. This simplifies clock extraction and synchronization manners of a receiver, implements fast phase locking, and achieves low PLL complexity and low jitter. In addition, P needs to be a multiple of a code length N of an inner code, in other words, $P = N \times b$, and inner codeword synchronization can be ensured after the receiver performs frame synchronization (namely, frame synchronization of the P+W bits, also referred to as an alignment marker lock operation) on received data. This simplifies operations such as the frame synchronization and the inner codeword synchronization of the receiver, and achieves low implementation complexity.

In some possible implementations, the value of the baud rate of each of the modulated symbol streams is an integer multiple of 156.25M.

In some possible implementations, convolutional interleaving is performed for each of the second data streams before the second FEC encoding. The convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits. Bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a 0$^{th}$ delay line each time f bits are output through the convolutional interleaving, where K×b is exactly divisible by f. A start position of each frame (W+P bits) should correspond to start positions of input and output switches (input and output switches) of a convolutional de-interleaver, and the start positions are usually topmost positions (topmost positions). More specifically, input and output switches of a convolution interleaver are at topmost positions each time the convolution interleaver output f bits, and the input and output switches of the convolution de-interleaver are at the topmost positions each time the convolution de-interleaver output f bits, so that synchronization performed by the convolution de-interleaver can be ensured during the frame synchronization.

In some possible implementations, r×d×c=K×b, and c is an integer greater than or equal to 1. To be specific, the convolution interleaver and the convolution de-interleaver may output K×b bits every c round-robin times. In this case, the input and output switches of the convolution interleaver and the convolution de-interleaver are at the start positions of the switches, so that the synchronization performed by the convolution de-interleaver can be ensured during the frame synchronization.

In some possible implementations, a rate of the first data stream is 850 Gbps, $\frac{850}{8} \times \frac{N}{K} \times \frac{P+W}{P} G = a \times 156.25M$, a is an integer greater than or equal to 1, G represents 10^9, and M represents 10^6.

In some possible implementations, N=128, K=120, and $a = \frac{2176}{3} \times \frac{P+W}{P}$.

In some possible implementations, W=48, P=13056, a=728, b=102, and the baud rate=113.75 Gbaud;

W=48, P=52224, a=726, b=408, and the baud rate=113.4375 Gbaud;
W=56, P=15232, a=728, b=119, and the baud rate=113.75 Gbaud;
W=56, P=60928, a=726, b=476, and the baud rate=113.4375 Gbaud;
W=64, P=13056, a=728, b=102, and the baud rate=113.75 Gbaud;
W=64, P=69632, a=726, b=544, and the baud rate=113.4375 Gbaud;
W=120, P=32640, a=728, b=255, and the baud rate=113.75 Gbaud;
W=120, P=52224, a=727, b=408, and the baud rate=113.5938 Gbaud;
W=120, P=130560, a=726, b=1020, and the baud rate=113.4375 Gbaud;
W=128, P=34816, a=728, b=272, and the baud rate=113.75 Gbaud; or
W=128, P=139264, a=726, b=1088, and the baud rate=113.4375 Gbaud.

In some possible implementations, N=170, K=160, and $a = \frac{1445}{2} \times \frac{P+W}{P}$.

In some possible implementations, W=48, P=23120, a=724, b=136, and the baud rate=113.125 Gbaud;

W=48, P=69360, a=723, b=408, and the baud rate=112.9688 Gbaud;
W=56, P=11560, a=726, b=68, and the baud rate=113.4375 Gbaud;
W=56, P=80920, a=723, b=476, and the baud rate=112.9688 Gbaud;
W=64, P=92480, a=723, b=544, and the baud rate=112.9688 Gbaud;
W=120, P=34680, a=725, b=204, and the baud rate=113.2813 Gbaud;

W=120, P=57800, a=724, b=340, and the baud rate=113.125 Gbaud;
W=120, P=173400, a=723, b=1020, and the baud rate=112.9688 Gbaud;
W=170, P=49130, a=725, b=289, and the baud rate=113.2813 Gbaud; or
W=170, P=245650, a=723, b=1445, and the baud rate=112.9688 Gbaud.

In some possible implementations, N=144, K=136, and $a = 720 \times \frac{P+W}{P}$.

In some possible implementations, W=48, P=5760, a=726, b=40, and the baud rate=113.4375 Gbaud;

W=48, P=8640, a=724, b=60, and the baud rate=113.125 Gbaud;
W=48, P=11520, a=723, b=80, and the baud rate=112.9688 Gbaud;
W=48, P=17280, a=722, b=120, and the baud rate=112.8125 Gbaud;
W=48, P=34560, a=721, b=240, and the baud rate=112.6563 Gbaud;
W=56, P=5760, a=727, b=40, and the baud rate=113.5938 Gbaud;
W=56, P=20160, a=722, b=140, and the baud rate=112.8125 Gbaud;
W=56, P=40320, a=721, b=280, and the baud rate=112.6563 Gbaud;
W=64, P=5760, a=728, b=40, and the baud rate=113.75 Gbaud;
W=64, P=11520, a=724, b=80, and the baud rate=113.125 Gbaud;
W=64, P=23040, a=722, b=160, and the baud rate=112.8125 Gbaud;
W=64, P=46080, a=721, b=320, and the baud rate=112.6563 Gbaud;
W=120, P=14400, a=726, b=100, and the baud rate=113.4375 Gbaud;
W=120, P=17280, a=725, b=120, and the baud rate=113.2813 Gbaud;
W=120, P=28800, a=723, b=200, and the baud rate=112.9688 Gbaud;
W=120, P=43200, a=722, b=300, and the baud rate=112.8125 Gbaud;
W=120, P=86400, a=721, b=600, and the baud rate=112.6563 Gbaud;
W=144, P=11520, a=729, b=80, and the baud rate=113.9063 Gbaud;
W=144, P=17280, a=726, b=120, and the baud rate=113.4375 Gbaud;
W=144, P=25920, a=724, b=180, and the baud rate=113.125 Gbaud;
W=144, P=34560, a=723, b=240, and the baud rate=112.9688 Gbaud;
W=144, P=51840, a=723, b=360, and the baud rate=112.8125 Gbaud; or
W=144, P=103680, a=721, b=720, and the baud rate=112.6563 Gbaud.

In some possible implementations, W=56, P=5040, a=728, b=35, and the baud rate=113.75 Gbaud;

W=56, P=10080, a=724, b=70, and the baud rate=113.125 Gbaud;
W=56, P=20160, a=722, b=140, and the baud rate=112.8125 Gbaud; or
W=56, P=40320, a=721, b=280, and the baud rate=112.6563 Gbaud.

In some possible implementations, N=148, K=140, W is a multiple of 4, and b is a multiple of 17.
In some possible implementations, N=128, K=120, and the baud rate of the modulated symbol stream is 113.4375 Gbaud.
In some possible implementations, P = 1088 × W.
In some possible implementations, the alignment marker includes at least one frame synchronization sequence with a length of 48 bits.
In some possible implementations, the 48 bits of the frame synchronization sequence are consecutive in the alignment marker.
In some possible implementations, values of the 48 bits of the frame synchronization sequence include 0x9A, 0x4A, 0x26, 0x65, 0xB5, and 0xD9.
In some possible implementations, the frame synchronization sequence includes two frame synchronization subsequences, a bit length of each of the frame synchronization subsequences is 24 bits, and the two frame synchronization subsequences are separated by eight bits in the alignment marker.
In some possible implementations, values of 24 bits of one of the two frame synchronization subsequences include 0x9A, 0x4A, and 0x26, and values of 24 bits of the other of the two frame synchronization subsequences include 0x65, 0xB5, and 0xD9.
In some possible implementations, the alignment marker includes a padding bit and/or a status field.
In some possible implementations, W is exactly divisible by N.
In some possible implementations, at least one of the following operations is performed for each of the second data streams before the second FEC encoding: alignment marker lock, lane de-skewing, and lane reordering; and/or at least one of the following operations is further performed for each of the second data streams after the second FEC encoding: channel interleaving and scrambling.

In some possible implementations, that first data processing is performed on a plurality of first data streams to obtain m second data streams includes: separately performing second FEC encoding on each group of eight first data streams in the plurality of first data streams to obtain each group of eight encoded data streams; and performing channel interleaving on each group of eight encoded data streams to obtain one second data stream, to obtain the m second data streams.

In some possible implementations, N=128, K=120, and the performing channel interleaving on each group of eight encoded data streams to obtain one second data stream includes: obtaining one inner codeword with a length of 128 bits from each encoded data stream in each group of eight encoded data streams, to obtain eight inner codewords in total; and obtaining two bits from each of the eight inner codewords in a round-robin fashion, to obtain 1024 consecutive bits in the second data stream.

In some possible implementations, cyclic shift is performed for each of the second data streams before the second FEC encoding.

In some possible implementations, that first data processing is performed on a plurality of first data streams includes: separately performing convolutional interleaving on $8 \times m$ first data streams; separately performing cyclic shift on $8 \times m$ convolutional interleaved first data streams; and separately performing second FEC encoding on $8 \times m$ cyclic shifted first data streams.

In some possible implementations, that first data processing is performed on a plurality of first data streams includes: separately performing convolutional interleaving on $2 \times m$ first data streams; distributing each convolutional interleaved first data stream, to obtain four distributed first data streams, so as to obtain $8 \times m$ distributed first data streams in total; separately performing cyclic shift on the $8 \times m$ distributed first data streams; and separately performing second FEC encoding on $8 \times m$ cyclic shifted first data streams.

In some possible implementations, that first data processing is performed on a plurality of first data streams includes: separately performing convolutional interleaving on m first data streams; distributing each convolutional interleaved first data stream, to obtain eight distributed first data streams, so as to obtain $8 \times m$ distributed first data streams in total; separately performing cyclic shift on the $8 \times m$ distributed first data streams; and separately performing second FEC encoding on $8 \times m$ cyclic shifted first data streams.

In some possible implementations, to achieve lower latency, lower complexity, and lower power consumption, the cyclic shift operation and/or the channel interleaving operation may alternatively be bypassed (bypassed). Specifically, that first data processing is performed on a plurality of first data streams to obtain m second data streams includes: first, distributing each of m first data streams to obtain eight distributed first data streams, so as to obtain $8 \times m$ distributed first data streams in total; then, separately performing second FEC encoding on the $8 \times m$ distributed first data streams to obtain $8 \times m$ encoded data streams; and performing codeword merging (codeword merging) on every eight encoded data streams in the $8 \times m$ encoded data streams to obtain one second data stream, so as to obtain the m second data streams in total. It should be understood that, performing codeword merging on eight encoded data streams is equivalent to performing one-way Hamming codeword interleaving (one-way Hamming codeword interleaving) on the eight encoded data streams.

In some possible implementations, the alignment marker includes at least one target codeword, and the target codeword includes N bits.

In some possible implementations, the target codeword is obtained by performing second FEC encoding on K-bit alignment marker information. It should be understood that the target codeword may also be referred to as an inner codeword, and selecting one or more inner codewords as a specific pattern of the alignment marker helps the receiver implement low-complexity frame synchronization and codeword synchronization.

In some possible implementations, the alignment marker is obtained by performing codeword interleaving on a plurality of target codewords. For example, each alignment marker is obtained by performing eight-way codeword interleaving on eight target codewords. The codeword interleaving herein may also be referred to as channel interleaving. It should be understood that, the alignment marker obtained by performing codeword interleaving on the plurality of target codewords should also be considered to include the plurality of target codewords. Alternatively, each alignment marker is obtained by performing codeword merging on a plurality of target codewords. For example, each alignment marker is obtained by performing codeword merging on eight target codewords. The codeword merging herein may also be referred to as one-way codeword interleaving.

According to a second aspect, an embodiment of this application provides a data processing method. The method is applied to a receiver, and includes the following steps. First, fourth data processing is performed on received Y modulated symbol streams to obtain m fourth data streams. Demodulation is performed for each of the fourth data streams, the Y modulated symbol streams are obtained by performing third data processing on m third data streams, modulation has been performed for each of the modulated symbol streams, the m third data streams are obtained by separately performing second data processing on m second data streams, and the m second data streams are obtained by performing first data processing on a plurality of first data streams obtained through first FEC encoding, where Y is an integer greater than or equal to 1, and m is an integer greater than 1. Second FEC encoding has been performed for each of the second data streams, and each codeword obtained through the second FEC encoding includes N bits, where N=K+S, K represents a quantity of information bits, S represents a quantity of parity bits, K is an integer greater than or equal to 1, and S is an integer greater than or equal to 1. Each of the third data streams includes at least one bit sequence, each bit sequence includes P+W bits, the P bits in each bit sequence are from the second data stream, and the W bits in each bit sequence are an added alignment marker, where P=N×b, b is an integer greater than or equal to 1, and a value of a baud rate of each of the modulated symbol streams is an integer multiple of a value of a reference clock frequency. Further, frame synchronization is performed on each of the fourth data streams based on an alignment marker in each of the fourth data streams.

In some possible implementations, the value of the baud rate of each of the modulated symbol streams is an integer multiple of 156.25M.

In some possible implementations, convolutional interleaving is performed for each of the second data streams before the second FEC encoding. The convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits. Bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a 0th delay line each time f bits are output through the convolutional interleaving, where K×b is exactly divisible by f. A start position of each frame (W+P bits) should correspond to start positions of input and output switches (input and output switches) of a convolutional de-interleaver, and the start positions are usually topmost positions (topmost positions). More specifically, input and output switches of a convolution interleaver are at topmost positions each time the convolution interleaver output f bits, and the input and output switches of the convolution de-interleaver are at the topmost positions each time the convolution de-interleaver output f bits, so that synchronization performed by the convolution de-interleaver can be ensured during the frame synchronization.

In some possible implementations, r×d×c=K×b, and c is an integer greater than or equal to 1. To be specific, the convolution interleaver and the convolution de-interleaver may output K×b bits every c round-robin times. In this case, the input and output switches of the convolution interleaver and the convolution de-interleaver are at the start positions of the switches, so that the synchronization performed by the convolution de-interleaver can be ensured during the frame synchronization.

In some possible implementations, a rate of the first data stream is 850 Gbps,

$$\frac{850}{8} \times \frac{N}{K} \times \frac{P+W}{P} G = a \times 156.25M$$

, a is an integer greater than or equal to 1, G represents 10^9, and M represents 10^6.

In some possible implementations, N=128, K=120, and $a = \overline{\frac{2176}{3} \times \frac{P+W}{P}}$.

In some possible implementations, W=48, P=13056, a=728, b=102, and the baud rate=113.75 Gbaud;

W=48, P=52224, a=726, b=408, and the baud rate=113.4375 Gbaud;
W=56, P=15232, a=728, b=119, and the baud rate=113.75 Gbaud;
W=56, P=60928, a=726, b=476, and the baud rate=113.4375 Gbaud;
W=64, P=13056, a=728, b=102, and the baud rate=113.75 Gbaud;
W=64, P=69632, a=726, b=544, and the baud rate=113.4375 Gbaud;
W=120, P=32640, a=728, b=255, and the baud rate=113.75 Gbaud;
W=120, P=52224, a=727, b=408, and the baud rate=113.5938 Gbaud;
W=120, P=130560, a=726, b=1020, and the baud rate=113.4375 Gbaud;
W=128, P=34816, a=728, b=272, and the baud rate=113.75 Gbaud; or
W=128, P=139264, a=726, b=1088, and the baud rate=113.4375 Gbaud.

In some possible implementations, N=170, K=160, and $a = \frac{1445}{2} \times \frac{P+W}{P}$.

In some possible implementations, W=48, P=23120, a=724, b=136, and the baud rate=113.125 Gbaud;

W=48, P=69360, a=723, b=408, and the baud rate=112.9688 Gbaud;
W=56, P=11560, a=726, b=68, and the baud rate=113.4375 Gbaud;
W=56, P=80920, a=723, b=476, and the baud rate=112.9688 Gbaud;
W=64, P=92480, a=723, b=544, and the baud rate=112.9688 Gbaud;
W=120, P=34680, a=725, b=204, and the baud rate=113.2813 Gbaud;
W=120, P=57800, a=724, b=340, and the baud rate=113.125 Gbaud;
W=120, P=173400, a=723, b=1020, and the baud rate=112.9688 Gbaud;
W=170, P=49130, a=725, b=289, and the baud rate=113.2813 Gbaud; or
W=170, P=245650, a=723, b=1445, and the baud rate=112.9688 Gbaud.

In some possible implementations, N=144, K=136, and $a = 720 \times \frac{P+W}{P}$.

In some possible implementations, W=48, P=5760, a=726, b=40, and the baud rate=113.4375 Gbaud;

W=48, P=8640, a=724, b=60, and the baud rate=113.125 Gbaud;
W=48, P=11520, a=723, b=80, and the baud rate=112.9688 Gbaud;
W=48, P=17280, a=722, b=120, and the baud rate=112.8125 Gbaud;
W=48, P=34560, a=721, b=240, and the baud rate=112.6563 Gbaud;
W=56, P=5760, a=727, b=40, and the baud rate=113.5938 Gbaud;
W=56, P=20160, a=722, b=140, and the baud rate=112.8125 Gbaud;
W=56, P=40320, a=721, b=280, and the baud rate=112.6563 Gbaud;
W=64, P=5760, a=728, b=40, and the baud rate=113.75 Gbaud;
W=64, P=11520, a=724, b=80, and the baud rate=113.125 Gbaud;
W=64, P=23040, a=722, b=160, and the baud rate=112.8125 Gbaud;
W=64, P=46080, a=721, b=320, and the baud rate=112.6563 Gbaud;
W=120, P=14400, a=726, b=100, and the baud rate=113.4375 Gbaud;
W=120, P=17280, a=725, b=120, and the baud rate=113.2813 Gbaud;
W=120, P=28800, a=723, b=200, and the baud rate=112.9688 Gbaud;
W=120, P=43200, a=722, b=300, and the baud rate=112.8125 Gbaud;
W=120, P=86400, a=721, b=600, and the baud rate=112.6563 Gbaud;
W=144, P=11520, a=729, b=80, and the baud rate=113.9063 Gbaud;
W=144, P=17280, a=726, b=120, and the baud rate=113.4375 Gbaud;
W=144, P=25920, a=724, b=180, and the baud rate=113.125 Gbaud;
W=144, P=34560, a=723, b=240, and the baud rate=112.9688 Gbaud;
W=144, P=51840, a=723, b=360, and the baud rate=112.8125 Gbaud; or
W=144, P=103680, a=721, b=720, and the baud rate=112.6563 Gbaud.

In some possible implementations, W=56, P=5040, a=728, b=35, and the baud rate=113.75 Gbaud;

W=56, P=10080, a=724, b=70, and the baud rate=113.125 Gbaud;
W=56, P=20160, a=722, b=140, and the baud rate=112.8125 Gbaud; or
W=56, P=40320, a=721, b=280, and the baud rate=112.6563 Gbaud.

In some possible implementations, N=148, K=140, W is a multiple of 4, and b is a multiple of 17.
In some possible implementations, the alignment marker includes a padding bit and/or a status field.
In some possible implementations, W is exactly divisible by N.
In some possible implementations, the alignment marker includes at least one target codeword, and the target codeword includes N bits.
In some possible implementations, the target codeword is obtained by performing second FEC encoding on K-bit alignment marker information. It should be understood that the target codeword may also be referred to as an inner codeword, and selecting one or more inner codewords as a specific pattern of the alignment marker helps the receiver implement low-complexity frame synchronization and codeword synchronization.
In some possible implementations, the alignment marker is obtained by performing codeword interleaving on a plurality of target codewords. For example, each alignment marker is obtained by performing eight-way codeword interleaving on eight target codewords. The codeword interleaving herein may also be referred to as channel interleaving.

It should be understood that, it should also be considered that the alignment marker obtained by performing codeword interleaving on the plurality of target codewords includes the plurality of target codewords. Alternatively, each alignment marker is obtained by performing codeword merging on a plurality of target codewords. For example, each alignment marker is obtained by performing codeword merging on eight target codewords. The codeword merging herein may also be referred to as one-way codeword interleaving.

According to a third aspect, an embodiment of this application provides a data processing apparatus. The data processing apparatus is used in a transmitter, and includes a first data processing unit, a second data processing unit, and a third data processing unit. The first data processing unit is configured to perform first data processing on a plurality of first data streams obtained through first forward error correction FEC encoding, to obtain m second data streams, where m is an integer greater than 1; and second FEC encoding has been performed for each of the second data streams, and each codeword obtained through the second FEC encoding includes N bits, where N=K+S, K represents a quantity of information bits, S represents a quantity of parity bits, K is an integer greater than or equal to 1, and S is an integer greater than or equal to 1. The second data processing unit is configured to separately perform second data processing on the m second data streams to obtain m third data streams, where each of the third data streams includes at least one bit sequence, each bit sequence includes P+W bits, the P bits in each bit sequence are from the second data stream, and the W bits in each bit sequence are an added alignment marker, where P=N×b, and b is an integer greater than or equal to 1. The third data processing unit is configured to perform third data processing on the m third data streams to obtain Y modulated symbol streams, where Y is an integer greater than or equal to 1, modulation has been performed for each of the modulated symbol streams, and a value of a baud rate of each of the modulated symbol streams is an integer multiple of a value of a reference clock frequency.

In some possible implementations, the value of the baud rate of each of the modulated symbol streams is an integer multiple of 156.25M.

In some possible implementations, convolutional interleaving is performed for each of the second data streams before the second FEC encoding. The convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits. Bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a $0^{th}$ delay line each time f bits are output through the convolutional interleaving, where K×b is exactly divisible by f. A start position of each frame (W+P bits) should correspond to start positions of input and output switches (input and output switches) of a convolutional de-interleaver, and the start positions are usually topmost positions (topmost positions). More specifically, input and output switches of a convolution interleaver are at topmost positions each time the convolution interleaver output f bits, and the input and output switches of the convolution de-interleaver are at the topmost positions each time the convolution de-interleaver output f bits, so that synchronization performed by the convolution de-interleaver can be ensured during frame synchronization.

In some possible implementations, r×d×c=K×b, and c is an integer greater than or equal to 1. To be specific, the convolution interleaver and the convolution de-interleaver may output K×b bits every c round-robin times. In this case, the input and output switches of the convolution interleaver and the convolution de-interleaver are at the start positions of the switches, so that the synchronization performed by the convolution de-interleaver can be ensured during the frame synchronization.

In some possible implementations, a rate of the first data stream is 850 Gbps, $\frac{850}{8} \times \frac{N}{K} \times \frac{P+W}{P} G = a \times 156.25M$, a is an integer greater than or equal to 1, G represents 10^9, and M represents 10^6.

In some possible implementations, N=128, K=120, and $a = \frac{2176}{3} \times \frac{P+W}{P}$.

In some possible implementations, W=48, P=13056, a=728, b=102, and the baud rate=113.75 Gbaud;

W=48, P=52224, a=726, b=408, and the baud rate=113.4375 Gbaud;
W=56, P=15232, a=728, b=119, and the baud rate=113.75 Gbaud;
W=56, P=60928, a=726, b=476, and the baud rate=113.4375 Gbaud;
W=64, P=13056, a=728, b=102, and the baud rate=113.75 Gbaud;
W=64, P=69632, a=726, b=544, and the baud rate=113.4375 Gbaud;

W=120, P=32640, a=728, b=255, and the baud rate=113.75 Gbaud;
W=120, P=52224, a=727, b=408, and the baud rate=113.5938 Gbaud;
W=120, P=130560, a=726, b=1020, and the baud rate=113.4375 Gbaud;
W=128, P=34816, a=728, b=272, and the baud rate=113.75 Gbaud; or
W=128, P=139264, a=726, b=1088, and the baud rate=113.4375 Gbaud.

In some possible implementations, N=170, K=160, and $a = \frac{1445}{2} \times \frac{P+W}{P}$.

In some possible implementations, W=48, P=23120, a=724, b=136, and the baud rate=113.125 Gbaud;

W=48, P=69360, a=723, b=408, and the baud rate=112.9688 Gbaud;
W=56, P=11560, a=726, b=68, and the baud rate=113.4375 Gbaud;
W=56, P=80920, a=723, b=476, and the baud rate=112.9688 Gbaud;
W=64, P=92480, a=723, b=544, and the baud rate=112.9688 Gbaud;
W=120, P=34680, a=725, b=204, and the baud rate=113.2813 Gbaud;
W=120, P=57800, a=724, b=340, and the baud rate=113.125 Gbaud;
W=120, P=173400, a=723, b=1020, and the baud rate=112.9688 Gbaud;
W=170, P=49130, a=725, b=289, and the baud rate=113.2813 Gbaud; or
W=170, P=245650, a=723, b=1445, and the baud rate=112.9688 Gbaud.

In some possible implementations, N=144, K=136, and $a = 720 \times \frac{P+W}{P}$.

In some possible implementations, W=48, P=5760, a=726, b=40, and the baud rate=113.4375 Gbaud;

W=48, P=8640, a=724, b=60, and the baud rate=113.125 Gbaud;
W=48, P=11520, a=723, b=80, and the baud rate=112.9688 Gbaud;
W=48, P=17280, a=722, b=120, and the baud rate=112.8125 Gbaud;
W=48, P=34560, a=721, b=240, and the baud rate=112.6563 Gbaud;
W=56, P=5760, a=727, b=40, and the baud rate=113.5938 Gbaud;
W=56, P=20160, a=722, b=140, and the baud rate=112.8125 Gbaud;
W=56, P=40320, a=721, b=280, and the baud rate=112.6563 Gbaud;
W=64, P=5760, a=728, b=40, and the baud rate=113.75 Gbaud;
W=64, P=11520, a=724, b=80, and the baud rate=113.125 Gbaud;
W=64, P=23040, a=722, b=160, and the baud rate=112.8125 Gbaud;
W=64, P=46080, a=721, b=320, and the baud rate=112.6563 Gbaud;
W=120, P=14400, a=726, b=100, and the baud rate=113.4375 Gbaud;
W=120, P=17280, a=725, b=120, and the baud rate=113.2813 Gbaud;
W=120, P=28800, a=723, b=200, and the baud rate=112.9688 Gbaud;
W=120, P=43200, a=722, b=300, and the baud rate=112.8125 Gbaud;
W=120, P=86400, a=721, b=600, and the baud rate=112.6563 Gbaud;
W=144, P=11520, a=729, b=80, and the baud rate=113.9063 Gbaud;
W=144, P=17280, a=726, b=120, and the baud rate=113.4375 Gbaud;
W=144, P=25920, a=724, b=180, and the baud rate=113.125 Gbaud;
W=144, P=34560, a=723, b=240, and the baud rate=112.9688 Gbaud;
W=144, P=51840, a=723, b=360, and the baud rate=112.8125 Gbaud; or
W=144, P=103680, a=721, b=720, and the baud rate=112.6563 Gbaud.

In some possible implementations, W=56, P=5040, a=728, b=35, and the baud rate=113.75 Gbaud;

W=56, P=10080, a=724, b=70, and the baud rate=113.125 Gbaud;
W=56, P=20160, a=722, b=140, and the baud rate=112.8125 Gbaud; or
W=56, P=40320, a=721, b=280, and the baud rate=112.6563 Gbaud.

In some possible implementations, N=148, K=140, W is a multiple of 4, and b is a multiple of 17.
In some possible implementations, N=128, K=120, and the baud rate of the modulated symbol stream is 113.4375 Gbaud.
In some possible implementations, P = 1088 × W.

In some possible implementations, the alignment marker includes at least one frame synchronization sequence with a length of 48 bits.

In some possible implementations, the 48 bits of the frame synchronization sequence are consecutive in the alignment marker.

In some possible implementations, values of the 48 bits of the frame synchronization sequence include 0x9A, 0x4A, 0x26, 0x65, 0xB5, and 0xD9.

In some possible implementations, the frame synchronization sequence includes two frame synchronization subsequences, a bit length of each of the frame synchronization subsequences is 24 bits, and the two frame synchronization subsequences are separated by eight bits in the alignment marker.

In some possible implementations, values of 24 bits of one of the two frame synchronization subsequences include 0x9A, 0x4A, and 0x26, and values of 24 bits of the other of the two frame synchronization subsequences include 0x65, 0xB5, and 0xD9.

In some possible implementations, the alignment marker includes a padding bit and/or a status field.

In some possible implementations, W is exactly divisible by N. In some possible implementations, at least one of the following operations is performed for each of the second data streams before the second FEC encoding: alignment marker lock, lane de-skewing, and lane reordering; and/or at least one of the following operations is further performed for each of the second data streams after the second FEC encoding: channel interleaving and scrambling.

In some possible implementations, the first data processing unit is specifically configured to: separately perform second FEC encoding on each group of eight first data streams in the plurality of first data streams to obtain each group of eight encoded data streams; and perform channel interleaving on each group of eight encoded data streams to obtain one second data stream, to obtain the m second data streams.

In some possible implementations, N=128, K=120, and the first data processing unit is specifically configured to: obtain one inner codeword with a length of 128 bits from each encoded data stream in each group of eight encoded data streams, to obtain eight inner codewords in total; and obtain two bits from each of the eight inner codewords in a round-robin fashion, to obtain 1024 consecutive bits in the second data stream.

In some possible implementations, cyclic shift is performed for each of the second data streams before the second FEC encoding.

In some possible implementations, the first data processing unit is specifically configured to: separately perform convolutional interleaving on $8 \times m$ first data streams; separately perform cyclic shift on $8 \times m$ convolutional interleaved first data streams; and separately perform second FEC encoding on $8 \times m$ cyclic shifted first data streams.

In some possible implementations, the first data processing unit is specifically configured to: separately perform convolutional interleaving on $2 \times m$ first data streams; distribute each convolutional interleaved first data stream, to obtain four distributed first data streams, so as to obtain $8 \times m$ distributed first data streams in total; separately perform cyclic shift on the $8 \times m$ distributed first data streams; and separately perform second FEC encoding on $8 \times m$ cyclic shifted first data streams.

In some possible implementations, the first data processing unit is specifically configured to: separately perform convolutional interleaving on m first data streams; distribute each convolutional interleaved first data stream, to obtain eight distributed first data streams, so as to obtain $8 \times m$ distributed first data streams in total; separately perform cyclic shift on the $8 \times m$ distributed first data streams; and separately perform second FEC encoding on $8 \times m$ cyclic shifted first data streams.

In some possible implementations, the first data processing unit is specifically configured to: distribute each of m first data streams to obtain eight distributed first data streams, so as to obtain $8 \times m$ distributed first data streams in total; separately perform second FEC encoding on the $8 \times m$ distributed first data streams to obtain $8 \times m$ encoded data streams; and perform codeword merging (codeword merging) on every eight encoded data streams in the $8 \times m$ encoded data streams to obtain one second data stream, so as to obtain the m second data streams in total. It should be understood that, performing codeword merging on eight encoded data streams is equivalent to performing one-way Hamming codeword interleaving (one-way Hamming codeword interleaving) on the eight encoded data streams.

In some possible implementations, the alignment marker includes at least one target codeword, and the target codeword includes N bits.

In some possible implementations, the target codeword is obtained by performing second FEC encoding on K-bit alignment marker information. It should be understood that the target codeword may also be referred to as an inner codeword, and selecting one or more inner codewords as a specific pattern of the alignment marker helps a receiver implement low-complexity frame synchronization and codeword synchronization.

In some possible implementations, the alignment marker is obtained by performing codeword interleaving on a plurality of target codewords. For example, each alignment marker is obtained by performing eight-way codeword interleaving on eight target codewords. The codeword interleaving herein may also be referred to as channel interleaving. It should be understood that, it should also be considered that the alignment marker obtained by performing codeword interleaving on the plurality of target codewords includes the plurality of target codewords. Alternatively, each alignment marker is obtained by performing codeword merging on a plurality of target codewords. For example, each alignment marker is obtained by performing codeword merging on eight target codewords. The codeword merging herein may also be referred to as one-way codeword interleaving.

According to a fourth aspect, an embodiment of this application provides a data processing apparatus. The data processing apparatus is used in a receiver, and includes a data processing unit and a synchronization unit. The data processing unit is configured to perform fourth data processing on received Y modulated symbol streams to obtain m fourth data streams, where demodulation has been performed for each of the fourth data streams, the Y modulated symbol streams are obtained by performing third data processing on m third data streams, modulation has been performed for each of the modulated symbol streams, the m third data streams are obtained by separately performing second data processing on m second data streams, and the m second data streams are obtained by performing first data processing on a plurality of first data streams obtained through first forward error correction FEC encoding, where Y is an integer greater than or equal to 1, and m is an integer greater than 1. Second FEC encoding has been performed for each of the second data streams, and each codeword obtained through the second FEC encoding includes N bits, where N=K+S, K represents a quantity of information bits, S represents a quantity of parity bits, K is an integer greater than or equal to 1, and S is an integer greater than or equal to 1. Each of the third data streams includes at least one bit sequence, each bit sequence includes P+W bits, the P bits in each bit sequence are from the second data stream, and the W bits in each bit sequence are an added alignment marker, where P=N×b, b is an integer greater than or equal to 1, and a value of a baud rate of each of the modulated symbol streams is an integer multiple of a value of a reference clock frequency. The synchronization unit is configured to perform frame synchronization on each of the fourth data streams based on an alignment marker in each of the fourth data streams.

In some possible implementations, the value of the baud rate of each of the modulated symbol streams is an integer multiple of 156.25M.

In some possible implementations, convolutional interleaving is performed for each of the second data streams before the second FEC encoding. The convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits. Bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a 0th delay line each time f bits are output through the convolutional interleaving, where K×b is exactly divisible by f. A start position of each frame (W+P bits) should correspond to start positions of input and output switches (input and output switches) of a convolutional de-interleaver, and the start positions are usually topmost positions (topmost positions). More specifically, input and output switches of a convolution interleaver are at topmost positions each time the convolution interleaver output f bits, and the input and output switches of the convolution de-interleaver are at the topmost positions each time the convolution de-interleaver output f bits, so that synchronization performed by the convolution de-interleaver can be ensured during the frame synchronization.

In some possible implementations, r×d×c=K×b, and c is an integer greater than or equal to 1. To be specific, the convolution interleaver and the convolution de-interleaver may output K×b bits every c round-robin times. In this case, the input and output switches of the convolution interleaver and the convolution de-interleaver are at the start positions of the switches, so that the synchronization performed by the convolution de-interleaver can be ensured during the frame synchronization.

In some possible implementations, a rate of the first data stream is 850 Gbps,
$$\frac{850}{8} \times \frac{N}{K} \times \frac{P+W}{P} G = a \times 156.25M$$
, a is an integer greater than or equal to 1, G represents 10^9, and M represents 10^6.

In some possible implementations, N=128, K=120, and $a = \frac{2176}{3} \times \frac{P+W}{P}$.

In some possible implementations, W=48, P=13056, a=728, b=102, and the baud rate=113.75 Gbaud;

W=48, P=52224, a=726, b=408, and the baud rate=113.4375 Gbaud;
W=56, P=15232, a=728, b=119, and the baud rate=113.75 Gbaud;
W=56, P=60928, a=726, b=476, and the baud rate=113.4375 Gbaud;
W=64, P=13056, a=728, b=102, and the baud rate=113.75 Gbaud;
W=64, P=69632, a=726, b=544, and the baud rate=113.4375 Gbaud;

W=120, P=32640, a=728, b=255, and the baud rate=113.75 Gbaud;
W=120, P=52224, a=727, b=408, and the baud rate=113.5938 Gbaud;
W=120, P=130560, a=726, b=1020, and the baud rate=113.4375 Gbaud;
W=128, P=34816, a=728, b=272, and the baud rate=113.75 Gbaud; or
W=128, P=139264, a=726, b=1088, and the baud rate=113.4375 Gbaud.

In some possible implementations, N=170, K=160, and $a = \frac{1445}{2} \times \frac{P+W}{P}$.

In some possible implementations, W=48, P=23120, a=724, b=136, and the baud rate=113.125 Gbaud;

W=48, P=69360, a=723, b=408, and the baud rate=112.9688 Gbaud;
W=56, P=11560, a=726, b=68, and the baud rate=113.4375 Gbaud;
W=56, P=80920, a=723, b=476, and the baud rate=112.9688 Gbaud;
W=64, P=92480, a=723, b=544, and the baud rate=112.9688 Gbaud;
W=120, P=34680, a=725, b=204, and the baud rate=113.2813 Gbaud;
W=120, P=57800, a=724, b=340, and the baud rate=113.125 Gbaud;
W=120, P=173400, a=723, b=1020, and the baud rate=112.9688 Gbaud;
W=170, P=49130, a=725, b=289, and the baud rate=113.2813 Gbaud; or
W=170, P=245650, a=723, b=1445, and the baud rate=112.9688 Gbaud.

In some possible implementations, N=144, K=136, and $a = 720 \times \frac{P+W}{P}$.

In some possible implementations, W=48, P=5760, a=726, b=40, and the baud rate=113.4375 Gbaud;

W=48, P=8640, a=724, b=60, and the baud rate=113.125 Gbaud;
W=48, P=11520, a=723, b=80, and the baud rate=112.9688 Gbaud;
W=48, P=17280, a=722, b=120, and the baud rate=112.8125 Gbaud;
W=48, P=34560, a=721, b=240, and the baud rate=112.6563 Gbaud;
W=56, P=5760, a=727, b=40, and the baud rate=113.5938 Gbaud;
W=56, P=20160, a=722, b=140, and the baud rate=112.8125 Gbaud;
W=56, P=40320, a=721, b=280, and the baud rate=112.6563 Gbaud;
W=64, P=5760, a=728, b=40, and the baud rate=113.75 Gbaud;
W=64, P=11520, a=724, b=80, and the baud rate=113.125 Gbaud;
W=64, P=23040, a=722, b=160, and the baud rate=112.8125 Gbaud;
W=64, P=46080, a=721, b=320, and the baud rate=112.6563 Gbaud;
W=120, P=14400, a=726, b=100, and the baud rate=113.4375 Gbaud;
W=120, P=17280, a=725, b=120, and the baud rate=113.2813 Gbaud;
W=120, P=28800, a=723, b=200, and the baud rate=112.9688 Gbaud;
W=120, P=43200, a=722, b=300, and the baud rate=112.8125 Gbaud;
W=120, P=86400, a=721, b=600, and the baud rate=112.6563 Gbaud;
W=144, P=11520, a=729, b=80, and the baud rate=113.9063 Gbaud;
W=144, P=17280, a=726, b=120, and the baud rate=113.4375 Gbaud;
W=144, P=25920, a=724, b=180, and the baud rate=113.125 Gbaud;
W=144, P=34560, a=723, b=240, and the baud rate=112.9688 Gbaud;
W=144, P=51840, a=723, b=360, and the baud rate=112.8125 Gbaud; or
W=144, P=103680, a=721, b=720, and the baud rate=112.6563 Gbaud.

In some possible implementations, W=56, P=5040, a=728, b=35, and the baud rate=113.75 Gbaud;

W=56, P=10080, a=724, b=70, and the baud rate=113.125 Gbaud;
W=56, P=20160, a=722, b=140, and the baud rate=112.8125 Gbaud; or
W=56, P=40320, a=721, b=280, and the baud rate=112.6563 Gbaud.

In some possible implementations, N=148, K=140, W is a multiple of 4, and b is a multiple of 17.
In some possible implementations, the alignment marker includes a padding bit and/or a status field.
In some possible implementations, W is exactly divisible by N.
In some possible implementations, the alignment marker includes at least one target codeword, and the target codeword includes N bits.

In some possible implementations, the target codeword is obtained by performing second FEC encoding on K-bit alignment marker information. It should be understood that the target codeword may also be referred to as an inner codeword, and selecting one or more inner codewords as a specific pattern of the alignment marker helps the receiver implement low-complexity frame synchronization and codeword synchronization.

In some possible implementations, the alignment marker is obtained by performing codeword interleaving on a plurality of target codewords. For example, each alignment marker is obtained by performing eight-way codeword interleaving on eight target codewords. The codeword interleaving herein may also be referred to as channel interleaving. It should be understood that, it should also be considered that the alignment marker obtained by performing codeword interleaving on the plurality of target codewords includes the plurality of target codewords. Alternatively, each alignment marker is obtained by performing codeword merging on a plurality of target codewords. For example, each alignment marker is obtained by performing codeword merging on eight target codewords. The codeword merging herein may also be referred to as one-way codeword interleaving.

According to a fifth aspect, an embodiment of this application provides a data processing method. The method is applied to a transmitter, and includes the following steps. First, first data processing is performed on m first data streams obtained through first forward error correction FEC encoding, to obtain m second data streams. m is an integer greater than 1, each of the second data streams includes at least one first bit sequence, each first bit sequence includes $\tilde{P} + \tilde{W}$ bits, the $\tilde{P}$ bits in each first bit sequence are from the first data stream, and the $\tilde{W}$ bits in each first bit sequence are an added first marker. Next, second data processing is performed on the m second data streams to obtain m third data streams, where the second data processing includes second FEC encoding, and each codeword obtained through the second FEC encoding includes N bits, where N=K+S, K represents a quantity of information bits, S represents a quantity of parity bits, K is an integer greater than or equal to 1, S is an integer greater than or equal to 1, $\tilde{P}=K\times b$, $\tilde{W} = K \times e$, b is an integer greater than or equal to 1, and e is an integer greater than or equal to 1. Further, third data processing is performed on the m third data streams to obtain Y modulated symbol streams. Y is an integer greater than or equal to 1, modulation has been performed for each of the modulated symbol streams, and a value of a baud rate of each of the modulated symbol streams is an integer multiple of a value of a reference clock frequency.

In this embodiment of this application, inner-code encoding is performed after the first marker is periodically inserted (periodically inserted) into an outer-code encoded data stream. Specifically, the $\tilde{P}$ bits are periodically obtained from the outer-code encoded data stream, and the first marker with a length of $\tilde{W}$ bits is inserted, so that the first marker with a length of $\tilde{W}$ bits exists in every $\tilde{P} + \tilde{W}$ bits in the data stream. In this application, the positive integers $\tilde{P}$ and $\tilde{W}$ are selected, so that the value of the baud rate of the modulated symbol data stream is the integer multiple of the reference clock (reference clock) frequency. This simplifies implementation of clock extraction and clock synchronization performed by a receiver, implements fast phase locking, and achieves low PLL complexity and low jitter. Further, the selected positive integers $\tilde{P}$ and $\tilde{W}$ are both divisible by the inner code information length K, so that hardware implementation complexity is low when a receiver processing module performs frame synchronization and codeword synchronization operations on received data. Still further, the positive integer $\tilde{P}$ is selected, so that concatenated de-interleaving synchronization can be ensured through inner codeword synchronization. In other words, according to the data processing method provided in this application, implementation complexity of the frame synchronization, the inner codeword synchronization, and the concatenated de-interleaving synchronization performed by the receiver processing module is low.

In some possible implementations, each of the third data streams includes at least one second bit sequence, each second bit sequence includes P+W bits, the P bits in each second bit sequence are obtained by performing second FEC encoding on the $\tilde{P}$ bits, the W bits in each second bit sequence are a second marker, and the second marker is obtained by performing second FEC encoding on the first marker, where P=N×b, and W=N×e.

In some possible implementations, the value of the baud rate of each of the modulated symbol streams is an integer multiple of 156.25M.

In some possible implementations, the first marker includes a padding bit and/or a status field.

In some possible implementations, convolutional interleaving is further performed for each first data stream, and the convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a 0th delay line each time f bits are output through the convolutional interleaving, where K×b is exactly divisible by f.

In some possible implementations, r×d×c=K×b, and c is an integer greater than or equal to 1.

In some possible implementations, $\frac{\widetilde{W}+\widetilde{P}}{\widetilde{P}} \times \frac{N}{K} = \frac{18}{17}$ .

In some possible implementations, N=148, K=140, 5032 × e is exactly divisible by b, and $5032 + (\frac{5032 \times e}{b})$ is exactly divisible by 7.

In some possible implementations, b = 629 × e.

In some possible implementations, KP4 encoding is used for the first FEC encoding, and Hamming(148,140) is used for the second FEC encoding. Alternatively, KP4 encoding is used for the first FEC encoding; and the second FEC encoding is performing bitwise exclusive OR on every two consecutive information bits in K=140 information bits to obtain 70 bits, and performing Hamming(78,70) encoding on the 70 bits to obtain S=8 parity bits, and the codeword with a length of 148 bits that is obtained through the second FEC encoding includes the K=140 information bits and the S=8 parity bits.

In some possible implementations, N=127, K=120, 2159 × e is exactly divisible by b, and $2159 + (\frac{2159 \times e}{b})$ is exactly divisible by 3.

In some possible implementations, b = 2159 × e.

In some possible implementations, KP4 encoding is used for the first FEC encoding, and Hamming(127,120) is used for the second FEC encoding. Alternatively, KP4 encoding is used for the first FEC encoding; and the second FEC encoding is performing bitwise exclusive OR on every two consecutive information bits in K=120 information bits to obtain 60 bits, and performing Hamming(67,60) encoding on the 60 bits to obtain S=7 parity bits, and the codeword with a length of 127 bits that is obtained through the second FEC encoding includes the K=120 information bits and the S=7 parity bits.

In some possible implementations, the first data processing further includes scrambling.

In some possible implementations, the third data processing further includes codeword interleaving, and the codeword interleaving is performed on t codewords to obtain an interleaved sequence including t × N bits, where an $i^{th}$ codeword in the t codewords includes a K-bit information sequence $B_i$ and an S-bit parity sequence $P_i$, $0 \le i \le t - 1$, the interleaved sequence includes a first subsequence with t × K consecutive bits and a second subsequence with t × S consecutive bits, the first subsequence includes a total of t information sequences that are $B_0$, $B_1$, $B_2$, ..., $B_{t-1}$, and the second subsequence includes a total of t parity sequences that are $P_0$, $P_1$, $P_2$, ..., $P_{t-1}$.

In some possible implementations, the baud rate of the modulated symbol stream is $\frac{850}{2 \times 4} \times \frac{\widetilde{W}+\widetilde{P}}{\widetilde{P}} \times \frac{N}{K}$ Gbaud, and the value of the baud rate is $\frac{850}{2 \times 4} \times \frac{\widetilde{W}+\widetilde{P}}{\widetilde{P}} \times \frac{N}{K} G = a \times 156.25M$ , where a is an integer greater than or equal to 1, G represents 10^9, and M represents 10^6.

In some possible implementations, N=128, K=120, and the baud rate of the modulated symbol stream is 113.4375 Gbaud.

In some possible implementations, $\widetilde{P}$ = 1088 × $\widetilde{W}$.

In some possible implementations, that third data processing is performed on the m third data streams to obtain Y modulated symbol streams includes: performing channel interleaving on each group of eight third data streams in the m third data streams to obtain one fourth data stream, so as to obtain Y fourth data streams in total; and separately modulating the Y fourth data streams to obtain the Y modulated symbol streams.

In some possible implementations, the first marker in each of the second data streams includes a synchronization subsequence with a length of $\widetilde{W}_s$ bits, where the synchronization subsequence is $\widetilde{W}_s$ consecutive bits starting from a start position in the first marker.

In some possible implementations, $\widetilde{W}_s$ = 6, one group of eight third data streams in the m third data streams is obtained by performing second FEC encoding on one group of eight second data streams in the m second data streams, one fourth data stream obtained by performing channel interleaving on the group of eight third data streams includes a synchronization sequence with a length of 48 bits, the synchronization sequence with a length of 48 bits is consecutive in the fourth data stream, and the synchronization sequence with a length of 48 bits includes a total of eight synchronization subsequences respectively included in the group of eight second data streams.

In some possible implementations, values of the 48 bits of the synchronization sequence include 0x9A, 0x4A, 0x26, 0x65, 0xB5, and 0xD9.

In some possible implementations, a synchronization subsequence 0 included in a $0^{th}$ second data stream in the group of eight second data streams is 010110;

a synchronization subsequence 1 included in a $1^{st}$ second data stream in the group of eight second data streams is 011010;

a synchronization subsequence 2 included in a 2nd second data stream in the group of eight second data streams is 100111;

a synchronization subsequence 3 included in a 3rd second data stream in the group of eight second data streams is 010001;

a synchronization subsequence 4 included in a 4th second data stream in the group of eight second data streams is 011010;

a synchronization subsequence 5 included in a 5th second data stream in the group of eight second data streams is 011001;

a synchronization subsequence 6 included in a 6th second data stream in the group of eight second data streams is 000110; and

a synchronization subsequence 7 included in a 7th second data stream in the group of eight second data streams is 101011.

In some possible implementations, one group of eight third data streams in the m third data streams is obtained by performing second FEC encoding on one group of eight second data streams in the m second data streams. A 0th second data stream, a 1st second data stream, a 2nd second data stream, and a 3rd second data stream in the group of eight second data streams each include a synchronization subsequence with a length of eight bits. A 4th second data stream, a 5th second data stream, a 6th second data stream, and a 7th second data stream in the group of eight second data streams each include a synchronization subsequence with a length of four bits, where first two bits and last two bits in the synchronization subsequence with a length of four bits are separated by two bits.

In some possible implementations, one fourth data stream obtained by performing channel interleaving on the group of eight third data streams includes a synchronization sequence with a length of 48 bits, the synchronization sequence with a length of 48 bits includes a total of eight synchronization subsequences respectively included in the group of eight second data streams, and first 24 bits and last 24 bits in the synchronization sequence with a length of 48 bits are separated by eight bits.

In some possible implementations, values of the first 24 bits in the synchronization sequence with a length of 48 bits include 0x9A, 0x4A, and 0x26, and values of the last 24 bits in the synchronization sequence with a length of 48 bits include 0x65, 0xB5, and 0xD9.

In some possible implementations, a synchronization subsequence 0 included in the 0th second data stream in the group of eight second data streams is 01011010;

a synchronization subsequence 1 included in the 1st second data stream in the group of eight second data streams is 01101001;

a synchronization subsequence 2 included in the 2nd second data stream in the group of eight second data streams is 10010110;

a synchronization subsequence 3 included in the 3rd second data stream in the group of eight second data streams is 01001011;

a synchronization subsequence 4 included in the 4th second data stream in the group of eight second data streams is 0110;

a synchronization subsequence 5 included in the 5th second data stream in the group of eight second data streams is 0110;

a synchronization subsequence 6 included in the 6th second data stream in the group of eight second data streams is 0011; and

a synchronization subsequence 7 included in the 7th second data stream in the group of eight second data streams is 1001.

In some possible implementations, the first marker in each of the second data streams includes a synchronization subsequence with a length of 48 bits, and first 24 bits and last 24 bits in the synchronization subsequence are separated by eight bits.

In some possible implementations, values of the first 24 bits in the synchronization subsequence with a length of 48 bits include 0x9A, 0x4A, and 0x26, and values of the last 24 bits in the synchronization subsequence with a length of 48 bits include 0x65, 0xB5, and 0xD9.

In some possible implementations, N=128, K=120, and the performing channel interleaving on each group of eight third data streams to obtain one fourth data stream includes: obtaining one inner codeword with a length of 128 bits from each of the third data streams in each group of eight third data streams, to obtain eight inner codewords in total; and obtaining two bits from each of the eight inner codewords in a round-robin fashion, to obtain 1024 consecutive bits in the fourth data stream.

In some possible implementations, that first data processing is performed on m first data streams includes:

separately performing cyclic shift on the m first data streams.

In some possible implementations, before the separately performing cyclic shift on the m first data streams, that first data processing is performed on m first data streams includes: separately performing convolutional interleaving on the m first data streams.

In some possible implementations, before the separately performing cyclic shift on the m first data streams, the method further includes: separately performing convolutional interleaving on m/4 input data streams; and distributing, to obtain four first data streams, each input convolutional interleaved data stream, to obtain the m first data streams in total.

In some possible implementations, before the separately performing cyclic shift on the m first data streams, the method further includes: separately performing convolutional interleaving on m/8 input data streams; and distributing, to obtain eight first data streams, each input convolutional interleaved data stream, to obtain the m first data streams in total.

According to a sixth aspect, an embodiment of this application provides a data processing method. The method is applied to a receiver, and includes the following steps. First, fourth data processing is performed on received Y modulated symbol streams to obtain m fourth data streams. Y is an integer greater than or equal to 1; demodulation has been performed for each of the fourth data streams, a value of a baud rate of each of the modulated symbol streams is an integer multiple of a value of a reference clock frequency, the Y modulated symbol streams are obtained by performing third data processing on m third data streams, and modulation has been performed for each of the modulated symbol streams; the m third data streams are obtained by performing second data processing on m second data streams, and the m second data streams are obtained by performing first data processing on m first data streams obtained through first forward error correction FEC encoding, where m is an integer greater than 1; and each of the second data streams includes at least one first bit sequence, each first bit sequence includes $\tilde{P} + \tilde{W}$ bits, the $\tilde{P}$ bits in each first bit sequence are from the first data stream, the $\tilde{W}$ bits in each first bit sequence are an added first marker, the second data processing includes second FEC encoding, and each codeword obtained through the second FEC encoding includes N bits, where N=K+S, K represents a quantity of information bits, S represents a quantity of parity bits, K is an integer greater than or equal to 1, S is an integer greater than or equal to 1, $\tilde{P}=K \times b$, $\tilde{W} = K \times e$, b is an integer greater than or equal to 1, and e is an integer greater than or equal to 1. Further, codeword synchronization and/or frame synchronization is performed on each of the fourth data streams.

In some possible implementations, each of the third data streams includes at least one second bit sequence, each second bit sequence includes P+W bits, the P bits in each second bit sequence are obtained by performing second FEC encoding on the $\tilde{P}$ bits, the W bits in each second bit sequence are a second marker, and the second marker is obtained by performing second FEC encoding on the first marker, where P=N×b, and W=N×e.

In some possible implementations, the value of the baud rate of each of the modulated symbol streams is an integer multiple of 156.25M.

In some possible implementations, the first marker includes a padding bit and/or a status field.

In some possible implementations, convolutional interleaving is further performed for each first data stream, and the convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a 0$^{th}$ delay line each time f bits are output through the convolutional interleaving, where K×b is exactly divisible by f.

In some possible implementations, r×d×c=K×b, and c is an integer greater than or equal to 1.

In some possible implementations, $\dfrac{\tilde{W}+\tilde{P}}{\tilde{P}} \times \dfrac{N}{K} = \dfrac{18}{17}$.

In some possible implementations, N=148, K=140, 5032 × e is exactly divisible by b, and $5032 + (\dfrac{5032 \times e}{b})$ is exactly divisible by 7.

In some possible implementations, b = 629 × e.

In some possible implementations, KP4 encoding is used for the first FEC encoding, and Hamming(148,140) is used for the second FEC encoding. Alternatively, KP4 encoding is used for the first FEC encoding; and the second FEC encoding is performing bitwise exclusive OR on every two consecutive information bits in K=140 information bits to obtain 70 bits, and performing Hamming(78,70) encoding on the 70 bits to obtain S=8 parity bits, and the codeword with a length of 148 bits that is obtained through the second FEC encoding includes the K=140 information bits and the S=8 parity bits.

In some possible implementations, N=127, K=120, 2159 $\times$ e is exactly divisible by b, and $2159 + \left(\frac{2159 \times e}{b}\right)$ is exactly divisible by 3.

In some possible implementations, b = 2159 $\times$ e.

In some possible implementations, KP4 encoding is used for the first FEC encoding, and Hamming(127,120) is used for the second FEC encoding. Alternatively, KP4 encoding is used for the first FEC encoding; and the second FEC encoding is performing bitwise exclusive OR on every two consecutive information bits in K=120 information bits to obtain 60 bits, and performing Hamming(67,60) encoding on the 60 bits to obtain S=7 parity bits, and the codeword with a length of 127 bits that is obtained through the second FEC encoding includes the K=120 information bits and the S=7 parity bits.

In some possible implementations, the first data processing further includes scrambling.

In some possible implementations, the third data processing further includes codeword interleaving, and the codeword interleaving is performed on t codewords to obtain an interleaved sequence including t $\times$ N bits, where an $i^{th}$ codeword in the t codewords includes a K-bit information sequence $B_i$ and an S-bit parity sequence $P_i$, $0 \leq i \leq t - 1$, the interleaved sequence includes a first subsequence with t $\times$ K consecutive bits and a second subsequence with t $\times$ S consecutive bits, the first subsequence includes a total of t information sequences that are $B_0$, $B_1$, $B_2$, ..., $B_{t-1}$, and the second subsequence includes a total of t parity sequences that are $P_0$, $P_1$, $P_2$, ..., $P_{t-1}$.

According to a seventh aspect, an embodiment of this application provides a data processing apparatus. The data processing apparatus includes: a first data processing unit, a second data processing unit, and a third data processing unit. The first data processing unit is configured to perform first data processing on m first data streams obtained through first forward error correction FEC encoding, to obtain m second data streams, where m is an integer greater than 1, each of the second data streams includes at least one first bit sequence, each first bit sequence includes $\tilde{P} + \tilde{W}$ bits, the $\tilde{P}$ bits in each first bit sequence are from the first data stream, and the $\tilde{W}$ bits in each first bit sequence are an added first marker. The second data processing unit is configured to perform second data processing on the m second data streams to obtain m third data streams, where the second data processing includes second FEC encoding, and each codeword obtained through the second FEC encoding includes N bits, where N=K+S, K represents a quantity of information bits, S represents a quantity of parity bits, K is an integer greater than or equal to 1, S is an integer greater than or equal to 1, $\tilde{P}$=K$\times$b, $\tilde{W}$ = K $\times$ e, b is an integer greater than or equal to 1, and e is an integer greater than or equal to 1. The third data processing unit is configured to perform third data processing on the m third data streams to obtain Y modulated symbol streams, where Y is an integer greater than or equal to 1, modulation has been performed for each of the modulated symbol streams, and a value of a baud rate of each of the modulated symbol streams is an integer multiple of a value of a reference clock frequency.

In some possible implementations, each of the third data streams includes at least one second bit sequence, each second bit sequence includes P+W bits, the P bits in each second bit sequence are obtained by performing second FEC encoding on the $\tilde{P}$ bits, the W bits in each second bit sequence are a second marker, and the second marker is obtained by performing second FEC encoding on the first marker, where P=N$\times$b, and W=N$\times$e.

In some possible implementations, the value of the baud rate of each of the modulated symbol streams is an integer multiple of 156.25M.

In some possible implementations, the first marker includes a padding bit and/or a status field.

In some possible implementations, convolutional interleaving is further performed for each first data stream, and the convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a $0^{th}$ delay line each time f bits are output through the convolutional interleaving, where K$\times$b is exactly divisible by f.

In some possible implementations, r$\times$d$\times$c=K$\times$b, and c is an integer greater than or equal to 1.

In some possible implementations, $\frac{\tilde{W}+\tilde{P}}{\tilde{P}} \times \frac{N}{K} = \frac{18}{17}$.

In some possible implementations, N=148, K=140, 5032 $\times$ e is exactly divisible by b, and $5032 + \left(\frac{5032 \times e}{b}\right)$ is exactly divisible by 7.

In some possible implementations, b = 629 $\times$ e.

In some possible implementations, KP4 encoding is used for the first FEC encoding, and Hamming(148,140) is used for the second FEC encoding. Alternatively, KP4 encoding is used for the first FEC encoding; and the second FEC encoding is performing bitwise exclusive OR on every two consecutive information bits in K=140 information bits to obtain 70 bits, and performing Hamming(78,70) encoding on the 70 bits to obtain S=8 parity bits, and the codeword with a length of 148 bits that is obtained through the second FEC encoding includes the K=140 information bits and the S=8 parity bits.

In some possible implementations, N=127, K=120, $2159 \times e$ is exactly divisible by b, and $2159 + (\frac{2159 \times e}{b})$ is exactly divisible by 3.

In some possible implementations, $b = 2159 \times e$.

In some possible implementations, KP4 encoding is used for the first FEC encoding, and Hamming(127,120) is used for the second FEC encoding. Alternatively, KP4 encoding is used for the first FEC encoding; and the second FEC encoding is performing bitwise exclusive OR on every two consecutive information bits in K=120 information bits to obtain 60 bits, and performing Hamming(67,60) encoding on the 60 bits to obtain S=7 parity bits, and the codeword with a length of 127 bits that is obtained through the second FEC encoding includes the K=120 information bits and the S=7 parity bits.

In some possible implementations, the first data processing further includes scrambling.

In some possible implementations, the third data processing further includes codeword interleaving, and the codeword interleaving is performed on t codewords to obtain an interleaved sequence including $t \times N$ bits, where an $i^{th}$ codeword in the t codewords includes a K-bit information sequence $B_i$ and an S-bit parity sequence $P_i$, $0 \leq i \leq t - 1$, the interleaved sequence includes a first subsequence with $t \times K$ consecutive bits and a second subsequence with $t \times S$ consecutive bits, the first subsequence includes a total of t information sequences that are $B_0$, $B_1$, $B_2$, ..., $B_{t-1}$, and the second subsequence includes a total of t parity sequences that are $P_0$, $P_1$, $P_2$, ..., $P_{t-1}$.

In some possible implementations, the baud rate of the modulated symbol stream is $\frac{850}{2 \times 4} \times \frac{\widetilde{W} + \widetilde{P}}{\widetilde{P}} \times \frac{N}{K}$ Gbaud, and the value of the baud rate is $\frac{850}{2 \times 4} \times \frac{\widetilde{W} + \widetilde{P}}{\widetilde{P}} \times \frac{N}{K} G = a \times 156.25M$, where a is an integer greater than or equal to 1, G represents 10^9, and M represents 10^6.

In some possible implementations, N=128, K=120, and the baud rate of the modulated symbol stream is 113.4375 Gbaud.

In some possible implementations, $\widetilde{P} = 1088 \times \widetilde{W}$.

In some possible implementations, the third data processing unit is specifically configured to: perform channel interleaving on each group of eight third data streams in the m third data streams to obtain one fourth data stream, so as to obtain Y fourth data streams in total; and separately modulate the Y fourth data streams to obtain the Y modulated symbol streams.

In some possible implementations, the first marker in each of the second data streams includes a synchronization subsequence with a length of $\widetilde{W}_s$ bits, where the synchronization subsequence is $\widetilde{W}_s$ consecutive bits starting from a start position in the first marker.

In some possible implementations, $\widetilde{W}_s = 6$, one group of eight third data streams in the m third data streams is obtained by performing second FEC encoding on one group of eight second data streams in the m second data streams, one fourth data stream obtained by performing channel interleaving on the group of eight third data streams includes a synchronization sequence with a length of 48 bits, the synchronization sequence with a length of 48 bits is consecutive in the fourth data stream, and the synchronization sequence with a length of 48 bits includes a total of eight synchronization subsequences respectively included in the group of eight second data streams.

In some possible implementations, values of the 48 bits of the synchronization sequence include 0x9A, 0x4A, 0x26, 0x65, 0xB5, and 0xD9.

In some possible implementations, a synchronization subsequence 0 included in a $0^{th}$ second data stream in the group of eight second data streams is 010110;

a synchronization subsequence 1 included in a $1^{st}$ second data stream in the group of eight second data streams is 011010;

a synchronization subsequence 2 included in a $2^{nd}$ second data stream in the group of eight second data streams is 100111;

a synchronization subsequence 3 included in a $3^{rd}$ second data stream in the group of eight second data streams is 010001;

a synchronization subsequence 4 included in a $4^{th}$ second data stream in the group of eight second data streams is 011010;

a synchronization subsequence 5 included in a $5^{th}$ second data stream in the group of eight second data streams is 011001;
a synchronization subsequence 6 included in a 6th second data stream in the group of eight second data streams is 000110; and
a synchronization subsequence 7 included in a 7th second data stream in the group of eight second data streams is 101011.

In some possible implementations, one group of eight third data streams in the m third data streams is obtained by performing second FEC encoding on one group of eight second data streams in the m second data streams. A 0th second data stream, a 1st second data stream, a 2nd second data stream, and a 3rd second data stream in the group of eight second data streams each include a synchronization subsequence with a length of eight bits. A 4th second data stream, a 5th second data stream, a 6th second data stream, and a 7th second data stream in the group of eight second data streams each include a synchronization subsequence with a length of four bits, where first two bits and last two bits in the synchronization subsequence with a length of four bits are separated by two bits.

In some possible implementations, one fourth data stream obtained by performing channel interleaving on one group of eight third data streams includes a synchronization sequence with a length of 48 bits, the synchronization sequence with a length of 48 bits includes a total of eight synchronization subsequences respectively included in the group of eight second data streams, and first 24 bits and last 24 bits in the synchronization sequence with a length of 48 bits are separated by eight bits.

In some possible implementations, values of the first 24 bits in the synchronization sequence with a length of 48 bits include 0x9A, 0x4A, and 0x26, and values of the last 24 bits in the synchronization sequence with a length of 48 bits include 0x65, 0xB5, and 0xD9.

In some possible implementations, a synchronization subsequence 0 included in the 0th second data stream in the group of eight second data streams is 01011010;

a synchronization subsequence 1 included in the 1st second data stream in the group of eight second data streams is 01101001;
a synchronization subsequence 2 included in the 2nd second data stream in the group of eight second data streams is 10010110;
a synchronization subsequence 3 included in the 3rd second data stream in the group of eight second data streams is 01001011;
a synchronization subsequence 4 included in the 4th second data stream in the group of eight second data streams is 0110;
a synchronization subsequence 5 included in the 5th second data stream in the group of eight second data streams is 0110;
a synchronization subsequence 6 included in the 6th second data stream in the group of eight second data streams is 0011; and
a synchronization subsequence 7 included in the 7th second data stream in the group of eight second data streams is 1001.

In some possible implementations, the first marker in each of the second data streams includes a synchronization subsequence with a length of 48 bits, and first 24 bits and last 24 bits in the synchronization subsequence are separated by eight bits.

In some possible implementations, values of the first 24 bits in the synchronization subsequence with a length of 48 bits include 0x9A, 0x4A, and 0x26, and values of the last 24 bits in the synchronization subsequence with a length of 48 bits include 0x65, 0xB5, and 0xD9.

In some possible implementations, N=128, K=120, and the third data processing unit is specifically configured to: obtain one inner codeword with a length of 128 bits from each of the third data streams in each group of eight third data streams, to obtain eight inner codewords in total; and obtain two bits from each of the eight inner codewords in a round-robin fashion, to obtain 1024 consecutive bits in the fourth data stream.

In some possible implementations, the first data processing unit is specifically configured to: separately perform cyclic shift on the m first data streams.

In some possible implementations, before the cyclic shift is separately performed on the m first data streams, the first data processing unit is specifically configured to separately perform convolutional interleaving on the m first data streams.

In some possible implementations, the data processing apparatus further includes a convolutional-interleaving unit and a distribution unit. Before the cyclic shift is separately performed on the m first data streams, the convolutional-interleaving unit is configured to separately perform convolutional interleaving on m/4 input data streams. The distribution unit is configured to distribute, to obtain four first data streams, each input convolutional interleaved data stream, to obtain the m first data streams in total.

In some possible implementations, the data processing apparatus further includes a convolutional-interleaving unit and a distribution unit. Before the cyclic shift is separately performed on the m first data streams, the convolutional-interleaving unit is configured to separately perform convolutional interleaving on m/8 input data streams. The distribution unit is configured to distribute, to obtain eight first data streams, each input convolutional interleaved data stream, to obtain the m first data streams in total.

According to an eighth aspect, an embodiment of this application provides a data processing apparatus. The data processing apparatus includes a data processing unit and a synchronization unit.

The data processing unit is configured to perform fourth data processing on received Y modulated symbol streams to obtain m fourth data streams, where Y is an integer greater than or equal to 1; demodulation has been performed for each of the fourth data streams, a value of a baud rate of each of the modulated symbol streams is an integer multiple of a value of a reference clock frequency, the Y modulated symbol streams are obtained by performing third data processing on m third data streams, modulation has been performed for each of the modulated symbol streams, the m third data streams are obtained by performing second data processing on m second data streams, and the m second data streams are obtained by performing first data processing on m first data streams obtained through first forward error correction FEC encoding, where m is an integer greater than 1; and each of the second data streams includes at least one first bit sequence, each first bit sequence includes $\tilde{P} + \tilde{W}$ bits, the $\tilde{P}$ bits in each first bit sequence are from the first data stream, the $\tilde{W}$ bits in each first bit sequence are an added first marker, the second data processing includes second FEC encoding, and each codeword obtained through the second FEC encoding includes N bits, where N=K+S, K represents a quantity of information bits, S represents a quantity of parity bits, K is an integer greater than or equal to 1, S is an integer greater than or equal to 1, $\tilde{P}$=K×b, $\tilde{W}$ = K × e, b is an integer greater than or equal to 1, and e is an integer greater than or equal to 1. The synchronization unit is configured to perform codeword synchronization and/or frame synchronization on each of the fourth data streams.

In some possible implementations, each of the third data streams includes at least one second bit sequence, each second bit sequence includes P+W bits, the P bits in each second bit sequence are obtained by performing second FEC encoding on the $\tilde{P}$ bits, the W bits in each second bit sequence are a second marker, and the second marker is obtained by performing second FEC encoding on the first marker, where P=N×b, and W=N×e.

In some possible implementations, the value of the baud rate of each of the modulated symbol streams is an integer multiple of 156.25M.

In some possible implementations, the first marker includes a padding bit and/or a status field.

In some possible implementations, convolutional interleaving is further performed for each first data stream, and the convolutional interleaving includes delaying an input data stream based on r delay lines, where r is an integer greater than 1; the delay lines include different quantities of storage units, a delay line with a smallest quantity of storage units includes zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving include d bits output from each delay line, where Q is an integer greater than or equal to 1, and d is an integer greater than or equal to 1.

In some possible implementations, input and output switches corresponding to the convolutional interleaving are in a 0th delay line each time f bits are output through the convolutional interleaving, where K×b is exactly divisible by f.

In some possible implementations, r×d×c=K×b, and c is an integer greater than or equal to 1.

In some possible implementations, $\dfrac{\tilde{W}+\tilde{P}}{\tilde{P}} \times \dfrac{N}{K} = \dfrac{18}{17}$.

In some possible implementations, N=148, K=140, 5032 × e is exactly divisible by b, and $5032 + (\dfrac{5032 \times e}{b})$ is exactly divisible by 7.

In some possible implementations, b = 629 × e.

In some possible implementations, KP4 encoding is used for the first FEC encoding, and Hamming(148,140) is used for the second FEC encoding. Alternatively, KP4 encoding is used for the first FEC encoding; and the second FEC encoding is performing bitwise exclusive OR on every two consecutive information bits in K=140 information bits to obtain 70 bits, and performing Hamming(78,70) encoding on the 70 bits to obtain S=8 parity bits, and the codeword with a length of 148 bits that is obtained through the second FEC encoding includes the K=140 information bits and the S=8 parity bits.

In some possible implementations, N=127, K=120, 2159 × e is exactly divisible by b, and $2159 + (\dfrac{2159 \times e}{b})$ is exactly divisible by 3.

In some possible implementations, b = 2159 × e.

In some possible implementations, KP4 encoding is used for the first FEC encoding, and Hamming(127,120) is used for the second FEC encoding. Alternatively, KP4 encoding is used for the first FEC encoding; and the second FEC encoding is performing bitwise exclusive OR on every two consecutive information bits in K=120 information bits to obtain 60 bits, and performing Hamming(67,60) encoding on the 60 bits to obtain S=7 parity bits, and the codeword with a length of 127 bits that is obtained through the second FEC encoding includes the K=120 information bits and the S=7 parity bits.

In some possible implementations, the first data processing further includes scrambling.

In some possible implementations, the third data processing further includes codeword interleaving, and the codeword interleaving is performed on t codewords to obtain an interleaved sequence including $t \times N$ bits, where an $i^{th}$ codeword in the t codewords includes a K-bit information sequence $B_i$ and an S-bit parity sequence $P_i$, $0 \leq i \leq t - 1$, the interleaved sequence includes a first subsequence with $t \times K$ consecutive bits and a second subsequence with $t \times S$ consecutive bits, the first subsequence includes a total of t information sequences that are $B_0$, $B_1$, $B_2$, ..., $B_{t-1}$, and the second subsequence includes a total of t parity sequences that are $P_0$, $P_1$, $P_2$, ..., $P_{t-1}$.

In embodiments of this application, the alignment marker (Alignment marker) is periodically inserted (periodically inserted) into the data stream obtained through concatenated FEC encoding. Specifically, the P bits are periodically obtained from the data stream obtained through the concatenated FEC encoding, and the alignment marker with a length of W bits is inserted, so that the alignment marker with a length of W bits exists in every P+W bits in the data stream. The positive integers P and W are selected, so that the value of the baud rate of the modulated symbol data stream is the integer multiple of the Ethernet common reference clock (Ethernet common reference clock) frequency. This simplifies the clock extraction and synchronization manners of the receiver, implements the fast phase locking, and achieves the low PLL complexity and low jitter. In addition, P needs to be the multiple of the code length N of the inner code, in other words, P = N $\times$ b, and the inner codeword synchronization can be ensured after the receiver performs frame synchronization (namely, frame synchronization of the P+W bits, also referred to as the alignment marker lock operation) on the received data. This simplifies the operations such as the frame synchronization and the inner codeword synchronization of the receiver, and achieves the low implementation complexity. In addition, the input and output switches of the convolution interleaver and the convolution de-interleaver are at the topmost positions each time the convolution interleaver and the convolution de-interleaver output f bits, and K$\times$b is exactly divisible by f, so that the synchronization performed by the convolution de-interleaver can be ensured during the frame synchronization.

This application further provides another embodiment, to perform inner-code encoding after a first marker is periodically inserted (periodically inserted) into an outer-code encoded data stream. Specifically, $\tilde{P}$ bits are periodically obtained from the outer-code encoded data stream, and the first marker with a length of $\tilde{W}$ bits is inserted, so that the first marker with a length of $\tilde{W}$ bits exists in every $\tilde{P} + \tilde{W}$ bits in the data stream. In this application, the positive integers $\tilde{P}$ and $\tilde{W}$ are selected, so that a value of a baud rate of a modulated symbol data stream is an integer multiple of a reference clock (reference clock) frequency. This simplifies implementation of clock extraction and clock synchronization performed by a receiver, implements fast phase locking, and achieves low PLL complexity and low jitter. Further, the selected positive integers $\tilde{P}$ and $\tilde{W}$ are both divisible by an inner code information length K, so that hardware implementation complexity is low when a receiver processing module performs frame synchronization and codeword synchronization operations on received data. Still further, the positive integer $\tilde{P}$ is selected, so that concatenated de-interleaving synchronization can be ensured through inner codeword synchronization. In other words, according to the data processing method provided in this application, implementation complexity of the frame synchronization, the inner codeword synchronization, and the concatenated de-interleaving synchronization performed by the receiver processing module is low.

BRIEF DESCRIPTION OF DRAWINGS

FIG. 1 is a diagram of a communication system to which an embodiment of this application is applied;

FIG. 2(a) is a diagram of a data transmission process in the communication system shown in FIG. 1;

FIG. 2(b) is a diagram of another communication system to which an embodiment of this application is applied;

FIG. 3 is a schematic flowchart of a data processing method according to an embodiment of this application;

FIG. 4(a) is a first diagram of a structure of a convolution interleaver according to an embodiment of this application;

FIG. 4(b) is a second diagram of a structure of a convolution interleaver according to an embodiment of this application;

FIG. 5(a) is a diagram of a structure of a third data stream according to an embodiment of this application;

FIG. 5(b) is another diagram of a structure of a third data stream according to an embodiment of this application;

FIG. 6 is another schematic flowchart of a data processing method according to an embodiment of this application;

FIG. 7 is still another schematic flowchart of a data processing method according to an embodiment of this application;

FIG. 8 is a diagram of a structure of a second data stream according to an embodiment of this application;

FIG. 9 is a diagram of a structure of a third data stream according to an embodiment of this application;

FIG. 10 is a diagram of an implementation of inner-code encoding according to an embodiment of this application;

FIG. 11 is a diagram of another implementation of inner-code encoding according to an embodiment of this application;

FIG. 12 is a diagram of a structure of a codeword;

FIG. 13 is another diagram of a structure of a codeword;

FIG. 14 is a diagram of an implementation of data processing according to an embodiment of this application;

FIG. 15 is a diagram of a structure of an alignment marker according to an embodiment of this application;

FIG. 16 is a diagram of a calculator architecture for synchronization;

FIG. 17 is another diagram of a structure of an alignment marker according to an embodiment of this application;

FIG. 18 is a diagram of another implementation of data processing according to an embodiment of this application;

FIG. 19 is a diagram of another implementation of data processing according to an embodiment of this application;

FIG. 20 is a diagram of another implementation of data processing according to an embodiment of this application;

FIG. 21 is a diagram of another implementation of data processing according to an embodiment of this application;

FIG. 22(a) is a diagram of another implementation of data processing according to an embodiment of this application;

FIG. 22(b) is a diagram of another implementation of data processing according to an embodiment of this application;

FIG. 22(c) is a diagram of another implementation of data processing according to an embodiment of this application;

FIG. 22(d) is a diagram of an implementation of generating an alignment marker according to an embodiment of this application;

FIG. 23 is a diagram of another implementation of data processing according to an embodiment of this application;

FIG. 24 is a diagram of a structure of a first marker according to an embodiment of this application;

FIG. 25 is a diagram of a structure of a channel interleaved synchronization sequence according to an embodiment of this application;

FIG. 26 is another diagram of a structure of a first marker according to an embodiment of this application;

FIG. 27 is another diagram of a structure of a channel interleaved synchronization sequence according to an embodiment of this application;

FIG. 28 is a diagram of another implementation of data processing according to an embodiment of this application;

FIG. 29 is a diagram of a structure of a first marker according to an embodiment of this application;

FIG. 30 is a diagram of another implementation of data processing according to an embodiment of this application;

FIG. 31 is a diagram of another implementation of data processing according to an embodiment of this application;

FIG. 32 is a diagram of another implementation of data processing according to an embodiment of this application;

FIG. 33 is a diagram of another implementation of data processing according to an embodiment of this application;

FIG. 34 is a diagram of a structure of a data processing apparatus used in a transmitter according to an embodiment of this application;

FIG. 35 is a diagram of a structure of a data processing apparatus used in a receiver according to an embodiment of this application; and

FIG. 36 is another diagram of a structure of a data processing apparatus according to an embodiment of this application.

DESCRIPTION OF EMBODIMENTS

Embodiments of this application provide a data processing method and a data processing apparatus, to simplify clock extraction and synchronization manners of a receiver, implement fast phase locking, and achieve low PLL complexity and low jitter; and to simplify operations including frame synchronization and inner codeword synchronization of the receiver, and achieve low implementation complexity. It should be noted that in the description, claims, and the foregoing accompanying drawings of this application, the terms such as "first" and "second" are intended to distinguish similar objects but do not limit a specific order or sequence. It should be understood that the foregoing terms may be interchanged in proper cases, so that embodiments described in this application can be implemented in an order other than the content described in this application. In addition, the terms "include", "have", and any other variant thereof are intended to cover non-exclusive inclusion. For example, a process, a method, a system, a product, or a device that includes a list of steps or units is not necessarily limited to those expressly listed steps or units, but may include other steps or units not expressly listed or inherent to the process, the method, the product, or the device.

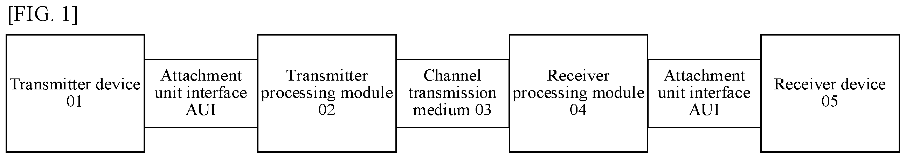

FIG. 1 is a diagram of a communication system to which an embodiment of this application is applied. As shown in FIG. 1, the communication system includes a transmitter device 01, a transmitter processing module 02, a channel transmission medium 03, a receiver processing module 04, and a receiver device 05. For example, the communication system is a data center network. The transmitter device 01 and the receiver device 05 may be devices such as a switch or a router. The transmitter device 01 is also referred to as a host chip (host chip) located at a transmitter, the receiver device 05 is also referred to as a host chip located at a receiver, and the channel transmission medium 03 may be an optical fiber. The host chip is also sometimes referred to as a host device (host device). The transmitter device 01 may be connected to the transmitter processing module 02 through an attachment unit interface (attachment unit interface, AUI), and the receiver device 05 may be connected to the receiver processing module 04 through an AUI. The transmitter processing module 02 and the receiver processing module 04 may each be an optical module (optical module), an electrical module, a connector (connector), or another module that processes data in a data sending process. For example, the processing module may be an 800LR module (800LR module, which is a coherent optical module). **In** addition, the transmitter device 01, the transmitter processing module 02, the channel transmission medium 03, the receiver processing module 04, and the receiver device 05 in the communication system may all support bidirectional transmission or unidirectional transmission. This is not specifically limited herein.

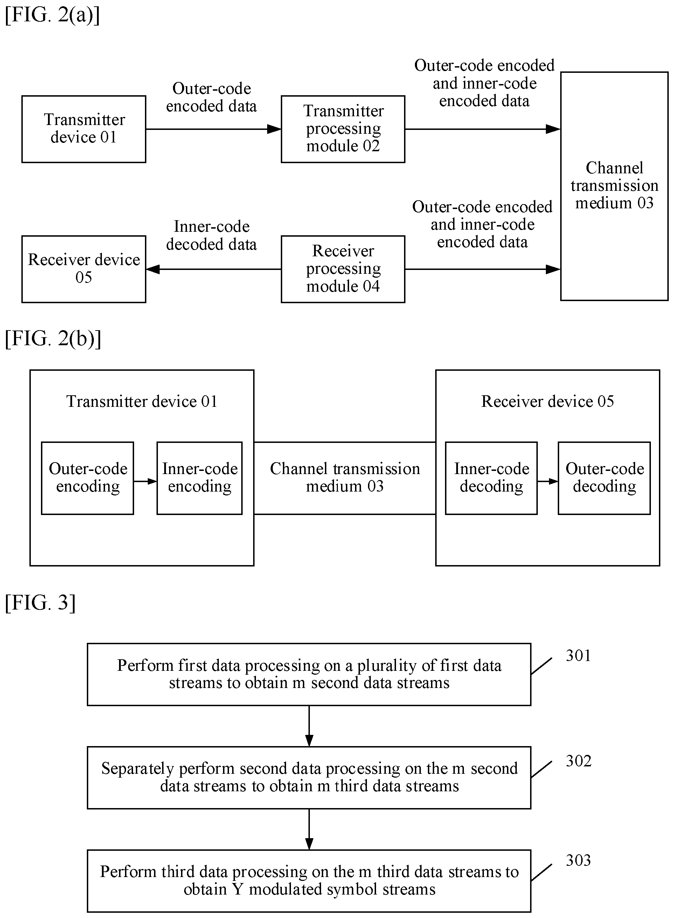

FIG. 2(a) is a diagram of a data transmission process in the communication system shown in FIG. 1. As shown in FIG. 2(a), in a process of transmitting data from the transmitter device 01 to the receiver device 05, the transmitter device 01 is configured to: perform outer-code encoding on the data, and then transmit outer-code encoded data to the transmitter processing module 02. The transmitter processing module 02 is configured to: perform inner-code encoding on the outer-code encoded data, to obtain outer-code encoded and inner-code encoded data; and transmit the outer-code encoded and inner-code encoded data to the channel transmission medium 03. The channel transmission medium 03 is configured to transmit the outer-code encoded and inner-code encoded data to the receiver processing module 04. The receiver processing module 04 is configured to: perform inner-code decoding on the outer-code encoded and inner-code encoded data, and transmit inner-code decoded data to the receiver device 05. The receiver device 05 is configured to perform outer-code decoding on the inner-code decoded data.

It should be understood that the "inner" in inner code and the "outer" in outer code are distinguished based merely on a distance between an execution body that performs an operation on data and the channel transmission medium 03. An execution body that performs an operation on inner code is close to the channel transmission medium, and an execution body that performs an operation on outer code is far away from the channel transmission medium. In embodiments of this application, data is transmitted from the transmitter device 01 to the channel transmission medium 03 via the transmitter processing module 02, and then is transmitted from the channel transmission medium 03 to the receiver device 05 via the receiver processing module 04. A distance that the data encoded by the transmitter device 01 travels to the channel transmission medium 03 is longer than that of the data encoded by the transmitter processing module 02, and a distance that the data decoded by the receiver device 05 travels to the channel transmission medium 03 is longer than that of the data decoded by the receiver processing module 04. Therefore, the data encoded by the transmitter device 01 is referred to as outer-code encoded data, the data encoded by the transmitter processing module 02 is referred to as inner-code encoded data, the data decoded by the receiver device 05 is referred to as outer-code decoded data, and data decoded by the receiver processing module 04 is referred to as inner-code decoded data. In a possible implementation, both the inner-code encoding and the outer-code encoding use an FEC encoding manner, so as to form a concatenated FEC transmission solution. For example, the transmitter device 01 may perform the outer-code encoding by using RS code, and the transmitter processing module 02 may perform the inner-code encoding by using Hamming (Hamming) code. For another example, the transmitter device 01 may perform the outer-code encoding by using RS code, and the transmitter processing module 02 may perform the inner-code encoding by using Bose-Chaudhuri-Hocquenghem (Bose-Chaudhuri-Hocquenghem, BCH) code. A BCH code for correcting a single error is equivalent to the Hamming code. For another example, the transmitter device 01 may perform outer-code encoding by using RS code, and the transmitter processing module 02 may perform inner-code encoding by using polar (Polar) code.

FIG. 2(b) is a diagram of another communication system to which an embodiment of this application is applied. As shown in FIG. 2(b), the communication system includes a transmitter device 01, a channel transmission medium 03, and a receiver device 05. The transmitter device 01 performs outer-code encoding and inner-code encoding, and sends outer-code encoded and inner-code encoded data to the transmission medium 03, and the receiver device 05 performs inner-code decoding and outer-code decoding on the data received from the transmission medium 03. For example, the communication system is a data center network. The transmitter device 01 and the receiver device 05 each may be a switch, a router, or another device. The transmitter device 01 is also referred to as a host chip (host chip) at a transmitter, the receiver device 05 is also referred to as a host chip at a receiver, and the channel transmission medium 03 may be an optical fiber. The host chip is also sometimes referred to as a host device (host device). All the transmitter device 01, the channel transmission medium 03, and the receiver device 05 in the communication system can support bidirectional transmission, and can also support unidirectional transmission. This is not specifically limited herein.

It should be noted that the foregoing content is example description of an application scenario of the data processing method provided in embodiments of this application, and does not constitute any limitation on the application scenario of the data processing method. A person of ordinary skill in the art may learn that, as service requirements change, the application scenario of the data processing method may be adjusted based on an application requirement. This is not enumerated one by one in embodiments of this application.

FIG. 3 is a schematic flowchart of a data processing method according to an embodiment of this application. It should be understood that the data processing method is applied to a transmitter. For example, the data processing method may be specifically implemented by the transmitter processing module 02 shown in FIG. 2(a).

301: Perform first data processing on a plurality of first data streams to obtain m second data streams.

In this embodiment, all the plurality of first data streams are data streams obtained through first FEC encoding, namely, the outer-code encoded data streams described above. An RS code may be for the outer-code encoding, and the outer-code encoded data stream may include a plurality of RS codewords. During actual application, the outer-code encoding may alternatively be performed in another encoding scheme. For ease of description, the RS codeword is uniformly used below to represent a codeword generated through the outer-code encoding. It should be noted that, in this application, a code length of an outer code is measured in outer code symbols, and an outer code symbol may include one or more bits. For example, the outer code is a KP4 RS(544,514) code that is used, a code length is 544 symbols, and one RS symbol of the outer code includes 10 bits.

It should be understood that an operation of the first data processing includes but is not limited to performing second FEC encoding on each first data stream. The second FEC encoding may be understood as the inner-code encoding described above. In other words, the second FEC encoding has been performed for all the m second data streams, where m is an integer greater than 1. Typically, a value of m is 4, 8, 16, 32, or 64. In an example, an inner-code encoder performs inner-code encoding on every K information bits in each first data stream, to be specific, adds S parity bits to obtain an inner codeword with a total of N bits, that is, $N=K+S$, where $K\geq 1$, and $S\geq 1$. In some scenarios, K is a multiple of 10, the K bits correspond to K/10 outer-code symbols, and the corresponding K/10 outer-code symbols are from K/10 different outer codewords.

In some possible implementations, the operation of the first data processing may further include at least one of operations such as alignment marker lock (alignment lock), lane de-skewing (lane de-skew), lane reordering (lane reorder), concatenated interleaving (concatenated interleaving), channel interleaving (channel interleave), and scrambling (scramble). For example, at least one of operations such as the alignment marker lock (alignment lock), the lane de-skewing (lane de-skew), the lane reordering (lane reorder), and the concatenated interleaving (concatenated interleaving) is performed for each of the second data streams before the second FEC encoding. For another example, at least one of operations such as the channel interleaving (channel interleave) and the scrambling (scramble) is further performed for each of the second data streams after the second FEC encoding.

It should be noted that, the channel interleaving is further performed for each of the second data streams after the second FEC encoding. One inner codeword with a length of N bits is obtained through the channel interleaving from each of $n_{HM}$ input data streams obtained through the second FEC encoding (the inner-code encoding), to obtain a total of $n_{HM}$ inner codewords including $n_{HM} \times N$ bits, and two bits are obtained, as bits in the second data stream, from each inner codeword in a round-robin (Round-Robin) manner, to obtain $n_{HM} \times N$ consecutive bits in the second data stream. In other words, every $n_{HM}$ data streams obtained through the second FEC encoding (the inner-code encoding) are processed through the channel interleaving to obtain one second data stream. The channel interleaving is also referred to as $n_{HM}$-way inner codeword interleaving ($n_{HM}$-way inner codeword interleaving), or is referred to as inner codeword interleaving.

It should be noted that, considering that for an AWGN channel, error bits input into inner-code decoding comply with random distribution, but error bits output from the decoding do not comply with the random distribution, adding a concatenated interleaver between an inner code and an outer code can make performance of an overall concatenated FEC solution desirable. An operation of the concatenated interleaving usually includes convolutional interleaving to achieve low latency. A specific implementation of the concatenated interleaving includes lane permutation and the convolutional interleaving. In the lane permutation, data permutation is performed on g input data streams to obtain g data streams that are obtained through the data permutation. Then, the convolutional interleaving is separately performed to obtain g convolutional interleaved data streams. Another specific implementation of the concatenated interleaving includes lane multiplexing and the convolutional interleaving. In the lane multiplexing, symbol multiplexing (symbol mux) is performed on g input data streams to obtain g1 symbol multiplexed data streams, where g is exactly divisible by g1. Then, the convolutional interleaving is separately performed on the g1 data streams to obtain g1 convolutional interleaved data streams. In this case, g1 is not equal to g. In other words, a quantity of first data streams may be the same as or different from a quantity of second data streams obtained by performing first data processing on the first data streams. This is specifically subject to an actual application scenario, and is not limited herein.

The following describes a possible implementation of the foregoing convolutional interleaving.

A convolution interleaver that performs convolutional interleaving includes r delay lines, the delay lines include different quantities of storage units, a delay line with a smallest quantity of storage units includes zero storage units, and a difference between quantities of storage units of every two adjacent delay lines is Q, where r is an integer greater than 1. Each storage unit is for storing d bits. Bits in each lane data stream are sequentially input into the r delay lines based on sequence numbers of the r delay lines, d bits are input into each delay line for a single time, and d bits are output from each delay line for a single time. r*d consecutive bits in a data stream that is output through the convolutional interleaving include d bits output from each delay line. Q is an integer greater than or equal to 1, and d is an integer greater than or equal to 1. For example, the r delay lines respectively include zero storage units, Q storage units, 2Q storage units, ..., (r-1)Q storage units, and each storage unit is for storing d bits. In this case, the r delay lines respectively correspond to r delay values, and the delay values include zero bits, $Q\times d$ bits, $2Q\times d$ bits, ..., $(r-1)Q\times d$ bits. A larger quantity of bits included in the delay value of the delay line indicates a longer delay (also referred to as latency) of the delay line for the data stream. It should be understood that, when the delay line includes no storage unit, a delay of the delay line is zero bits, in other words, transparent transmission with no delay is performed.

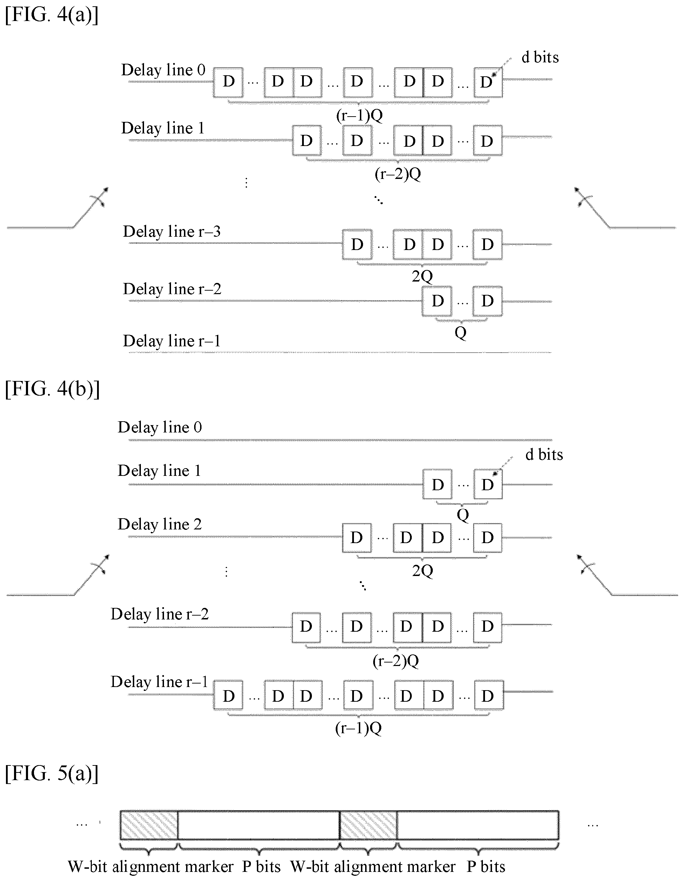

The following describes a specific structure of the convolution interleaver with reference to the accompanying drawings. FIG. 4(a) is a first diagram of a structure of a convolution interleaver according to an embodiment of this application. As shown in FIG. 4(a), the quantities of storage units in the r delay lines are in descending order of the sequence numbers of the r delay lines. To be specific, a delay line 0 has (r-1)Q storage units, Q storage units are sequentially decreased for each delay line, and a delay line r-1 has zero storage units. FIG. 4(b) is a second diagram of a structure of a convolution interleaver according to an embodiment of this application. As shown in FIG. 4(b), the quantities of storage units in the r delay lines are in ascending order of the sequence numbers of the r delay lines. To be specific, a delay line 0 has zero storage units, Q storage units are sequentially increased for each delay line, and a delay line r-1 has (r-1)Q storage units.

It should be noted that, at a same moment, an input switch (switch) and an output switch of the convolution interleaver are located on a same delay line. After d bits are input into and d bits are output from a current delay line for a single time, positions of the switches are updated to a next delay line, to ensure that the bits in each lane data stream are sequentially input into the r delay lines based on the sequence numbers of the r delay lines, and r*d consecutive bits in the first data stream include d bits output from each delay line. A specific data read/write operation performed by the convolution interleaver is as follows: d bits are read from a storage unit that is closest to an output port and that is in the current delay line. d bits stored in each storage unit in the current delay line are transferred to a next storage unit. Next, d bits are written into a storage unit that is closest to an input port and that is in the current delay line. Then, switching to a next delay line is performed, and the foregoing operations are repeated. The rest can be deduced by analogy.

It should be understood that when same parameters r, Q, and d are used, the convolutional interleaving processing in FIG. 4(a) and the convolutional interleaving processing in FIG. 4(b) are inverse operations of each other. In other words, when the transmitter processing module uses the convolutional interleaving structure shown in FIG. 4(a), convolutional de-interleaving corresponding to a receiver processing module that corresponds to the transmitter processing module uses the structure shown in FIG. 4(b). Similarly, when the transmitter processing module uses the convolutional interleaving structure shown in FIG. 4(b), convolutional de-interleaving corresponding to a receiver processing module that corresponds to the transmitter processing module uses the structure shown in FIG. 4(a).

It should be noted that, in some specific applications, a cyclic shift operation is performed before the inner-code encoder performs inner-code encoding on every K information bits in each first data stream. In the cyclic shift operation, left cyclic shift or right cyclic shift is performed on every K information bits to improve anti-burst performance of a whole concatenated code.

302: Separately perform second data processing on the m second data streams to obtain m third data streams.

In this embodiment, an alignment marker (Alignment marker) is periodically inserted (periodically insert) into each of the second data streams to obtain the third data stream. Specifically, P bits are periodically obtained from each of the second data streams, and the alignment marker with a length of W bits is inserted, so that the alignment marker with a length of W bits exists in every P+W bits in each of the third data streams. It should be understood that a specific form of the alignment marker is not limited in this application. For example, the alignment marker added herein may be the same as an alignment marker used in the foregoing alignment marker lock (alignment lock). For another example, the alignment marker added herein may be a part of an alignment marker used in the foregoing alignment marker lock (alignment lock). It should be noted that, if the alignment marker added herein includes the part of the alignment marker used in the foregoing alignment marker lock, the operation of the first data processing generally includes the scrambling.

FIG. 5(a) is a diagram of a structure of a third data stream according to an embodiment of this application. As shown in FIG. 5(a), the third data stream includes at least one bit sequence, each bit sequence includes P+W bits, the P bits in each bit sequence are from the second data stream, and the W bits in each bit sequence are the added alignment marker. It should be noted that every P+W bits may be referred to as one frame, and the W-bit alignment marker is usually first W consecutive bits of the frame. In some specific application scenarios, the W-bit alignment marker is also referred to as a frame header, or may also be referred to as a frame alignment signal (frame alignment signal, FAS) or another name. It should be noted that the alignment marker may include bits with a plurality of functions, to be specific, only a part of the W bits are for a receiver to perform synchronization.

It should be noted that, in the P+W bits of each frame, the W-bit alignment marker may be the first W consecutive bits of the frame, or the W-bit alignment marker may be last W consecutive bits of the frame.

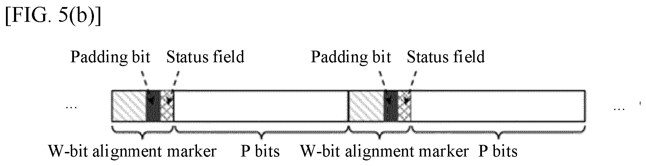

FIG. 5(b) is another diagram of a structure of a third data stream according to an embodiment of this application. As shown in FIG. 5(b), the alignment marker includes a padding bit (padding bit) and/or a status field (status field). For example, in the W bits, $W_0$ bits are for a receiver to perform synchronization, and $W_1$ bits are padding bits (Padding bits). The padding bit may be a preset bit. For example, the $W_1$ bits are all 0s. Alternatively, the $W_1$ bits are random bits. $W_0 + W_1 \leq W$. For another example, in the W bits, $W_0$ bits are for a receiver to perform synchronization, $W_1$ bits are padding bits (Padding bits) reserved for future development or innovation, and $W_2$ bits are a status field (status field) indicating a FEC

status, where $W_0 + W_1 + W_2 \leq W$.

In some other scenarios, the W-bit alignment marker may not be consecutively arranged. For example, the alignment marker may be split into a plurality of marker subblocks that are distributed in the P+W bits. Specifically, the W-bit alignment marker is split into h marker subblocks that are distributed in the P+W bits, and lengths of the h marker subblocks are respectively represented by $W_0, W_1, \ldots$ , and $W_{h-1}$. In this case, $W_0 + W_1 + \cdots + W_{h-1} = W$. A position of the W-bit alignment marker in one frame of P+W bits is not specifically limited herein.

303: Perform third data processing on the m third data streams to obtain Y modulated symbol streams.

In this embodiment, the third data processing including modulation is performed on the m third data streams to obtain the Y modulated symbol streams, where Y is an integer greater than or equal to 1.

It should be noted that in this application, the positive integers P and W are selected, so that a value of a baud rate of the modulated symbol data stream is an integer multiple of a reference clock (reference clock) frequency. This simplifies implementation of clock extraction and clock synchronization performed by the receiver, implements fast phase locking, and achieves low PLL complexity and low jitter. It should be understood that a specific value of the reference clock frequency is not limited in this application. For example, the value may be an Ethernet common reference clock (Ethernet common reference clock) frequency. In an example, the value of the baud rate of the modulated symbol data stream is an integer multiple of 156.25M. It should be further understood that a specific error range may be accepted during actual application. For example, the value of the baud rate of the modulated symbol data stream is an integer multiple of 156.25M $\pm$ V (ppm), where V may be 20, 50, or 100.

Further, the positive integer P is selected, so that the receiver processing module performs frame synchronization (namely, frame synchronization of the P+W bits, also referred to as an alignment marker lock operation) on received data, and inner codeword synchronization and concatenated de-interleaving synchronization can be ensured on the basis of implementing the frame synchronization. To be specific, according to the data processing method provided in this application, after the receiver processing module performs the frame synchronization operation, the inner codeword synchronization and the concatenated de-interleaving synchronization can still be implemented without a need to design another operation for the inner codeword synchronization and the concatenated de-interleaving synchronization. This is simple in implementation. The following describes value requirements for P and W in detail.

Considering an 800GbE scenario, a transmitter device performs outer-code encoding on to-be-transmitted 800GbE service data streams by using a KP4 RS(544,514) code to obtain data streams with a total rate of 850 Gbps, and sends the data streams to the transmitter processing module through an attachment unit interface 800GAUI after PMA processing. The transmitter processing module performs first data processing including the inner-code encoding on the plurality of first data streams to obtain the m second data streams, where a total rate of the m second data streams is

$$850 \times \frac{N}{K}$$ Gbps. The alignment marker is periodically inserted into the m second data streams separately, in other words, the second data processing is performed, to obtain the m third data streams, where a total rate of the m third data streams is $$850 \times \frac{N}{K} \times \frac{P+W}{P}$$ Gbps. The third data processing including PAM4 modulation is performed on the third data streams to obtain four modulated symbol streams, where a baud rate of the modulation symbol stream is

$$\frac{850}{2 \times 4} \times \frac{N}{K} \times \frac{P+W}{P}$$ Gbaud. Herein, baud represents a rate of a modulated symbol communicated per second.

It should be noted that in a 1.6TbE scenario, a transmitter device performs outer-code encoding on to-be-transmitted 1.6TbE service data streams by using a KP4 RS(544,514) code to obtain data streams with a total rate of 1.7 Tbps, and sends the data streams to a transmitter processing module through an attachment unit interface AUI after PMA processing. The transmitter processing module obtains eight PAM4 modulated symbol streams through the first data processing, the second data processing, and the third data processing, where a baud rate of the PAM4 modulated symbol stream is $$\frac{1700}{2 \times 8} \times \frac{N}{K} \times \frac{P+W}{P}$$ Gbaud. It should be noted that, modulation in the third data stream processing may not be the PAM4 modulation, but may be, for example, PAM8 modulation. In this case, eight PAM8 modulated symbol streams are obtained, where a baud rate of the PAM8 modulated symbol stream is $$\frac{1700}{3 \times 8} \times \frac{N}{K} \times \frac{P+W}{P}$$ Gbaud.

Assuming that the reference clock frequency is $\varphi$ MHz, the following uses the 800GbE scenario as an example for description. A value of the baud rate of the PAM4 modulated symbol stream is an integer multiple of the Ethernet common reference clock frequency, and $$\frac{850}{2 \times 4} \times \frac{N}{K} \times \frac{P+W}{P} G = a \times \varphi M$$ , where N is a code length of an inner code, K is an information bit length of the inner code, and a is a positive integer. G represents 10^9, and M represents 10^6. In this case, the implementation of performing clock extraction and clock synchronization by the receiver is simple, the fast phase locking can be implemented, and the PLL complexity and jitter are low. One Ethernet common reference clock frequency is 156.25 MHz. In some 800GbE scenarios, considering a baud rate of 112.5G, $\frac{N}{K} \times \frac{P+W}{P} = \frac{18}{17}$.

It should be noted that the parameter combination N, K, P, and W used in the foregoing 800GbE scenario may be used in a higher-rate scenario, for example, the 1.6TbE scenario. For example, when the PAM4 modulation is for 1.6TbE, $\frac{1700}{2 \times 4} \times \frac{N}{K} \times \frac{P+W}{P} G = \tilde{a} \times \varphi M$, where the integer ã in 1.6TbE is twice the integer a in the 800GbE scenario. In some 1.6TbE scenarios, considering a baud rate of 225G, $\frac{N}{K} \times \frac{P+W}{P} = \frac{18}{17}$.

Further, when P is a multiple of the code length N of the inner code, in other words, P = N × b, where b is a positive integer, the inner codeword synchronization can be ensured after the receiver processing module performs frame synchronization (namely, frame synchronization of the P+W bits, also referred to as the alignment marker lock operation) on the received data. To be specific, the receiver processing module may determine a boundary (boundary) of the frame based on the alignment marker, to complete the frame synchronization. Further, because P is a multiple of the code length N of the inner code, a boundary (boundary) of the inner codeword may be obtained after the frame synchronization is completed, to complete the inner codeword synchronization. In some 800GbE scenarios with the PAM4 modulation and the baud rate of 112.5G or 1.6TbE scenarios with the PAM4 modulation and the baud rate of 225G, $\frac{N}{K} \times \frac{P+W}{P} = \frac{18}{17}$. According to P = N × b, $\frac{N \times b + W}{K \times b} = \frac{18}{17}$.

Further, because the transmitter processing module uses the concatenated interleaving including the convolutional interleaving, to ensure convolutional de-interleaving synchronization during the frame synchronization, the receiver processing module should meet a condition that a start position of each frame (the W+P bits) corresponds to start positions of input and output switches (input and output switches) of a convolutional de-interleaver, and the start positions are usually topmost positions (topmost positions), for example, positions of the delay lines 0 shown in FIG. 4(a) and FIG. 4(b). More specifically, input and output switches of the convolution interleaver are at topmost positions each time the convolution interleaver output f bits, and the input and output switches of the convolution de-interleaver are at the topmost positions each time the convolution de-interleaver output f bits; and K×b is exactly divisible by f, so that synchronization performed by the convolution de-interleaver can be ensured during the frame synchronization. In a specific manner, r*d*c=K × b, where r is a quantity of delay lines in each of the convolution interleaver and the convolutional de-interleaver, d is a quantity of bits stored in a storage unit in each of the convolution interleaver and the convolutional de-interleaver, and c is a positive integer.

In this way, based on improvement of the transmitter processing module in this application, the inner codeword synchronization and the convolutional de-interleaving synchronization are also implemented provided that the receiver processing module implements the frame synchronization of received data based on the alignment marker added by the transmitter processing module. This simplifies operations such as the frame synchronization, the inner codeword synchronization, and concatenated interleaving synchronization at the receiver, and achieves low implementation complexity.

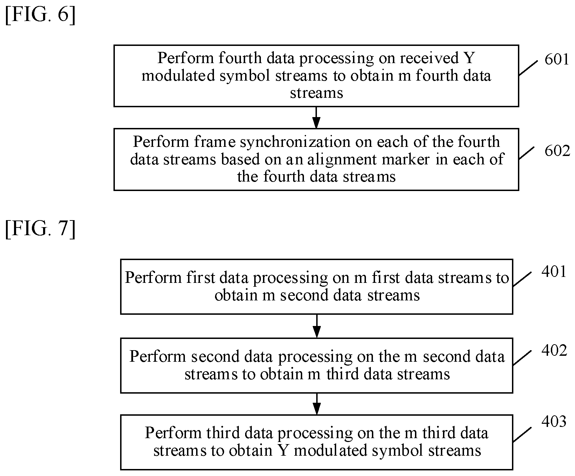

FIG. 6 is another schematic flowchart of a data processing method according to an embodiment of this application. It should be understood that the data processing method is applied to a receiver. For example, the data processing method may be specifically implemented by the receiver processing module 04 shown in FIG. 2(a).

601: Perform fourth data processing on received Y modulated symbol streams to obtain m fourth data streams.

It should be understood that the Y modulated symbol streams are from the transmitter processing module 02. For a feature of the modulated symbol stream and a manner of generating the modulated symbol stream, refer to the related descriptions in the embodiment shown in FIG. 3. Details are not described herein again. The receiver processing module 04 performs fourth data processing including demodulation on the Y modulated symbol streams to obtain the m fourth data streams, where the fourth data processing performed by the receiver processing module 04 is an inverse operation of third data processing performed by the transmitter processing module 02.

602: Perform frame synchronization on each of the fourth data streams based on an alignment marker in each of the fourth data streams.

The receiver processing module 04 may perform alignment marker lock on each of the fourth data streams based on the alignment marker added by the transmitter processing module 02, to determine a boundary (boundary) of each frame (P+W bits) in the fourth data stream, to implement the frame synchronization.

It should be understood that, after completing the frame synchronization, the receiver processing module 04 further performs fifth data processing on the m fourth data streams. The fifth data processing may be understood as an inverse operation of first data processing performed by the transmitter processing module 02. For example, the fifth data processing includes but is not limited to inner-code decoding and concatenated de-interleaving, where the concatenated de-interleaving includes convolutional de-interleaving. Details are not described herein one by one again.

The following uses a specific application scenario as an example to describe the operations performed by the transmitter processing module 02 and the receiver processing module 04.

The transmitter processing module 02 performs first data processing including concatenated interleaving and inner-code encoding on outer-code encoded first data streams, to obtain m second data streams, where the concatenated interleaving includes convolutional interleaving. Then, W-bit alignment markers are separately inserted into the m second data streams by using P bits as a periodicity to obtain P+W bits, in other words, second data processing is performed, to obtain m third data streams. The third data processing including PAM4 modulation is performed on the third data streams to obtain the Y modulated symbol streams, where Y is a positive integer. In an 800GbE service scenario, Y=4. In a 1.6TbE service scenario, Y=8. In this application, the 800GbE service scenario is used as an example to describe the data processing method, and the 800GbE service scenario can be simply extended to the 1.6TbE service scenario. A specific implementation of a data processing method in the 1.6TbE service scenario is known to a person of ordinary skill in the art, and details are not described herein.

The receiver processing module 04 performs fourth data processing on the received Y modulated symbol streams to obtain the m fourth data streams, where the fourth data processing is the inverse operation of the third data processing, and includes PAM4 demodulation. Then, the receiver processing module 04 performs alignment marker lock on each of the fourth data streams based on the W-bit alignment marker inserted by the transmitter processing module 02, to obtain the boundary of the frame of P+W bits in the fourth data stream, in other words, perform frame synchronization. Next, the receiver processing module 04 performs fifth data processing on the m fourth data streams, where the fifth data processing includes the inner-code decoding and the concatenated de-interleaving, and the concatenated de-interleaving includes the convolutional de-interleaving. It should be understood that, the receiver processing module 04 may further perform alignment marker lock on each received modulated symbol stream based on the W-bit alignment markers inserted by the transmitter processing module 02 and a feature of the third data processing, to further implement the frame synchronization.

It should be noted that, before performing inner-code decoding, the receiver processing module 04 needs to determine a boundary of an inner codeword, in other words, needs to perform inner codeword synchronization. It should be further noted that, before performing convolutional de-interleaving, the receiver processing module 04 needs to determine positions of input and output switches in the convolutional de-interleaving, in other words, needs to perform convolutional de-interleaving synchronization. Based on the foregoing descriptions, the inner codeword synchronization and the convolutional de-interleaving synchronization are also implemented provided that the receiver processing module 04 implements the frame synchronization of received data based on the alignment marker added by the transmitter processing module 02, and no other operations need to be designed for the inner codeword synchronization and concatenated de-interleaving synchronization. This simplifies operations such as the frame synchronization, the inner codeword synchronization, and the convolutional de-interleaving at the receiver, and achieves low implementation complexity.

The following provides several embodiments based on different inner-code encoding schemes to describe possible values of P and W.

Embodiment 1: Hamming(128,120) is used for the inner-code encoding.

It is considered that the inner code is a block code, for example, Hamming(128,120), with an information length of K=120 bits and a codeword length of N=128 bits, and the baud rate of the PAM4 modulated symbol stream is $\frac{850}{2\times4} \times \frac{128}{120} \times \frac{P+W}{P}$ Gbaud. Assuming that the value $\frac{850}{2\times4} \times \frac{128}{120} \times \frac{P+W}{P}$ Gbaud of the baud rate is an integer multiple of the Ethernet common reference clock frequency (156.25 MHz), in other words, $\frac{850}{2\times4} \times \frac{128}{120} \times \frac{P+W}{P}G = 156.25 \times aM$, where a is a positive integer, G represents 10^9, and M represents 10^6, $a = \frac{2176}{3} \times \frac{P+W}{P}$, and a is an integer. Implementation of performing clock extraction and clock synchronization by the receiver is simple, the fast phase locking can be implemented, and the PLL complexity and jitter are low.

When P is a multiple of the code length N of the inner code, that is, P = 128 × b, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained, where b is a positive integer. In this case,

$$a = \frac{2176}{3} \times \frac{128 \times b + W}{128 \times b} = \frac{2176 + (\frac{17 \times W}{b})}{3}$$ , the positive integer $17 \times W$ is exactly divisible by the positive integer b, and the positive integer $2176 + (\frac{17 \times W}{b})$ is exactly divisible by 3.

Considering that bit lengths W of some common alignment markers are 48, 56, 64, and 120, and N=128, an optional combination that is of the positive integers a, b, and P and that corresponds to W and a baud rate corresponding to the combination are enumerated in Table 1 below.

Table 1

| W | P | a | b | Baud rate (Gbaud) |
|---|---|---|---|---|
| 48 | 384 | 816 | 3 | 127.5 |
| 48 | 1536 | 748 | 12 | 116.875 |
| 48 | 6144 | 731 | 48 | 114.2188 |
| 48 | 13056 | 728 | 102 | 113.75 |
| 48 | 52224 | 726 | 408 | 113.4375 |
| 56 | 256 | 884 | 2 | 138.125 |
| 56 | 1024 | 765 | 8 | 119.5313 |
| 56 | 1792 | 748 | 14 | 116.875 |
| 56 | 2176 | 744 | 17 | 116.25 |
| 56 | 7168 | 731 | 56 | 114.2188 |
| 56 | 8704 | 730 | 68 | 114.0625 |
| 56 | 15232 | 728 | 119 | 113.75 |
| 56 | 60928 | 726 | 476 | 113.4375 |
| 64 | 128 | 1088 | 1 | 170 |
| 64 | 512 | 816 | 4 | 127.5 |
| 64 | 2048 | 748 | 16 | 116.875 |
| 64 | 4352 | 736 | 34 | 115 |
| 64 | 8192 | 731 | 64 | 114.2188 |
| 64 | 17408 | 728 | 136 | 113.75 |
| 64 | 69632 | 726 | 544 | 113.4375 |
| 120 | 384 | 952 | 3 | 148.75 |
| 120 | 1536 | 782 | 12 | 122.1875 |
| 120 | 3840 | 748 | 30 | 116.875 |
| 120 | 13056 | 732 | 102 | 114.375 |
| 120 | 15360 | 731 | 120 | 114.2188 |
| 120 | 32640 | 728 | 255 | 113.75 |
| 120 | 52224 | 727 | 408 | 113.5938 |
| 120 | 130560 | 726 | 1020 | 113.4375 |
| 128 | 256 | 1088 | 2 | 170 |
| 128 | 1024 | 816 | 8 | 127.5 |

(continued)

| W | P | a | b | Baud rate (Gbaud) |
|---|---|---|---|---|
| 128 | 2176 | 768 | 17 | 120 |
| 128 | 4096 | 748 | 32 | 116.875 |
| 128 | 8704 | 736 | 68 | 115 |
| 128 | 16384 | 731 | 128 | 114.2188 |
| 128 | 34816 | 728 | 272 | 113.75 |
| 128 | 139264 | 726 | 1088 | 113.4375 |

For a high baud rate, power consumption of an optical module is usually high. Considering a baud rate lower than 114 Gbaud, a desirable combination of the positive integers a, b, and P and a baud rate corresponding to the combination are enumerated in Table 2 below.

Table 2

| W | P | a | b | Baud rate (Gbaud) |
|---|---|---|---|---|
| 48 | 13056 | 728 | 102 | 113.75 |
| 48 | 52224 | 726 | 408 | 113.4375 |
| 56 | 15232 | 728 | 119 | 113.75 |
| 56 | 60928 | 726 | 476 | 113.4375 |
| 64 | 17408 | 728 | 136 | 113.75 |
| 64 | 69632 | 726 | 544 | 113.4375 |
| 120 | 32640 | 728 | 255 | 113.75 |
| 120 | 52224 | 727 | 408 | 113.5938 |
| 120 | 130560 | 726 | 1020 | 113.4375 |
| 128 | 34816 | 728 | 272 | 113.75 |
| 128 | 139264 | 726 | 1088 | 113.4375 |

The inner code information length is K=120 bits, and one RS symbol of the outer KP4 code includes 10 bits. For the convolution interleaver between the inner-code encoding and the outer-code encoding, there is a convolution interleaver whose input and output switches are at topmost positions each time the convolution interleaver outputs 120 bits. For example, a quantity r of delay lines of the convolution interleaver is 3, and each storage unit of the convolution interleaver stores d=40 bits. For another example, a quantity r of delay lines of the convolution interleaver is 6, and each storage unit of the convolution interleaver stores d=20 bits. In this case, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained. In addition, the convolutional de-interleaving synchronization can be further ensured, to be specific, positions of input and output switches (input and output switches) of the convolutional de-interleaving are obtained, so that implementation of the receiver processing module is simple.

It should be noted that the 800GbE scenario is considered in the foregoing embodiment, and the 800GbE service scenario can be simply extended to the 1.6TbE scenario. For example, the parameter combination of W, P, and b in Table 1 may be directly used in the 1.6TbE scenario. For example, the PAM4 modulation is still applied to the 1.6TbE scenario, and a baud rate used in the 1.6TbE scenario is twice the baud rate in the 800GbE scenario.

Embodiment 2: Hamming(170,160) is used for the inner-code encoding.

It is considered that the inner code is a block code, for example, Hamming(170,160), with an information length of K=160 bits and a codeword length of N=170 bits, and the baud rate of the PAM4 modulated symbol stream is

$\frac{850}{2\times4} \times \frac{170}{160} \times \frac{P+W}{P}$ Gbaud. Assuming that the value $\frac{850}{2\times4} \times \frac{170}{160} \times \frac{P+W}{P}$ Gbaud of the baud rate is an integer multiple of the Ethernet common reference clock frequency (156.25 MHz), in other words, $\frac{850}{2\times4} \times \frac{170}{160} \times$

$$\frac{P+W}{P}G = 156.25 \times aM$$

, where a is a positive integer, G represents 10^9, and M represents

$10^{\wedge}6$, $a = \frac{1445}{2} \times \frac{P+W}{P}$, and a is an integer. Implementation of performing clock extraction and clock synchronization by the receiver is simple, the fast phase locking can be implemented, and the PLL complexity and jitter are low.

When P is a multiple of the code length N of the inner code, in other words, P = 170 × b, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained, where b is a positive integer. In this case,

$$a = \frac{1445}{2} \times \frac{170\times b+W}{170\times b} = \frac{2890+(\frac{17\times W}{b})}{4}$$

, the positive integer 17 × W is exactly divisible by the positive integer b, and the positive integer $$2890 + (\frac{17\times W}{b})$$ is exactly divisible by 4.

Considering that bit lengths W of some common alignment markers are 48, 56, 64, and 120, and N=170, an optional combination that is of the positive integers a, b, and P and that corresponds to W and a baud rate corresponding to the combination are enumerated in Table 3 below.

Table 3

| W | P | a | b | Baud rate (Gbaud) |
|---|---|---|---|---|
| 48 | 1360 | 748 | 8 | 116.875 |
| 48 | 4080 | 731 | 24 | 114.2188 |
| 48 | 23120 | 724 | 136 | 113.125 |
| 56 | 680 | 782 | 4 | 122.1875 |
| 56 | 4760 | 731 | 28 | 114.2188 |
| 56 | 11560 | 726 | 68 | 113.4375 |
| 56 | 80920 | 723 | 476 | 112.9688 |
| 48 | 69360 | 723 | 408 | 112.9688 |
| 64 | 5440 | 731 | 32 | 114.2188 |
| 64 | 92480 | 723 | 544 | 112.9688 |
| 120 | 680 | 850 | 4 | 132.8125 |
| 120 | 2040 | 765 | 12 | 119.5313 |
| 120 | 3400 | 748 | 20 | 116.875 |
| 120 | 10200 | 731 | 60 | 114.2188 |
| 120 | 11560 | 730 | 68 | 114.0625 |
| 120 | 34680 | 725 | 204 | 113.2813 |
| 120 | 57800 | 724 | 340 | 113.125 |
| 120 | 173400 | 723 | 1020 | 112.9688 |
| 170 | 170 | 1445 | 1 | 225.7813 |
| 170 | 850 | 867 | 5 | 135.4688 |

(continued)

| W | P | a | b | Baud rate (Gbaud) |
|---|---|---|---|---|
| 170 | 2890 | 765 | 17 | 119.5313 |
| 170 | 14450 | 731 | 85 | 114.2188 |
| 170 | 49130 | 725 | 289 | 113.2813 |
| 170 | 245650 | 723 | 1445 | 112.9688 |

For a high baud rate, power consumption of an optical module is usually high. Considering a baud rate lower than 114 Gbaud, a desirable combination of the positive integers a, b, and P and a baud rate corresponding to the combination are enumerated in Table 4 below.

Table 4

| W | P | a | b | Baud rate (Gbaud) |
|---|---|---|---|---|
| 48 | 23120 | 724 | 136 | 113.125 |
| 48 | 69360 | 723 | 408 | 112.9688 |
| 56 | 11560 | 726 | 68 | 113.4375 |
| 56 | 80920 | 723 | 476 | 112.9688 |
| 64 | 92480 | 723 | 544 | 112.9688 |
| 120 | 34680 | 725 | 204 | 113.2813 |
| 120 | 57800 | 724 | 340 | 113.125 |
| 120 | 173400 | 723 | 1020 | 112.9688 |
| 170 | 49130 | 725 | 289 | 113.2813 |
| 170 | 245650 | 723 | 1445 | 112.9688 |

The inner code information length is K=160 bits, and one RS symbol of the outer KP4 code includes 10 bits. For the convolution interleaver between the inner code and the outer code, there is a convolution interleaver whose input and output switches are at topmost positions each time the convolution interleaver outputs 160 bits. For example, a quantity r of delay lines of the convolution interleaver is 4, and each storage unit of the convolution interleaver stores d=40 bits. For another example, a quantity r of delay lines of the convolution interleaver is 8, and each storage unit of the convolution interleaver stores d=20 bits. In this case, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained. In addition, the convolutional de-interleaving synchronization can be further ensured, to be specific, positions of input and output switches (input and output switches) of the convolutional de-interleaving are obtained, so that implementation of the receiver processing module is simple.

It should be noted that the 800GbE scenario is considered in the foregoing embodiment, and the 800GbE service scenario can be simply extended to the 1.6TbE scenario. For example, the parameter combination of W, P, and b in Table 3 may be directly used in the 1.6TbE scenario. For example, the PAM4 modulation is still applied to the 1.6TbE scenario, and a baud rate used in the 1.6TbE scenario is twice the baud rate in the 800GbE scenario.

Embodiment 3: Hamming(144,136) is used for the inner-code encoding.

It is considered that the inner code is a block code, for example, Hamming(144,136), with an information length of K=136 bits and a codeword length of N=144 bits, and the baud rate of the PAM4 modulated symbol stream is $\frac{850}{2\times4}\times\frac{144}{136}\times\frac{P+W}{P}$ Gbaud. Assuming that the value $\frac{850}{2\times4}\times\frac{144}{136}\times\frac{P+W}{P}$ Gbaud of the baud rate is an integer multiple of the Ethernet common reference clock frequency (156.25 MHz), in other words, $\frac{850}{8}\times\frac{144}{136}\times$

$$\frac{P+W}{P}G = 156.25M \times a$$ , where a is a positive integer, G represents 10^9, and M represents

$$10\text{^}6, \quad a = 720 \times \frac{P+W}{P},$$ , and a is an integer. Implementation of performing clock extraction and clock synchronization by the receiver is simple, the fast phase locking can be implemented, and the PLL complexity and jitter are low.

When P is a multiple of the code length N of the inner code, in other words, P = 144 × b, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained, where b is a positive integer. In this case,

$$a = 720 \times \frac{144 \times b + W}{144 \times b} = 720 + \frac{5 \times W}{b}$$ and the positive integer 5 × W is exactly divisible by the positive integer b.

Considering that bit lengths W of some common alignment markers are 48, 56, 64, and 120, and N=144, an optional combination that is of the positive integers a, b, and P and that corresponds to W and a baud rate corresponding to the combination are enumerated in Table 5 below.

Table 5

| W | P | a | b | Baud rate (Gbaud) |
|---|---|---|---|---|
| 48 | 144 | 960 | 1 | 150 |
| 48 | 288 | 840 | 2 | 131.25 |
| 48 | 432 | 800 | 3 | 125 |
| 48 | 576 | 780 | 4 | 121.875 |
| 48 | 720 | 768 | 5 | 120 |
| 48 | 864 | 760 | 6 | 118.75 |
| 48 | 1152 | 750 | 8 | 117.1875 |
| 48 | 1440 | 744 | 10 | 116.25 |
| 48 | 1728 | 740 | 12 | 115.625 |
| 48 | 2160 | 736 | 15 | 115 |
| 48 | 2304 | 735 | 16 | 114.8438 |
| 48 | 2880 | 732 | 20 | 114.375 |
| 48 | 3456 | 730 | 24 | 114.0625 |
| 48 | 4320 | 728 | 30 | 113.75 |
| 48 | 5760 | 726 | 40 | 113.4375 |
| 48 | 6912 | 725 | 48 | 113.2813 |
| 48 | 8640 | 724 | 60 | 113.125 |
| 48 | 11520 | 723 | 80 | 112.9688 |
| 48 | 17280 | 722 | 120 | 112.8125 |
| 48 | 34560 | 721 | 240 | 112.6563 |
| 56 | 144 | 1000 | 1 | 156.25 |
| 56 | 288 | 860 | 2 | 134.375 |
| 56 | 576 | 790 | 4 | 123.4375 |
| 56 | 720 | 776 | 5 | 121.25 |
| 56 | 1008 | 760 | 7 | 118.75 |
| 56 | 1152 | 755 | 8 | 117.9688 |
| 56 | 1440 | 748 | 10 | 116.875 |

(continued)

| W | P | a | b | Baud rate (Gbaud) |
|---|---|---|---|---|
| 56 | 2016 | 740 | 14 | 115.625 |
| 56 | 2880 | 734 | 20 | 114.6875 |
| 56 | 4032 | 730 | 28 | 114.0625 |
| 56 | 5040 | 728 | 35 | 113.75 |
| 56 | 5760 | 727 | 40 | 113.5938 |
| 56 | 8064 | 725 | 56 | 113.2813 |
| 56 | 10080 | 724 | 70 | 113.125 |
| 56 | 20160 | 722 | 140 | 112.8125 |
| 56 | 40320 | 721 | 280 | 112.6563 |
| 64 | 144 | 1040 | 1 | 162.5 |
| 64 | 288 | 880 | 2 | 137.5 |
| 64 | 576 | 800 | 4 | 125 |
| 64 | 720 | 784 | 5 | 122.5 |
| 64 | 1152 | 760 | 8 | 118.75 |
| 64 | 1440 | 752 | 10 | 117.5 |
| 64 | 2304 | 740 | 16 | 115.625 |
| 64 | 2880 | 736 | 20 | 115 |
| 64 | 4608 | 730 | 32 | 114.0625 |
| 64 | 5760 | 728 | 40 | 113.75 |
| 64 | 9216 | 725 | 64 | 113.2813 |
| 64 | 11520 | 724 | 80 | 113.125 |
| 64 | 23040 | 722 | 160 | 112.8125 |
| 64 | 46080 | 721 | 320 | 112.6563 |
| 120 | 144 | 1320 | 1 | 206.25 |
| 120 | 288 | 1020 | 2 | 159.375 |
| 120 | 432 | 920 | 3 | 143.75 |
| 120 | 576 | 870 | 4 | 135.9375 |
| 120 | 720 | 840 | 5 | 131.25 |
| 120 | 864 | 820 | 6 | 128.125 |
| 120 | 1152 | 795 | 8 | 124.2188 |
| 120 | 1440 | 780 | 10 | 121.875 |
| 120 | 1728 | 770 | 12 | 120.3125 |
| 120 | 2160 | 760 | 15 | 118.75 |
| 120 | 2880 | 750 | 20 | 117.1875 |
| 120 | 3456 | 745 | 24 | 116.4063 |
| 120 | 3600 | 744 | 25 | 116.25 |
| 120 | 4320 | 740 | 30 | 115.625 |
| 120 | 5760 | 735 | 40 | 114.8438 |
| 120 | 7200 | 732 | 50 | 114.375 |

(continued)

| W | P | a | b | Baud rate (Gbaud) |
|---|---|---|---|---|
| 120 | 8640 | 730 | 60 | 114.0625 |
| 120 | 10800 | 728 | 75 | 113.75 |
| 120 | 14400 | 726 | 100 | 113.4375 |
| 120 | 17280 | 725 | 120 | 113.2813 |
| 120 | 21600 | 724 | 150 | 113.125 |
| 120 | 28800 | 723 | 200 | 112.9688 |
| 120 | 43200 | 722 | 300 | 112.8125 |
| 120 | 86400 | 721 | 600 | 112.6563 |
| 144 | 144 | 1440 | 1 | 225 |
| 144 | 288 | 1080 | 2 | 168.75 |
| 144 | 432 | 960 | 3 | 150 |
| 144 | 576 | 900 | 4 | 140.625 |
| 144 | 720 | 864 | 5 | 135 |
| 144 | 864 | 840 | 6 | 131.25 |
| 144 | 1152 | 810 | 8 | 126.5625 |
| 144 | 1296 | 800 | 9 | 125 |
| 144 | 1440 | 792 | 10 | 123.75 |
| 144 | 1728 | 780 | 12 | 121.875 |
| 144 | 2160 | 768 | 15 | 120 |
| 144 | 2304 | 765 | 16 | 119.5313 |
| 144 | 2592 | 760 | 18 | 118.75 |
| 144 | 2880 | 756 | 20 | 118.125 |
| 144 | 3456 | 750 | 24 | 117.1875 |
| 144 | 4320 | 744 | 30 | 116.25 |
| 144 | 5184 | 740 | 36 | 115.625 |
| 144 | 5760 | 738 | 40 | 115.3125 |
| 144 | 6480 | 736 | 45 | 115 |
| 144 | 6912 | 735 | 48 | 114.8438 |
| 144 | 8640 | 732 | 60 | 114.375 |
| 144 | 10368 | 730 | 72 | 114.0625 |
| 144 | 11520 | 729 | 80 | 113.9063 |
| 144 | 12960 | 728 | 90 | 113.75 |
| 144 | 17280 | 726 | 120 | 113.4375 |
| 144 | 20736 | 725 | 144 | 113.2813 |
| 144 | 25920 | 724 | 180 | 113.125 |
| 144 | 34560 | 723 | 240 | 112.9688 |
| 144 | 51840 | 722 | 360 | 112.8125 |
| 144 | 103680 | 721 | 720 | 112.6563 |

For a high baud rate, power consumption of an optical module is usually high. Considering a baud rate lower than 114 Gbaud, a desirable combination of the positive integers a, b, and P and a baud rate corresponding to the combination are enumerated in Table 6 below.

Table 6

| W | P | a | b | Baud rate (Gbaud) |
|---|---|---|---|---|
| 48 | 4320 | 728 | 30 | 113.75 |
| 48 | 5760 | 726 | 40 | 113.4375 |
| 48 | 6912 | 725 | 48 | 113.2813 |
| 48 | 8640 | 724 | 60 | 113.125 |
| 48 | 11520 | 723 | 80 | 112.9688 |
| 48 | 17280 | 722 | 120 | 112.8125 |
| 48 | 34560 | 721 | 240 | 112.6563 |
| 56 | 5040 | 728 | 35 | 113.75 |
| 56 | 5760 | 727 | 40 | 113.5938 |
| 56 | 8064 | 725 | 56 | 113.2813 |
| 56 | 10080 | 724 | 70 | 113.125 |
| 56 | 20160 | 722 | 140 | 112.8125 |
| 56 | 40320 | 721 | 280 | 112.6563 |
| 64 | 5760 | 728 | 40 | 113.75 |
| 64 | 9216 | 725 | 64 | 113.2813 |
| 64 | 11520 | 724 | 80 | 113.125 |
| 64 | 23040 | 722 | 160 | 112.8125 |
| 64 | 46080 | 721 | 320 | 112.6563 |
| 120 | 10800 | 728 | 75 | 113.75 |
| 120 | 14400 | 726 | 100 | 113.4375 |
| 120 | 17280 | 725 | 120 | 113.2813 |
| 120 | 21600 | 724 | 150 | 113.125 |
| 120 | 28800 | 723 | 200 | 112.9688 |
| 120 | 43200 | 722 | 300 | 112.8125 |
| 120 | 86400 | 721 | 600 | 112.6563 |
| 144 | 11520 | 729 | 80 | 113.9063 |
| 144 | 12960 | 728 | 90 | 113.75 |
| 144 | 17280 | 726 | 120 | 113.4375 |
| 144 | 20736 | 725 | 144 | 113.2813 |
| 144 | 25920 | 724 | 180 | 113.125 |
| 144 | 34560 | 723 | 240 | 112.9688 |
| 144 | 51840 | 722 | 360 | 112.8125 |
| 144 | 103680 | 721 | 720 | 112.6563 |

It should be noted that the inner code information length is K=136 bits, and one RS symbol of the outer KP4 code includes 10 bits. For the convolution interleaver between the inner code and the outer code, there is a convolution interleaver whose input and output switches are at topmost positions each time the convolution interleaver outputs r*d=160 bits. For example, a quantity r of delay lines of the convolution interleaver is 4, and each storage unit of the convolution interleaver stores d=40 bits. For another example, a quantity r of delay lines of the convolution interleaver is 8, and each storage unit of the convolution interleaver stores d=20 bits. Considering that the least common multiple of the inner code information length K=136 and 160 is 2720=136×20, the input and output switches of the convolution interleaver are at the topmost positions each time the convolution interleaver outputs 2720=17× 160 bits, and the output 2720 bits are used as information bits of 20 inner codes. In other words, when b is a multiple of 20, 2720=r*d*c=K × b, where c is a positive integer. In this case, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained. In addition, the convolutional de-interleaving synchronization can be further ensured, to be specific, positions of input and output switches (input and output switches) of the convolutional de-interleaving are obtained. A corresponding combination of the positive integers a, b, and P and a baud rate corresponding to the combination are enumerated in Table 7 below.

Table 7

| W | P | a | b | Baud rate (Gbaud) |
|---|---|---|---|---|
| 48 | 5760 | 726 | 40 | 113.4375 |
| 48 | 8640 | 724 | 60 | 113.125 |
| 48 | 11520 | 723 | 80 | 112.9688 |
| 48 | 17280 | 722 | 120 | 112.8125 |
| 48 | 34560 | 721 | 240 | 112.6563 |
| 56 | 5760 | 727 | 40 | 113.5938 |
| 56 | 20160 | 722 | 140 | 112.8125 |
| 56 | 40320 | 721 | 280 | 112.6563 |
| 64 | 5760 | 728 | 40 | 113.75 |
| 64 | 11520 | 724 | 80 | 113.125 |
| 64 | 23040 | 722 | 160 | 112.8125 |
| 64 | 46080 | 721 | 320 | 112.6563 |
| 120 | 14400 | 726 | 100 | 113.4375 |
| 120 | 17280 | 725 | 120 | 113.2813 |
| 120 | 28800 | 723 | 200 | 112.9688 |
| 120 | 43200 | 722 | 300 | 112.8125 |
| 120 | 86400 | 721 | 600 | 112.6563 |
| 144 | 11520 | 729 | 80 | 113.9063 |
| 144 | 17280 | 726 | 120 | 113.4375 |
| 144 | 25920 | 724 | 180 | 113.125 |
| 144 | 34560 | 723 | 240 | 112.9688 |
| 144 | 51840 | 722 | 360 | 112.8125 |
| 144 | 103680 | 721 | 720 | 112.6563 |

It should be noted that the inner code information length is K=136 bits, and one RS symbol of the outer KP4 code includes 10 bits. For the convolution interleaver between the inner code and the outer code, there is a convolution interleaver whose input and output switches are at topmost positions each time the convolution interleaver outputs r*d=140 bits. For example, a quantity r of delay lines of the convolution interleaver is 7, and each storage unit of the convolution interleaver stores d=20 bits. Considering that the least common multiple of the inner code information length K=136 and 140 is 4760=136×35, the input and output switches of the convolution interleaver are at the topmost positions each time the convolution interleaver outputs 4760=34*140 bits, and the output 4760 bits are used as information bits of 35 inner codes. To be specific, when b is a multiple of 35, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained. **In** addition, the convolutional de-interleaving synchronization can be further ensured, to be specific, positions of input and output switches (input and output switches) of the convolutional de-interleaving are obtained. A corresponding combination of the positive integers a, b, and P and a baud rate corresponding to the combination are enumerated in Table 8 below.

Table 8

| W | P | a | b | Baud rate (Gbaud) |
|----|-------|-----|-----|-------------------|
| 56 | 5040  | 728 | 35  | 113.75 |
| 56 | 10080 | 724 | 70  | 113.125 |
| 56 | 20160 | 722 | 140 | 112.8125 |
| 56 | 40320 | 721 | 280 | 112.6563 |

It should be noted that the 800GbE scenario is considered in the foregoing embodiment, and the 800GbE service scenario can be simply extended to the 1.6TbE scenario. For example, the parameter combination of W, P, and b in Table 5 may be directly used in the 1.6TbE scenario. For example, the PAM4 modulation is still applied to the 1.6TbE scenario, and a baud rate used in the 1.6TbE scenario is twice the baud rate in the 800GbE scenario.

Embodiment 4: A FEC code with an information length of K=140 bits and a codeword length of N=148 bits is used for the inner-code encoding.

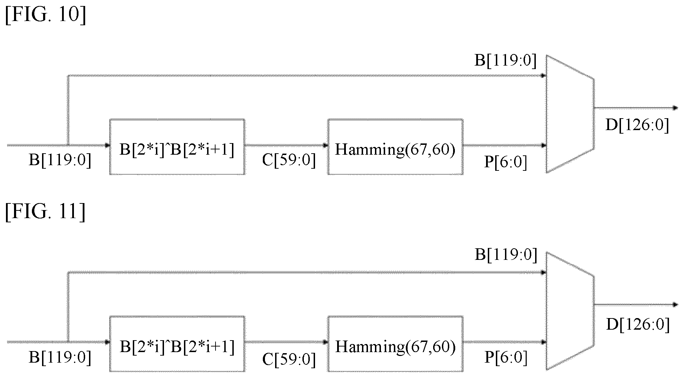

It is considered that the inner code is the FEC code, for example, a Hamming(148,140) code, with an information length of K=140 bits and a codeword length of N=148 bits. For another example, an encoding scheme shown in FIG. 10 is used, to-be-encoded 140-bit data is represented by B[139:0], bitwise exclusive OR is performed on every two consecutive bits in the 140-bit data to obtain one-bit data C[i], and 70-bit data is obtained in total, and is represented by C[69:0], where C[i]=B[2*i]^B[2*i+1], where $0 \leq i \leq 69$. Then, Hamming(78,70) encoding is performed on C[69:0] as information data to obtain eight-bit parity data that is represented by P[7:0]. Finally, 148 bits of B[139:0] and P[7:0] in total are concatenated into an output of the inner-code encoding, where the output is represented by D[147:0]. D[139:0] is from B[139:0], and D[147:140] is from P[7:0].

The baud rate of the PAM4 modulated symbol stream is $\frac{850}{2\times4} \times \frac{148}{140} \times \frac{P+W}{P}$ Gbaud. Assuming that the value $\frac{850}{2\times4} \times \frac{148}{140} \times \frac{P+W}{P}$ Gbaud of the baud rate is an integer multiple of the Ethernet common reference clock frequency (156.25 MHz), in other words, $\frac{850}{2\times4} \times \frac{148}{140} \times \frac{P+W}{P} G = 156.25 \times aM$, where a is a positive integer, G represents 10^9, and M represents 10^6, $a = \frac{5032}{7} \times \frac{P+W}{P}$, and a is an integer. Implementation of performing clock extraction and clock synchronization by the receiver is simple, the fast phase locking can be implemented, and the PLL complexity and jitter are low.

When P is a multiple of the code length N of the inner code, in other words, P = 148 × b, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained, where b is a positive integer. In this case, $a = \frac{5032}{7} \times \frac{148 \times b + W}{148 \times b} = \frac{5032 + (\frac{34 \times W}{b})}{7}$, the positive integer 34 × W is exactly divisible by the positive integer b, and the positive integer $5032 + (\frac{34 \times W}{b})$ is exactly divisible by 7.

Considering that bit lengths W of some common alignment markers are 48, 56, 64, and 120, and N=148, an optional combination that is of the positive integers a, b, and P and that corresponds to W and a baud rate corresponding to the combination are enumerated in Table 9 below.

Table 9

| W | P | a | b | Baud rate (Gbaud) |
|----|-----|-----|---|-------------------|
| 48 | 148 | 952 | 1 | 148.75 |

(continued)

| W | P | a | b | Baud rate (Gbaud) |
|---|---|---|---|---|
| 48 | 1184 | 748 | 8 | 116.875 |
| 48 | 30192 | 720 | 204 | 112.5 |
| 48 | 241536 | 719 | 1632 | 112.3438 |
| 56 | 35224 | 720 | 238 | 112.5 |
| 56 | 281792 | 719 | 1904 | 112.3438 |
| 64 | 5032 | 728 | 34 | 113.75 |
| 64 | 40256 | 720 | 272 | 112.5 |
| 64 | 322048 | 719 | 2176 | 112.3438 |
| 120 | 888 | 816 | 6 | 127.5 |
| 120 | 2960 | 748 | 20 | 116.875 |
| 120 | 5032 | 736 | 34 | 115 |
| 120 | 7104 | 731 | 48 | 114.2188 |
| 120 | 40256 | 721 | 272 | 112.6563 |
| 120 | 75480 | 720 | 510 | 112.5 |
| 120 | 603840 | 719 | 4080 | 112.3438 |
| 148 | 5032 | 740 | 34 | 115.625 |
| 148 | 93092 | 720 | 629 | 112.5 |
| 148 | 744736 | 719 | 5032 | 112.3438 |

For a high baud rate, power consumption of an optical module is usually high. Considering a baud rate lower than 114 Gbaud, a desirable combination of the positive integers a, b, and P and a baud rate corresponding to the combination are enumerated in Table 10 below.

Table 10

| W | P | a | b | Baud rate (Gbaud) |
|---|---|---|---|---|
| 48 | 30192 | 720 | 204 | 112.5 |
| 48 | 241536 | 719 | 1632 | 112.3438 |
| 56 | 35224 | 720 | 238 | 112.5 |
| 56 | 281792 | 719 | 1904 | 112.3438 |
| 64 | 5032 | 728 | 34 | 113.75 |
| 64 | 40256 | 720 | 272 | 112.5 |
| 64 | 322048 | 719 | 2176 | 112.3438 |
| 120 | 40256 | 721 | 272 | 112.6563 |
| 120 | 75480 | 720 | 510 | 112.5 |
| 120 | 603840 | 719 | 4080 | 112.3438 |
| 148 | 93092 | 720 | 629 | 112.5 |
| 148 | 744736 | 719 | 5032 | 112.3438 |

The inner code information length is K=140 bits, and one RS symbol of the outer KP4 code includes 10 bits. For the convolution interleaver between the inner code and the outer code, there is a convolution interleaver whose input and output switches are at topmost positions each time the convolution interleaver outputs 140 bits. For example, a quantity r of delay lines of the convolution interleaver is 7, and each storage unit of the convolution interleaver stores d=20 bits. In this case, the inner codeword synchronization can be ensured when the receiver processing module performs frame synchronization (namely, frame synchronization of the P+W bits, also referred to as the alignment marker lock operation) on the received data, in other words, the boundary (boundary) of the inner codeword can be obtained. In addition, the convolutional de-interleaving synchronization can be further ensured, to be specific, positions of input and output switches (input and output switches) of the convolutional de-interleaving are obtained, so that implementation of the receiver processing module is simple.

It should be noted that the 800GbE scenario is considered in the foregoing embodiment, and the 800GbE service scenario can be simply extended to the 1.6TbE scenario. For example, the parameter combination of W, P, and b in Table 9 may be directly used in the 1.6TbE scenario. For example, the PAM4 modulation is still applied to the 1.6TbE scenario, and a baud rate used in the 1.6TbE scenario is twice the baud rate in the 800GbE scenario.

In some 800GbE scenarios with the PAM4 modulation and the baud rate of 112.5G or 1.6TbE scenarios with the PAM4 modulation and the baud rate of 225G, $\frac{N}{K} \times \frac{P+W}{P} = \frac{18}{17}$. According to P = N × b, $\frac{N \times b + W}{K \times b} = \frac{18}{17}$. Because N = 148, and K = 140, 17W = 4b. Considering that b is an integer, the integer W is a multiple of 4, and the integer b is a multiple of 17.

Embodiment 5: A FEC code with an information length of K=120 bits and a codeword length of N=128 bits is used for the inner-code encoding.

It is considered that the inner code is the FEC code, for example, a Hamming(128,120) code, with an information length of K=120 bits and a codeword length of N=128 bits. For another example, to-be-encoded 120-bit data is represented by B[119:0], bitwise exclusive OR is performed on every two consecutive bits of the 120-bit data to obtain one-bit data C[i], and 60-bit data is obtained in total, and is represented by C[59:0]. C[i]=B[2*i]^B[2*i+1], where $0 \leq i \leq 59$. Then, Hamming(68,60) encoding is performed on C[59:0] as information data to obtain eight-bit parity data that is represented by P[7:0]. Finally, 128 bits of B[119:0] and P[7:0] in total are concatenated into an output of the inner-code encoding, where the output is represented by D[127:0]. D[119:0] is from B[119:0], and D[127:120] is from P[7:0].

Considering the 800GE scenario and that the PAM4 modulation is applied, four PAM modulated symbol streams are obtained through data processing. When the periodically inserted alignment marker with a length of W bits is not considered, a baud rate of the PAM4 modulated symbol stream is $\frac{850}{2 \times 4} \times \frac{N}{K}$ Gbaud ≈ 113.3333 Gbaud, and the value of the baud rate is approximately 725.3333 times the value of the reference clock frequency (156.25M). Considering that 725.3333 is not an integer, and a minimum positive integer greater than 725.3333 is 726, when the alignment marker with a length of W bits inserted into every P bits is considered, a baud rate of the PAM4 modulated symbol stream is 113.4375 Gbaud, and the value of the baud rate is 726 times the value of the reference clock frequency (156.25M).

According to $a = \frac{2176}{3} \times \frac{P+W}{P}$ in Embodiment 1, $\frac{2176}{3} \times \frac{P+W}{P} = 726$. In this case, P = 1088 × W. Considering that W is an integer multiple of the length N=128 of the inner codeword, a corresponding value of P is also an integer multiple of 128, so that the receiver can perform low-complexity frame synchronization and codeword synchronization. Several typical values of W and P are enumerated in Table 13.

Table 13

| W | P |
|---|---|
| 128 | 139264 |
| 256 | 278528 |
| 384 | 417792 |
| 512 | 557056 |
| 640 | 696320 |
| 768 | 835584 |
| 896 | 974848 |
| 1024 | 1114112 |

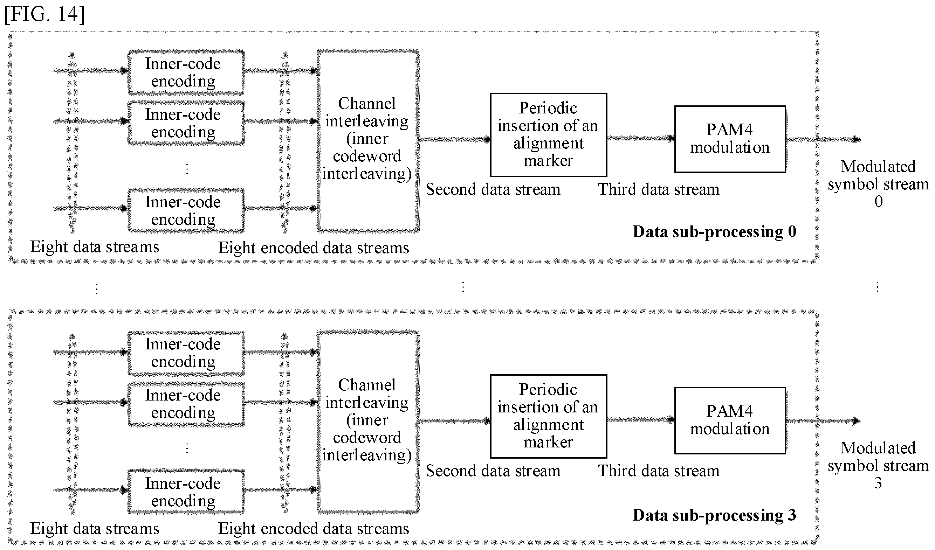

FIG. 14 is a diagram of an implementation of data processing according to an embodiment of this application. With reference to FIG. 14, the following describes a specific data processing procedure.

Inner-code encoding is performed on 32 data streams obtained through first FEC encoding, to obtain 32 inner-code encoded data streams. Specifically, inner-code encoding is performed on every K=120 information bits in each data stream, to be specific, S=8 parity bits are added, to obtain an inner codeword with N=128 bits in total.

Channel interleaving is performed on every eight encoded data streams in the 32 inner-code encoded data streams, to obtain one second data stream, and m=4 second data streams are obtained in total. Refer to FIG. 14. In the 800GE scenario, the data processing includes four pieces of data sub-processing, namely, data sub-processing 0, data sub-processing 1, data sub-processing 2, and data sub-processing 3 in FIG. 14. Each piece of data sub-processing includes one channel interleaving operation. One inner codeword with a length of 128 bits is obtained through the channel interleaving from each of $n_{HM}$ = 8 encoded data streams that are input, to obtain a total of eight inner codewords, and two bits are obtained, as bits in the second data stream, from each inner codeword in a round-robin (Round-Robin) fashion, to obtain 1024 consecutive bits in the second data stream. The channel interleaving is also referred to as eight-way Hamming codeword interleaving (eight-way Hamming codeword interleaving), or referred to as inner codeword interleaving.

An alignment marker is periodically inserted into each of the m=4 second data streams to obtain m=4 third data streams. Specifically, P bits are periodically obtained from each of the second data streams, and the alignment marker with a length of W bits is inserted, so that the alignment marker with a length of W bits exists in every P+W bits in each of the third data streams.

Third data processing including PAM4 modulation is performed on the m=4 third data streams to obtain Y=4 modulated symbol streams.

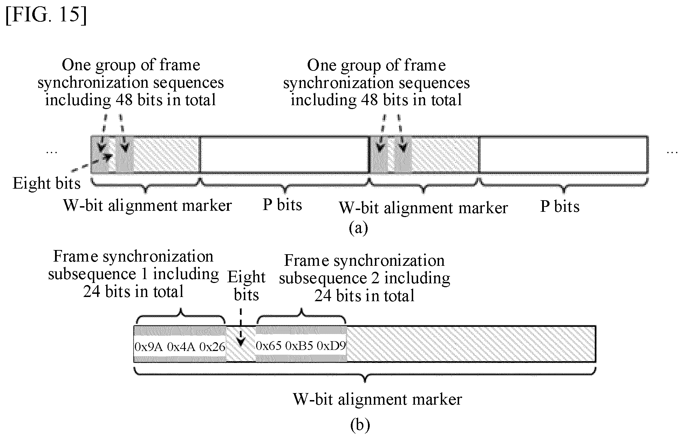

FIG. 15 is a diagram of a structure of an alignment marker according to an embodiment of this application. In this embodiment, a specific structure of the periodically inserted alignment marker with a length of W=384 bits is described by using $W = 3 \times 128 = 384$ and $P = 1088 \times W = 417792$ as an example. As shown in (a) in FIG. 15, an alignment marker with a length of 384 bits includes at least one group of frame synchronization sequences (Framesynchronizationsequence) for the receiver to perform synchronization. The group of frame synchronization sequences includes 48 bits in total, and is distributed into two frame synchronization subsequences, namely, a frame synchronization subsequence 1 and a frame synchronization subsequence 2 in (b) in FIG. 15, in the alignment marker. Each frame synchronization subsequence includes 24 bits, and the two frame synchronization subsequences are inconsecutive in the 1024-bit alignment marker, and are separated by eight bits (one byte). A specific structure of the frame synchronization subsequence is shown in (b) in FIG. 15. Herein, an interval between two consecutive bits is defined as zero bits.

In some specific applications, specific values of the frame synchronization subsequence 1 with a length of 24 bits are 0x9A, 0x4A, and 0x26, and specific values of the frame synchronization subsequence 2 with a length of 24 bits are 0x65, 0xB5, and 0xD9. It should be noted that the frame synchronization subsequence 1 (or the frame synchronization subsequence 2) is sent in a sequence of 0x9A, 0x4A, and 0x26 (or 0x65, 0xB5, and 0xD9). More specifically, for the frame synchronization subsequence 1, 0x9A is a byte transmitted first, and 0x26 is a byte transmitted later. In addition, for eight bits of one byte, an LSB is transmitted first, and an MSB is transmitted later. For example, eight bits corresponding to 0x9A are transmitted from left to right in a bit sequence of 01011100.

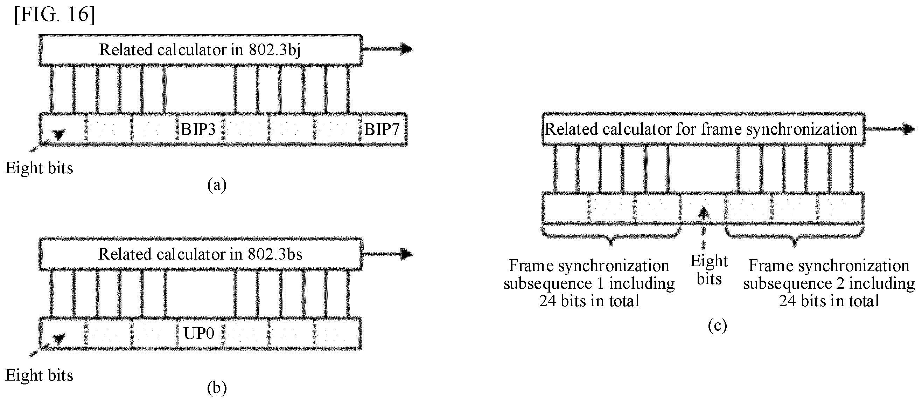

FIG. 16 is a diagram of a calculator architecture for synchronization. It should be noted that the two frame synchronization subsequences in the group of frame synchronization sequences are separated by eight bits (one byte) in the 1024-bit alignment marker, so that when performing frame synchronization, the receiver can reuse a synchronization hardware implementation architecture in existing 100GE 802.3bj and 400GE 802.3bs standards. (a) in FIG. 16 shows a related calculator architecture for alignment marker synchronization in the 100GE 802.3bj standard. (b) in FIG. 16 shows a related calculator architecture for alignment marker synchronization in the 400GE 802.3bs standard. (c) in FIG. 16 shows a related calculator architecture for the frame synchronization in the present invention. It can be learned that the synchronization hardware implementation architecture in the existing 100GE 802.3bj and 400GE 802.3bs standards can be reused for the structure of the frame synchronization sequence. This facilitates implementation.

Embodiment 6

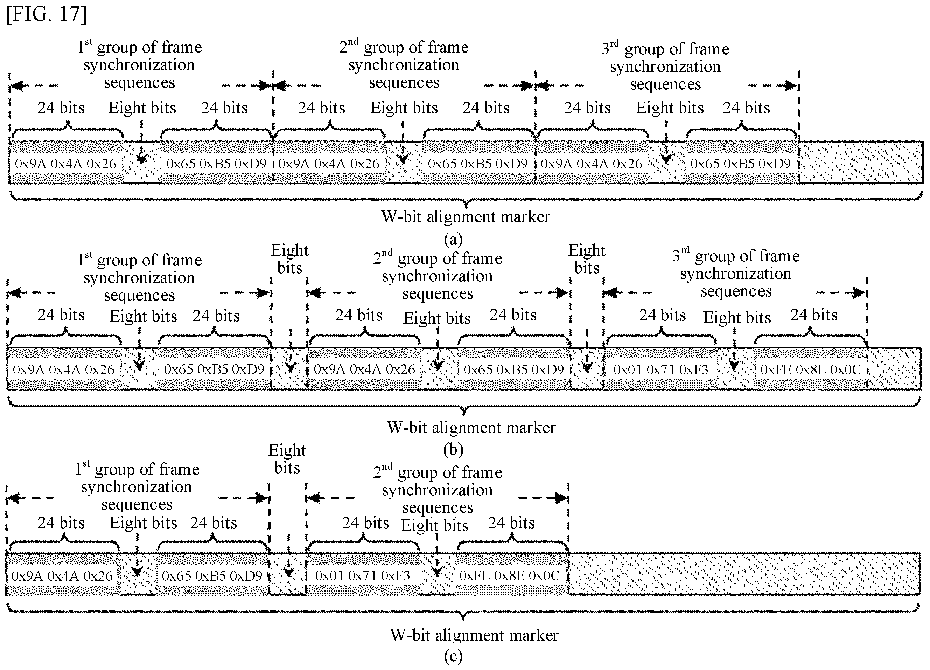

FIG. 17 is another diagram of a structure of an alignment marker according to an embodiment of this application. Based on Embodiment 5, it is considered that $W = 8 \times 128 = 1024$ and $P = 1088 \times W = 1114112$. In a data processing operation, P bits are periodically obtained from each of the second data streams, and an alignment marker with a length of W bits is inserted. The alignment marker includes a plurality of groups of frame synchronization sequences for the receiver to perform synchronization. As shown in (a) in FIG. 17 and (b) in FIG. 17, the alignment marker includes three groups of frame synchronization sequences for the receiver to perform synchronization. As shown in (c) in FIG. 17, the alignment marker includes two groups of frame synchronization sequences for the receiver to perform synchronization.

It should be noted that the groups of frame synchronization sequences may or may not be separated. As shown in (a) in FIG. 17, the three groups of frame synchronization sequences are not separated in the alignment marker with a length of W=1024 bits. As shown in (b) in FIG. 17, two adjacent frame synchronization sequences in the three groups of frame synchronization sequences are separated by eight bits in the alignment marker with a length of W=1024 bits. It should be noted that, a quantity of bits by which the two adjacent frame synchronization sequences in the three groups of frame synchronization sequences are separated in the alignment marker with a length of W=1024 bits may be another positive integer that is an integer multiple of 8.

It should be noted that specific values of the plurality of groups of frame synchronization sequences may be the same, or may be different. As shown in (a) in FIG. 17, values of the three groups of frame synchronization sequences are the same, and values of 48 bits in each group of frame synchronization sequences are: 0x9A, 0x4A, 0x26, 0x65, 0xB5, and 0xD9. As shown in (b) in FIG. 17, in the three groups of frame synchronization sequences, values of a 1st group of frame synchronization sequences and a 2nd group of frame synchronization sequences are the same, and values of 48 bits in each group of frame synchronization sequences are: 0x9A, 0x4A, 0x26, 0x65, 0xB5, and 0xD9. Values of a 3rd group of frame synchronization sequences are different from the values of the 1st and 2nd groups of frame synchronization sequences, and values of 48 bits of the 3rd group of frame synchronization sequences are: 0x01, 0x71, 0xF3, 0xFE, 0x8E, and 0x0C. As shown in (c) in FIG. 17, values of the two groups of frame synchronization sequences are different. Values of 48 bits in a 1st frame synchronization sequence are: 0x9A, 0x4A, 0x26, 0x65, 0xB5, and 0xD9, and values of 48 bits in a 2nd frame synchronization sequence are: 0x01, 0x71, 0xF3, 0xFE, 0x8E, and 0x0C.

Embodiment 7

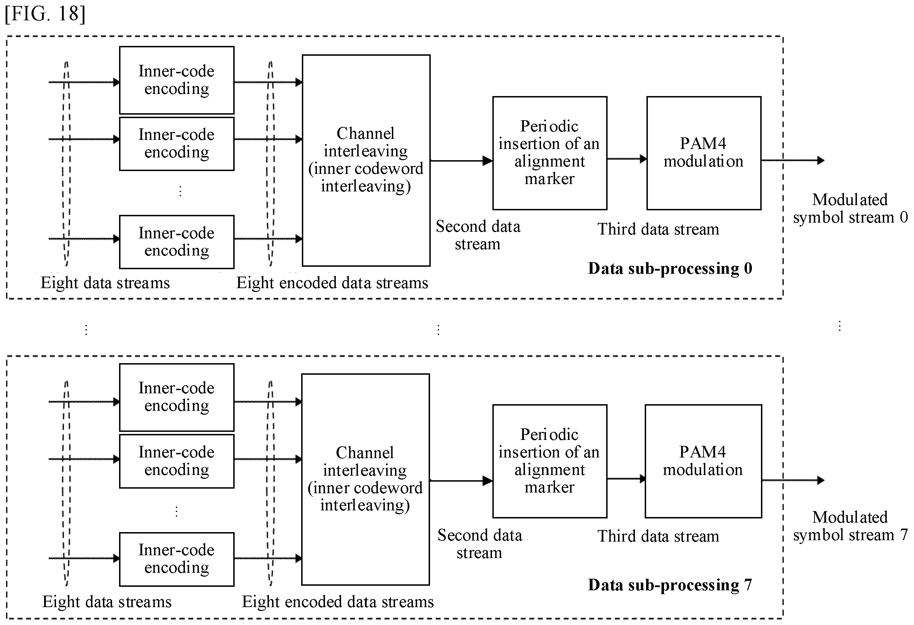

FIG. 18 is a diagram of another implementation of data processing according to an embodiment of this application. Based on Embodiment 5, considering the 1.6TE scenario and that the PAM4 modulation is applied, eight PAM modulated symbol streams are obtained through the data processing. When the periodically inserted alignment marker with a length of W bits is not considered, a baud rate of the PAM4 modulated symbol stream is $\frac{1700}{2 \times 8} \times \frac{N}{K}$ Gbaud ≈ 113.3333 Gbaud, and the value of the baud rate is approximately 725.3333 times the value of the reference clock frequency (156.25M). Considering that 725.3333 is not an integer, and a minimum positive integer greater than 725.3333 is 726, when the periodically inserted alignment marker with a length of W bits is considered, a baud rate of the PAM4 modulated symbol stream is 113.4375 Gbaud, and the value of the baud rate is 726 times the value of the reference clock frequency (156.25M).

With reference to $a = \frac{2176}{3} \times \frac{P+W}{P}$ in Embodiment 1, $\frac{2176}{3} \times \frac{P+W}{P} = 726$. In this case, P = 1088 × W. Considering that W is an integer multiple of the length N=128 of the inner codeword, a corresponding value of P is also an integer multiple of 128, so that the receiver can perform low-complexity frame synchronization and codeword synchronization. Several typical values of W and P are enumerated in Table 13 in Embodiment 5. For a specific data processing procedure, refer to FIG. 18 for understanding. Data processing in the procedure includes eight pieces of data sub-processing, namely, data sub-processing 0 to data sub-processing 7. For a specific operation of each piece of data sub-processing, refer to Embodiment 5 for understanding.

Embodiment 8

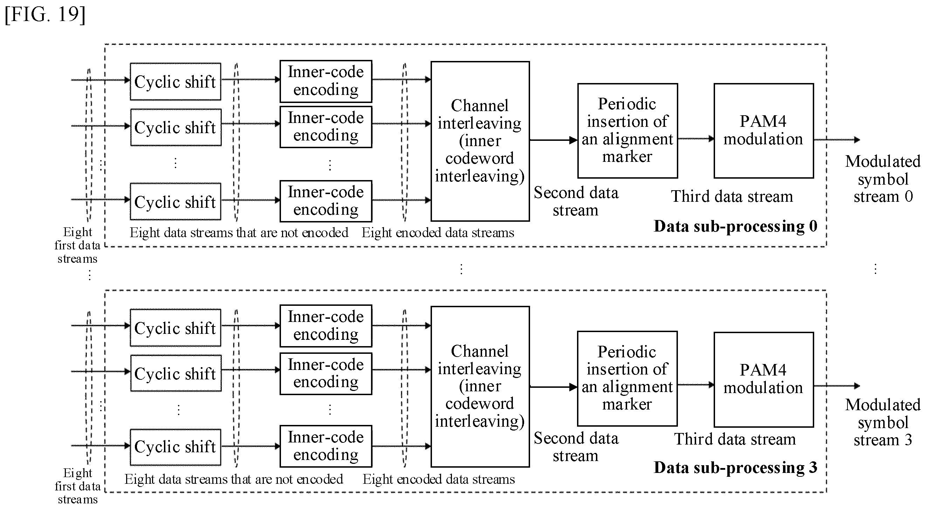

FIG. 19 is a diagram of another implementation of data processing according to an embodiment of this application. Based on Embodiment 5, a cyclic shift operation is further performed before the inner-code encoder performs inner-code encoding on every K=120 information bits in each first data stream. As shown in FIG. 19, in the cyclic shift operation, right cyclic shift is performed on every K=120 information bits, to improve anti-burst performance of a whole concatenated code.

Embodiment 9

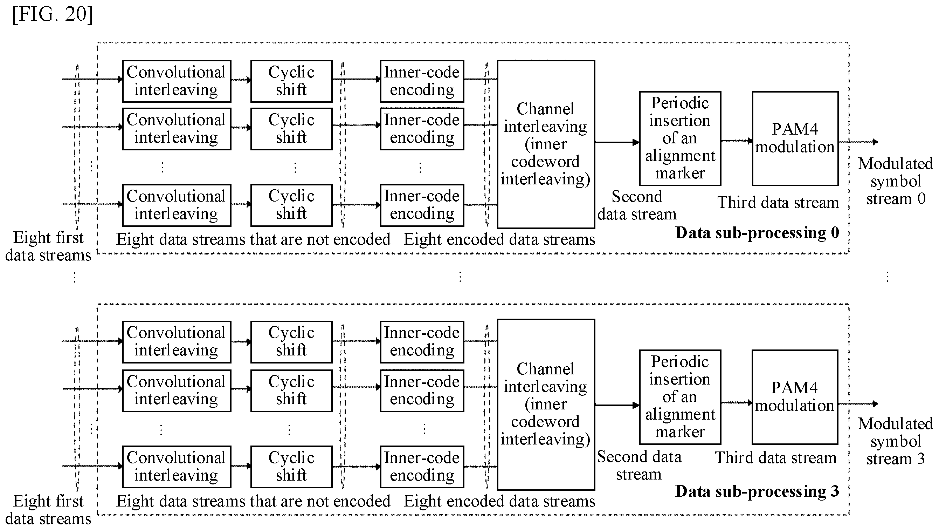

FIG. 20 is a diagram of another implementation of data processing according to an embodiment of this application. Based on Embodiment 5, a convolutional interleaving operation is further performed before the inner-code encoder performs inner-code encoding on every K=120 information bits in each first data stream. As shown in FIG. 20, the convolutional interleaving is first performed on every eight first data streams in the 32 first data streams, then cyclic shift is performed on every K=120 bits, and the inner-code encoding and channel interleaving (inner codeword interleaving) are sequentially performed to obtain one second data stream, to obtain four second data streams in total. The convolutional interleaving is further performed before the inner-code encoding, so that performance of a whole concatenated code in AWGN is improved.

Embodiment 10

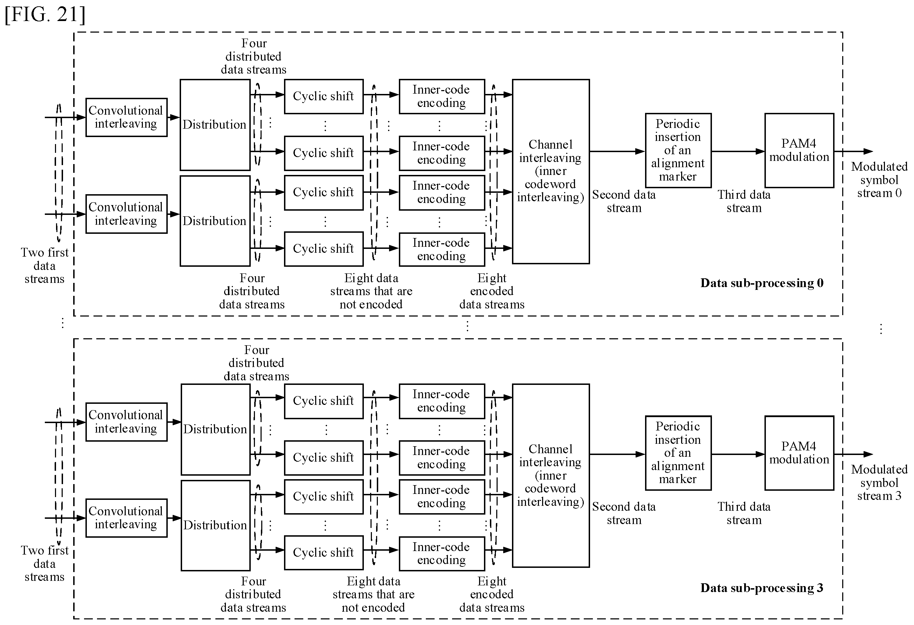

FIG. 21 is a diagram of another implementation of data processing according to an embodiment of this application. Based on Embodiment 9, every two first data streams in the eight first data streams are grouped as two input data streams for data sub-processing. In each piece of data sub-processing, convolutional interleaving is separately performed on the two first data streams to obtain two convolutional interleaved data streams. Data distribution (distribution) is performed on each convolutional interleaved data stream, to obtain four distributed data streams, and eight distributed data streams are obtained in total. The data distribution is performed at a granularity of $\alpha_0$ bits. As shown in FIG. 21, when $\alpha_0$ bits in the convolutional interleaved data stream are grouped together, for four groups of $4 \times \alpha_0$ consecutive bits in total, a $0^{th}$ group of $\alpha_0$ bits is sent to a $0^{th}$ data stream in the four distributed data streams, a $1^{st}$ group of $\alpha_0$ bits is sent to a $1^{st}$ data stream in the four distributed data streams, a $2^{nd}$ group of $\alpha_0$ bits is sent to a $2^{nd}$ data stream in the four distributed data streams, and a $3^{rd}$ group of $\alpha_0$ bits is sent to a $3^{rd}$ data stream in the four distributed data streams. Typically, the distribution bit granularity is $\alpha_0 = 120$.

It should be noted that, in the 800GE scenario, the data processing includes four pieces of data sub-processing, as shown in FIG. 21. A data stream input of each piece of data sub-processing is two first data streams. The two first data streams correspond to a rate of approximately 200G bits per second, in other words, each first data stream corresponds to a rate of approximately 100G bits per second. Correspondingly, the distributed data stream corresponds to a rate of approximately 25G bits per second.

It should be further noted that when the distribution bit granularity is $\alpha_0 = 120$, the data processing shown in FIG. 21 may be described as: The convolutional interleaving is separately performed on the two first data streams, to obtain a total of two convolutional interleaved data streams. Four bit groups are obtained from each convolutional interleaved data stream, and a length of each bit group is 120 bits. The cyclic shift and the inner-code encoding are separately performed on each bit group to obtain four inner codewords. A total of eight bit groups are obtained from the two convolutional interleaved data streams, a total of eight inner codewords are obtained separately through the cyclic shift and the inner-code encoding, and then the channel interleaving is performed to obtain 1024 bits in the second data stream.

It should be noted that, in some specific application scenarios with a low-latency requirement, the convolutional interleaving in FIG. 21 may be removed, and the convolutional interleaving operation is bypassed (bypassed).

It should be noted that, in the 1.6TE scenario, the data processing includes eight pieces of data sub-processing, and a data stream input of each piece of data sub-processing is two first data streams. The two first data streams correspond to a rate of approximately 200G bits per second, in other words, each first data stream corresponds to a rate of approximately 100G bits per second. Correspondingly, the distributed data stream corresponds to a rate of approximately 25G bits per second.

Embodiment 11

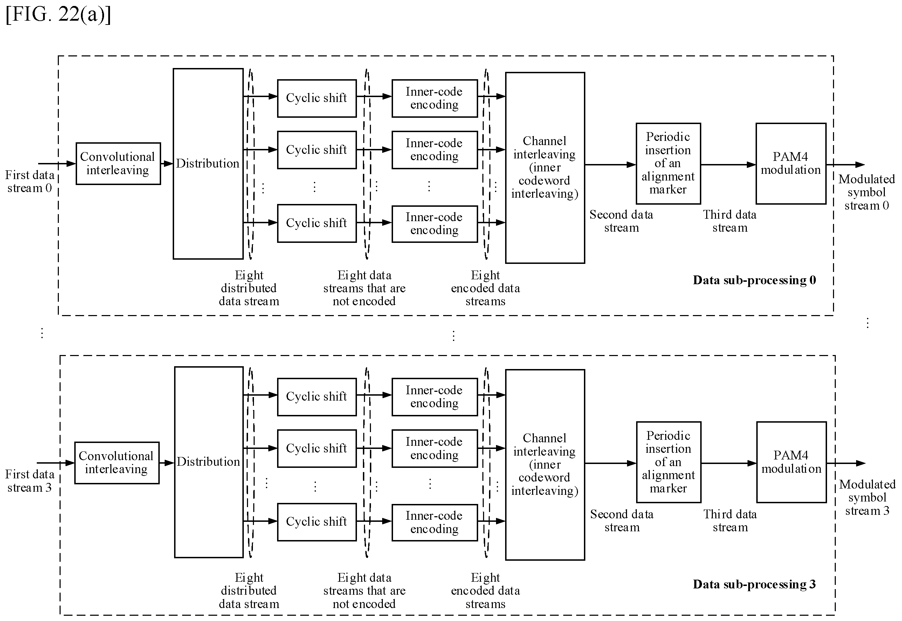

FIG. 22(a) is a diagram of another implementation of data processing according to an embodiment of this application. Based on Embodiment 9, each of four first data streams is used as an input data stream for data sub-processing. In each piece of data sub-processing, the convolutional interleaving is performed on the first data stream to obtain one convolutional interleaved data stream. Data distribution (distribution) is performed on the convolutional interleaved data stream, to obtain eight distributed data streams. The data distribution is performed at a granularity of $\alpha_0$ bits. As shown in FIG. 22(a), when $\alpha_0$ bits in the convolutional interleaved data stream are grouped together, for eight groups of $8 \times \alpha_0$ consecutive bits in total, a $0^{th}$ group of $\alpha_0$ bits is sent to a $0^{th}$ data stream in the eight distributed data streams, a $1^{st}$ group of $\alpha_0$ bits is sent to a $1^{st}$ data stream in the eight distributed data streams, ..., and a $7^{th}$ group of $\alpha_0$ bits is sent to a $7^{th}$ data stream in the eight distributed data streams. Typically, the distribution bit granularity is $\alpha_0 = 120$.

It should be noted that, in the 800GE scenario, the data processing includes four pieces of data sub-processing, as shown in FIG. 22(a). A data stream input of each piece of data sub-processing is one first data stream, and the first data stream corresponds to a rate of approximately 200G bits per second. Correspondingly, the distributed data stream corresponds to a rate of approximately 25G bits per second.

It should be further noted that when the distribution bit granularity is $\alpha_0 = 120$, the data processing shown in FIG. 22(a) may be described as: The convolutional interleaving is performed on each first data stream, to obtain one convolutional interleaved data stream. Eight bit groups are obtained from the convolutional interleaved data stream, and a length of each bit group is 120 bits. The cyclic shift and the inner-code encoding are separately performed on each bit group to obtain eight inner codewords, and then the channel interleaving is performed to obtain 1024 bits in the second data stream.

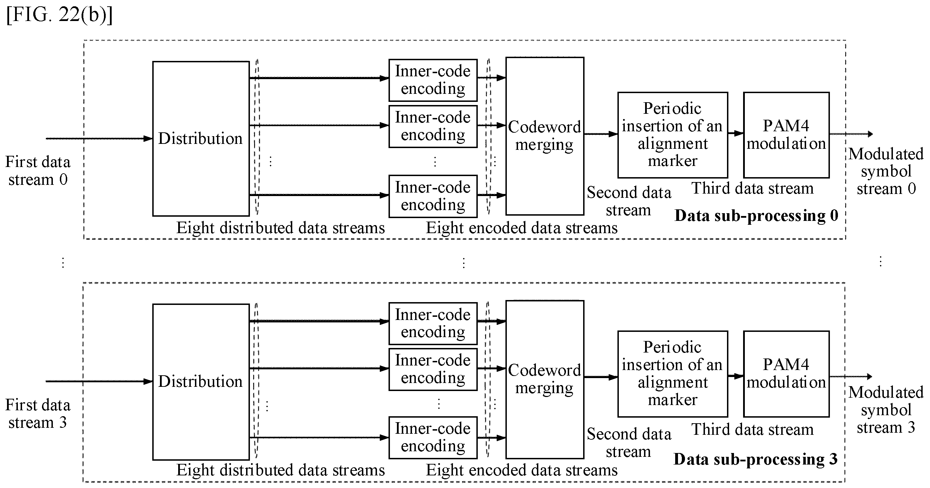

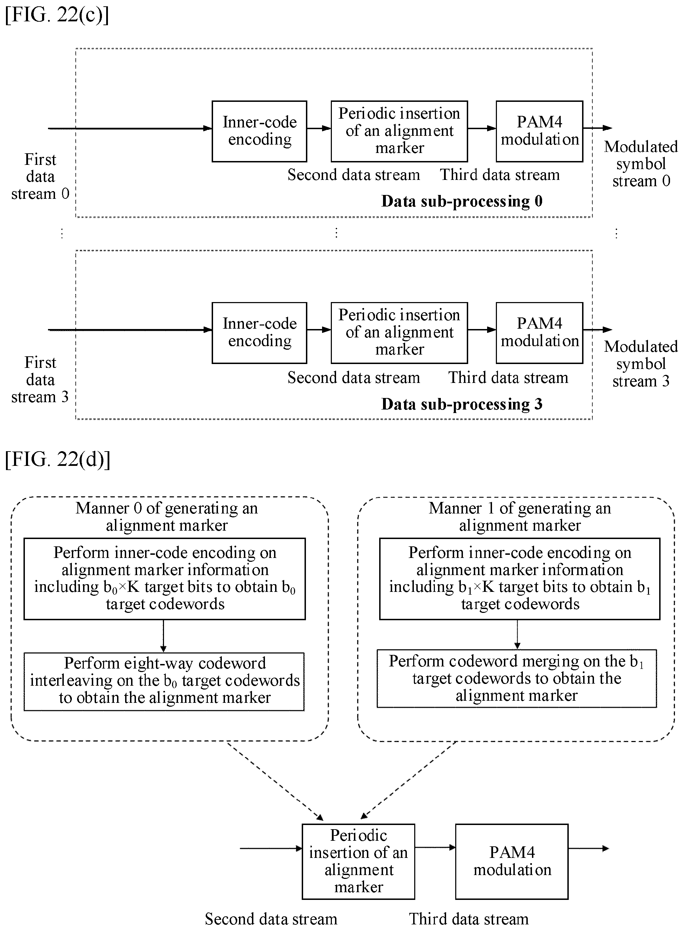

It should be noted that, in some specific application scenarios with a low-latency requirement, the convolutional interleaving in FIG. 22 may be removed, and the convolutional interleaving operation is bypassed (bypassed). Further, to achieve lower latency, lower complexity, and lower power consumption, in some possible scenarios, the cyclic shift operation and/or the channel interleaving (inner codeword interleaving) operation may also be bypassed (bypassed). If the channel interleaving (inner codeword interleaving) operation is bypassed (bypassed), one-way Hamming codeword interleaving (one-way Hamming codeword interleaving) may be performed on the eight encoded data streams. This is equivalent to performing codeword merging (codeword merging) on the eight encoded data streams.

FIG. 22(b) is a diagram of another implementation of data processing according to an embodiment of this application. Each of four first data streams is an input data stream for data sub-processing. A difference from the implementation shown in FIG. 22(a) lies in: As shown in FIG. 22(b), in each piece of data sub-processing, the convolutional interleaving is not performed on the first data stream, but data distribution (distribution) is directly performed to obtain eight distributed data streams. The data distribution is performed at a granularity of $\alpha_0$ bits, to be specific, when $\alpha_0$ bits in the first data stream on which the data distribution is not performed are grouped together, for eight groups of $8 \times \alpha_0$ consecutive bits in total, a $0^{th}$ group of $\alpha_0$ bits is sent to a $0^{th}$ distributed data stream, a $1^{st}$ group of $\alpha_0$ bits is sent to a $1^{st}$ distributed data stream, ..., and a $7^{th}$ group of $\alpha_0$ bits is sent to a $7^{th}$ distributed data stream. Typically, the distribution bit granularity is $\alpha_0 = 120$.

FIG. 22(c) is a diagram of another implementation of data processing according to an embodiment of this application. In a possible implementation, the implementation in FIG. 22(b) is simplified to obtain the implementation shown in FIG. 22(c) that is equivalent to the implementation in FIG. 22(b). Specifically, as shown in FIG. 22(c), in each piece of data sub-processing, the inner-code encoding is performed on the first data stream to obtain the second data stream, the alignment marker is periodically inserted into the second data stream to obtain the third data stream, and the PAM4 modulation is performed to obtain the modulated symbol stream.

It should be noted that, after the modulated symbol stream obtained through the data processing shown in FIG. 22(b) or FIG. 22(c) is transmitted through an actual channel, a received symbol stream is obtained at the receiver, and the PAM4 demodulation is performed to obtain a demodulated data stream. In an example, in a data processing manner of the receiver, the frame synchronization is performed by using the frame synchronization sequence in the alignment marker to obtain a start position of each frame and an inner code boundary, then inner-code soft-decision decoding is performed to obtain an inner-code decoded data stream, and the data stream is sent to a host device for outer-code KP4 decoding. A pre-correction bit error rate of an entire concatenated system may reach approximately 3.3E-3.

In another example, in a data processing manner of the receiver, the frame synchronization is performed by using the frame synchronization sequence in the alignment marker to obtain a start position of each frame and an inner code boundary, then inner-code hard-decision decoding is performed to obtain an inner-code decoded data stream, and the data stream is sent to a host device for outer-code KP4 decoding. A pre-correction bit error rate of an entire concatenated system may reach approximately 6E-4. It should be understood that applying the hard-decision decoding as the inner-code decoding achieves low decoding complexity.

In still another example, in some scenarios in which link quality is good, the receiver may perform frame synchronization by using the frame synchronization sequence in the alignment marker to obtain a start position of each frame and an inner code boundary, and then bypass (bypass) the inner-code decoding. To be specific, the receiver directly removes a parity bit in each received inner codeword in the data stream, retains only an information bit, then performs frame synchronization by using the frame synchronization sequence in the alignment marker to obtain the start position of each frame, removes the alignment marker, and sends a processed data stream to a host device for outer-code KP4 decoding. In this case, the receiver has advantages such as low latency and low complexity.

In some possible implementations, the length W of the alignment marker is an integer multiple of the length N of the inner codeword, and a specific pattern of the alignment marker is one or more inner codewords. In an example, the inner codeword included in the alignment marker is obtained by performing inner-code encoding on alignment marker information, and the inner-code encoding is the second FEC encoding above. The length of the inner codeword obtained by performing inner-code encoding on the alignment marker information is the same as the length of the inner codeword that is in the second data stream and that is obtained through the second FEC encoding. For ease of description, the inner codeword included in the alignment marker may also be referred to as a target codeword, to be specific, a length of the target codeword is the same as the length of the inner codeword in the foregoing second data stream. Specifically, each target codeword is obtained by performing inner-code encoding on the alignment marker information that includes K target bits, the target codeword includes N bits, and the N bits include the K target bits and S parity bits obtained through the encoding.

FIG. 22(d) is a diagram of an implementation of generating the alignment marker according to an embodiment of this application. As shown in FIG. 22(d), two possible manners of generating the alignment marker are provided.

Using a manner 0 of generating the alignment marker as an example, the length W of the alignment marker is an integer multiple of the length N of the target codeword, in other words, $W = b_0 \times N$. $b_0$ is an integer multiple of 8. For example, $W = 8 \times 128 = 1024$. In this case, one or more target codewords may be selected as a specific pattern of the alignment marker. Optionally, the alignment marker is obtained by performing codeword interleaving on a plurality of target codewords. Specifically, the inner-code encoding is performed on alignment marker information including $b_0 \times K$ target bits to obtain $b_0$ target codewords, and eight-way codeword interleaving is performed on the $b_0$ target codewords to obtain the alignment marker. It should be understood that, it should also be considered that the alignment marker obtained by performing codeword interleaving on the plurality of target codewords includes the plurality of target codewords.

Using a manner 1 of generating the alignment marker as an example, the length W of the alignment marker is an integer multiple of the length N of a target codeword, in other words, $W = b_1 \times N$. For example, $W = 3 \times 128 = 384$. For another example, $W = 8 \times 128 = 1024$. In this case, one or more target codewords may be selected as a specific pattern of the alignment marker. Optionally, the alignment marker is obtained by performing codeword merging on a plurality of target codewords. Specifically, the inner-code encoding is performed on alignment marker information including $b_1 \times K$ target bits to obtain $b_1$ target codewords, and codeword merging is performed on the $b_1$ target codewords to obtain the alignment marker.

It should be noted that, for the implementation shown in FIG. 22(a), the manner 0 of generating the alignment marker in FIG. 22(d) or the manner 1 of generating the alignment marker in FIG. 22(d) may be applied. In this case, a corresponding data processing manner of the receiver is: The inner codeword self-synchronization is performed on a demodulated data stream obtained through demodulation, to obtain the inner codeword boundary. Then, a data stream obtained through eight-way inner codeword de-interleaving is obtained, the inner-code decoding is performed, and the frame synchronization is performed by using the frame synchronization sequence in the inner-code decoded alignment marker information, to obtain the start position of each frame. It should be understood that, because reliability of the frame synchronization sequence and a status field (status field) that are included in the inner-code decoded alignment marker information is further improved, a time period for the frame synchronization can be shortened.

It should be noted that, for the implementation shown in FIG. 22(b) or FIG. 22(c), the manner 0 of generating the alignment marker in FIG. 22(d) or the manner 1 of generating the alignment marker in FIG. 22(d) may be applied. In this case, a corresponding data processing manner of the receiver is: The inner codeword self-synchronization is performed on a demodulated data stream obtained through demodulation, to obtain the inner codeword boundary. Then, the inner-code decoding is performed, and the frame synchronization is performed by using the frame synchronization sequence in the inner-code decoded alignment marker information, to obtain the start position of each frame. It should be understood that, because reliability of the frame synchronization sequence or a status field (status field) that is included in the inner-code decoded alignment marker information is further improved, a time period for the frame synchronization can be shortened.

It should be noted that, in the data processing methods shown in FIG. 22(a), FIG. 22(b), and FIG. 22(c), the third data stream obtained by inserting the alignment marker includes the W-bit alignment marker in every P+W bits, and the synchronization sequence in the alignment marker is at a fixed position. Therefore, in the data processing manners shown in FIG. 22(a), FIG. 22(b), and FIG. 22(c), a same operation may be performed for the frame synchronization in the corresponding data processing at the receiver to obtain the start position of the frame, so that one set of hardware is compatible with the data processing that is at the receiver and that corresponds to the data processing at the transmitter in FIG. 22(a), FIG. 22(b), and FIG. 22(c).

It should be noted that, in the 1.6TE scenario, the data processing includes eight pieces of data sub-processing, a data stream input of each piece of data sub-processing is one first data stream, and the first data stream corresponds to a rate of approximately 200G bits per second. Correspondingly, the distributed data stream corresponds to a rate of approximately 25G bits per second.

It should be noted that, in some specific applications, the length W of the alignment marker is an integer multiple of the length N of the codeword obtained through the second FEC encoding (also referred to as the inner-code encoding), and P is an integer multiple of N. In this case, the alignment marker may be protected by the inner-code encoding, to be specific, the W-bit alignment marker includes W/N inner codewords, where $W/N \times K$ bits correspond to information bits in the inner codeword, and $W/N \times (N - K)$ bits correspond to parity bits in the W/N inner codeword. Typically, $\overline{W}_0$ bits in the W/N $\times K$ bits are used as the foregoing frame synchronization sequence, and the other bits are for transferring link information and/or control information, includes a receiver status, a FEC status, and the like, and is also referred to as the status field (status field). Specifically, to improve accuracy of the transferred link information and/or control information, in W/N $\times$ K - $\overline{W}_0$ remaining bits other than the foregoing frame synchronization sequence in the W/N $\times$ K bits, $\overline{W}_1$ bits indicate a type of the link information and/or a type of the control information, $\overline{W}_2$ bits indicate specific content of the link information and/or control information, and $\overline{W}_3$ bits are for cyclic redundancy check (Cyclic Redundancy Check, CRC). Typically, $\overline{W}_1 = 8$, and a value of $\overline{W}_3$ is 8, 16, or 32. In some other specific applications, the indicated link information and/or control information needs to be transferred in a coordinated manner by using a plurality of frames, to further improve the accuracy of the transferred information. In this case, $\overline{W}_4$ bits in the W/N $\times$ K bits indicate the plurality of frames, and the $\overline{W}_4$ bits are also referred to as a multi-frame synchronization signal. Typically, $\overline{W}_4 = 8$.

In some specific applications, as shown in FIG. 15, the frame synchronization sequence includes 48 bits that are distributed into two frame synchronization subsequences, and the two frame synchronization subsequences are separated by eight bits. In this case, the eight bits for separation may be used as eight bits for the CRC8 check, eight bits indicating the type of the link information and/or the type of the control information, or eight bits for the multi-frame synchronization signal.

Based on the foregoing descriptions, in this embodiment of this application, the alignment marker (Alignment marker) is periodically inserted (periodically inserted) into the data stream obtained through concatenated FEC encoding. Specifically, the P bits are periodically obtained from the data stream obtained through the concatenated FEC encoding, and the alignment marker (also referred to as a frame header, which may include the padding bit or the status field) with a length of W bits is inserted, so that the alignment marker with a length of W bits exists in every P+W bits (referred to as the frame) in the data stream. The positive integers P and W are selected, so that the value of the baud rate of the modulated symbol data stream is the integer multiple of the Ethernet common reference clock (Ethernet common reference clock) frequency. This simplifies the clock extraction and synchronization manners of the receiver, implements the fast phase locking, and achieves the low PLL complexity and low jitter. In addition, P needs to be the multiple of the code length N of the inner code, in other words, $P = N \times b$, and the inner codeword synchronization can be ensured after the receiver performs frame synchronization (namely, frame synchronization of the P+W bits, also referred to as the alignment marker lock operation) on the received data. This simplifies the operations such as the frame synchronization and the inner codeword synchronization of the receiver, and achieves the low implementation complexity. In addition, input and output switches of the convolution interleaver are at topmost positions each time the convolution interleaver output f bits, and input and output switches of a convolution de-interleaver are at topmost positions each time the convolution de-interleaver output f bits; and $K \times b$ is exactly divisible by f, so that synchronization performed by the convolution de-interleaver can be ensured during the frame synchronization.

When performing frame synchronization by using the W-bit alignment marker (also referred to as the frame header, which may include the padding bit or the status field), the receiver needs to identify the marker bit by bit. Considering that the value of the integer P is usually large, complexity of the frame synchronization operation for identifying the marker bit by bit is greater than complexity of the inner codeword synchronization operation. In some application scenarios, the length W of the alignment marker may be selected as an integer multiple of the length N of the codeword obtained through the second FEC encoding (also referred to as the inner-code encoding), and the one or more inner codewords may be selected as the specific pattern of the alignment marker, so that the receiver can perform low-complexity frame synchronization and codeword synchronization. The foregoing operation manner of first performing inner-code encoding and then periodically inserting the alignment marker may be equivalent to the following operation manner of first periodically inserting the marker and then performing inner-code encoding. In other words, the inner-code encoding scheme applied to the "first performing inner-code encoding and then periodically inserting the alignment marker" in the foregoing embodiment may also be applied as an inner-code encoding scheme for the "first periodically inserting the marker and then performing inner-code encoding" in the following implementation. For example, the block code with an information length of K=120 bits and a codeword length of N=128 bits in Embodiment 1 may also be used in the following specific implementation. The following describes a specific implementation solution for the "first periodically inserting the marker and then performing inner-code encoding".

FIG. 7 is still another schematic flowchart of a data processing method according to an embodiment of this application. It should be understood that the data processing method is applied to a transmitter, and includes the following steps.

401: Perform first data processing on m first data streams to obtain m second data streams.

In this embodiment, all the m first data streams are data streams obtained through first FEC encoding, namely, the outer-code encoded data streams described above. Typically, a value of m is 4, 8, 16, 32, or 64.

Specifically, a first marker is periodically inserted (periodically inserted) into each data stream in the m first data streams to obtain the m second data streams in total. Specifically, $\tilde{P}$ bits are periodically obtained from each first data stream, and the first marker with a length of $\tilde{W}$ bits is inserted, so that the first marker with a length of $\tilde{W}$ bits exists in every $\tilde{P}+\tilde{W}$ bits in each of the second data streams.

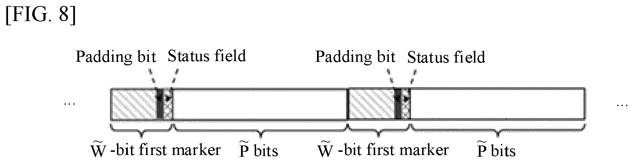

FIG. 8 is a diagram of a structure of a second data stream according to an embodiment of this application. As shown in FIG. 8, the second data stream includes at least one first bit sequence, each first bit sequence includes $\tilde{P}+\tilde{W}$ bits, the $\tilde{P}$ bits in each first bit sequence are from the first data stream, and the $\tilde{W}$ bits in each first bit sequence are the added first marker. It should be noted that the first marker may include a padding bit (padding bit) and/or a status field (status field). The padding bit may be a preset bit, for example, all 0s; or may be a random bit. The status field (status field) indicates a FEC state. In some other scenarios, the $\tilde{W}$-bit first marker may not be consecutively arranged, and a position of the $\tilde{W}$-bit alignment marker in the $\tilde{P}+\tilde{W}$ bits is not specifically limited herein.

It should be noted that, in every $\tilde{P}+\tilde{W}$ bits, the $\tilde{W}$-bit first marker may be first $\tilde{W}$ consecutive bits in the $\tilde{P}+\tilde{W}$ bits, or may be last $\tilde{W}$ consecutive bits in the $\tilde{P}+\tilde{W}$ bits.

In some possible implementations, a concatenated interleaver is added between an inner code and an outer code to make performance of an overall concatenated FEC solution desirable. An operation of concatenated interleaving usually includes convolutional interleaving to achieve low latency. In other words, all the m first data streams are data streams obtained through the concatenated interleaving. A specific implementation of the concatenated interleaving includes lane permutation and the convolutional interleaving. In the lane permutation, data permutation is performed on g input data streams to obtain g data streams that are obtained through the data permutation. Then, the convolutional interleaving is separately performed to obtain g convolutional interleaved data streams. Another specific implementation of the concatenated interleaving includes lane multiplexing and the convolutional interleaving. In the lane multiplexing, symbol multiplexing (symbol mux) is performed on g input data streams to obtain g1 symbol multiplexed data streams, where g is exactly divisible by g1. Then, the convolutional interleaving is separately performed on the g1 data streams to obtain g1 convolutional interleaved data streams. In this case, g1 is not equal to g. In other words, a quantity of first data streams may be the same as or different from a quantity of second data streams obtained by performing first data processing on the first data streams. This is specifically subject to an actual application scenario, and is not limited herein. For a possible implementation of the convolutional interleaving, refer to step 301 for understanding.

In some possible implementations, at least one of operations such as alignment marker lock (alignment lock), lane de-skewing (lane de-skew), and lane reordering (lane reorder) may be further performed before the first data processing.

In some possible implementations, an operation of the first data processing may further include scrambling (scrambling). For example, each first data stream is scrambled first, and then the first marker is periodically inserted. In this way, synchronization quality is better when a receiver performs synchronization.

402: Perform second data processing on the m second data streams to obtain m third data streams.

In this embodiment, an operation of the second data processing includes but is not limited to performing second FEC encoding on each of the second data streams. The second FEC encoding may be understood as the inner-code encoding described above. In other words, the second FEC encoding has been performed for all the m third data streams, where m is an integer greater than 1. Typically, the value of m is 4, 8, 16, 32, or 64. In an example, an inner-code encoder performs inner-code encoding on every K information bits in each of the second data streams, to be specific, adds S parity bits to obtain an inner codeword with a total of N bits, in other words, N=K+S, where K≥1, and S≥1.

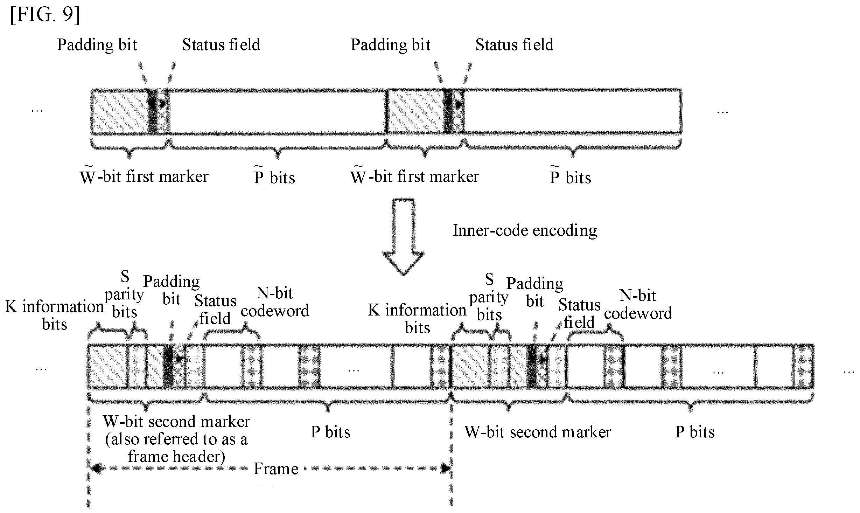

FIG. 9 is a diagram of a structure of a third data stream according to an embodiment of this application. As shown in FIG. 9, each of the third data streams includes at least one second bit sequence, each second bit sequence includes P+W bits, the P bits in each second bit sequence are obtained by performing second FEC encoding on the $\tilde{P}$ bits, the W bits in each second bit sequence are a second marker, and the second marker is obtained by performing second FEC encoding on the first marker, where P=N×b, and W=N×e.

It should be noted that the length $\tilde{W}$ of the first marker inserted into each first data stream in step 401 is a multiple of the inner code information length K, and $\tilde{W} = K \times e$, where the integer e is an integer greater than 0. In addition, in the $\tilde{P}$ bits periodically obtained in step 401, $\tilde{P} = K \times b$, where the integer b is an integer greater than 0. The inner-code encoding is performed on the first marker to obtain the second marker with a length of W = N × e. In step 401, the $\tilde{P}$ bits are periodically obtained, and the $\tilde{W}$-bit first marker is added, to obtain the $\tilde{P}+\tilde{W}$ bits, and the inner-code encoding is performed on the $\tilde{P}+\tilde{W}$ bits to obtain the length of P+W bits, where P= N × b. In a data stream obtained by performing inner-code encoding on each of the second data streams, the W-bit second marker exists in every P+W bits. In FIG. 9, $\tilde{W} = K \times e = K \times 2$ and W= N × e = N × 2 are used as an example. In some specific implementations, the P+W bits are referred to as one frame, and the W-bit second marker is referred to as a frame header.

In some possible implementations, the operation of the second data processing may further include at least one of operations such as channel interleaving (channel interleaving) and scrambling (scrambling). For example, the at least one of operations such as channel interleaving (channel interleaving) and scrambling (scrambling) is further performed on each of the second data streams after the second FEC encoding.

It should be noted that, the second marker shown in FIG. 9 is a structure in the inner-code encoded data stream. Another operation, for example, channel interleaving for disordering, may be further performed on the inner-code encoded data stream. In this case, the second marker in a channel interleaved data stream is disordered. However, a channel interleaving mode is fixed and preset, and the receiver may recover a specific position of the second marker in the data stream when performing inner-code synchronization based on the channel interleaving mode.

403: Perform third data processing on the m third data streams to obtain Y modulated symbol streams.

In this embodiment, the third data processing including modulation is performed on the m third data streams to obtain the Y modulated symbol streams, where Y is an integer greater than or equal to 1.

In some possible implementations, an operation of the third data processing may further include at least one of operations such as codeword interleaving and symbol interleaving. For example, the codeword interleaving is performed first and then the modulation is performed on each of the third data streams. For another example, the modulation is performed first and then the symbol interleaving is performed on each of the third data streams, where the symbol interleaving is also referred to as channel interleaving. Colored noise in channel transmission may be interleaved through the symbol interleaving for disordering, so that quality of a signal recovered by the receiver is good.

It should be noted that, in some specific applications, the channel interleaving is first performed on every $n_{HM}$ third data streams in the m third data streams to obtain one channel interleaved data stream, and there are a total of $m/n_{HM}$ channel interleaved data streams. The $m/n_{HM}$ channel interleaved data streams are modulated to obtain $m/n_{HM}$ modulated symbol data streams, where $m/n_{HM}$ = Y. One inner codeword with a length of N bits is obtained from each of the $n_{HM}$ third data streams through the channel interleaving, to obtain a total of $n_{HM}$ inner codewords. The $n_{HM}$ inner codewords include $n_{HM} \times N$ bits, and two bits are obtained, as bits in the second data stream, from each inner codeword in a round-robin (Round-Robin) manner, to obtain $n_{HM} \times N$ consecutive bits in the channel interleaved data stream. The channel interleaving is also referred to as $n_{HM}$-way Hamming codeword interleaving ($n_{HM}$-way Hamming codeword interleaving), or referred to as inner codeword interleaving.

Considering that the channel interleaving is first performed and then the modulation is performed on every $n_{HM}$ third data streams in the m third data streams for the $m/n_{HM}$ modulated symbol data streams in total, correspondingly, a total of $n_{HM} \times \tilde{P} \times N/K + n_{HM} \times \tilde{W} \times N/K$ bits are obtained by performing inner-code encoding and channel interleaving on a total of $n_{HM} \times (\tilde{P} + \tilde{W})$ bits including $\tilde{P} + \tilde{W}$ bits in each third data stream in $n_{HM}$ second data streams. The $n_{HM} \times \tilde{P} \times N/K + n_{HM} \times \tilde{W} \times N/K$ bits are referred to as one frame, and $n_{HM} \times \tilde{W} \times N/K$ bits obtained by performing encoding and channel interleaving on $n_{HM}$ first markers are referred to as a frame identifier. In some specific implementations, the frame identifier is also referred to as a frame header.

It should be noted that the $\tilde{W}$-bit first marker may include a synchronization subsequence for the receiver to perform frame synchronization, where a length of the synchronization subsequence is less than $\tilde{W}$. Each of the m second data streams includes one periodically inserted synchronization subsequence, and there are a total of m synchronization subsequences. In some specific applications, lengths of the m synchronization subsequences are the same, and are all $\tilde{W}_s$ bits. The inner-code encoding and the channel interleaving (the $n_{HM}$-way inner codeword interleaving) are performed on every $n_{HM}$ synchronization subsequences in the m synchronization subsequences to obtain $n_{HM} \times \tilde{W}_s$ bits in the channel interleaved data stream. The $n_{HM} \times \tilde{W}_s$ bits may be referred to as a frame synchronization sequence, and may also be referred to as a synchronization sequence for short. The $m/n_{HM}$ channel interleaved data streams correspond to $m/n_{HM}$ synchronization sequences. It should be noted that, in some specific embodiments, specific bit patterns of the $n_{HM}$ synchronization subsequences are not completely the same, but specific bit patterns of the $m/n_{HM}$ synchronization sequences are the same.

It should be noted that, in some other specific applications, each of the m second data streams includes one periodically inserted synchronization subsequence, and there are a total of m synchronization subsequences, where lengths of the m synchronization subsequences are not all the same.

It should be noted that, in some specific applications, to further improve anti-burst performance of a whole concatenated code, before the $\tilde{W}$-bit first marker is periodically inserted, a cyclic shift operation is further performed on data in the data stream. Left cyclic shift or right cyclic shift is performed on every K information bits in the data stream through the cyclic shift operation.

It should be noted that, in this application, the positive integers $\tilde{P}$ and $\tilde{W}$ are selected, so that a value of a baud rate of the modulated symbol data stream is an integer multiple of a reference clock (reference clock) frequency. This simplifies implementation of clock extraction and clock synchronization performed by the receiver, implements fast phase locking, and achieves low PLL complexity and low jitter. It should be understood that a specific value of the reference clock frequency is not limited in this application. For example, the value may be an Ethernet common reference clock (Ethernet common reference clock) frequency. In an example, the value of the baud rate of the modulated symbol data stream is an integer multiple of 156.25M. It should be further understood that a specific error range may be accepted during actual application. For example, the value of the baud rate of the modulated symbol data stream is the integer multiple of 156.25M $\pm V$ (ppm), where V may be 20, 50, or 100.

Further, the selected positive integers $\tilde{P}$ and $\tilde{W}$ are both divisible by the inner code information length K, so that hardware implementation complexity is low when a receiver processing module performs frame synchronization (namely, frame synchronization of the P+W bits or frame synchronization of $n_{HM} \times \tilde{P} \times N/K + n_{HM} \times \tilde{W} \times N/K$ bits, also referred to as an alignment marker lock operation) on received data and codeword synchronization. Still further, the positive integer $\tilde{P}$ is selected, so that concatenated de-interleaving synchronization can be ensured through inner codeword synchronization. In other words, according to the data processing method provided in this application, implementation complexity of the frame synchronization, the inner codeword synchronization, and the concatenated de-interleaving synchronization performed by the receiver processing module is low.

It should be noted that the receiver first performs codeword synchronization and then performs frame synchronization, or may directly perform frame synchronization bit by bit by using the first marker or the second marker. This can ensure the codeword synchronization and the concatenated de-interleaving synchronization. This is not specifically limited herein.

The following describes value requirements for $\tilde{P}$ and $\tilde{W}$ in detail.

Considering an 800GbE scenario, a transmitter device performs outer-code encoding on to-be-transmitted 800GbE service data streams by using a KP4 RS(544,514) code to obtain data streams with a total rate of 850 Gbps, and sends the data streams to a transmitter processing module through an attachment unit interface 800GAUI after PMA processing. The transmitter processing module periodically inserts the first marker into the m first data streams separately, in other words, performs first data processing to obtain the m second data streams, where a total rate of the m second data streams is $850 \times \dfrac{\tilde{W}+\tilde{P}}{\tilde{P}}$ Gbps. The second data processing including the inner-code encoding is performed on the m second data streams to obtain the m third data streams, where a total rate of the m third data streams is

$$850 \times \frac{\widetilde{W}+\widetilde{P}}{\widetilde{P}} \times \frac{N}{K} \text{ Gbps}$$

Gbps . The third data processing including PAM4 modulation is performed on the third data streams to obtain four modulated symbol streams, where a baud rate of the modulation symbol stream is

$$\frac{850}{2\times4} \times \frac{\widetilde{W}+\widetilde{P}}{\widetilde{P}} \times \frac{N}{K}$$

Gbaud. Herein, baud represents a rate of a modulated symbol communicated per second. Assuming that the reference clock frequency is $\varphi$ MHz, and the value of the baud rate of the PAM4 modulated symbol stream is an integer multiple of the Ethernet common reference clock frequency,

$$\frac{850}{2\times4} \times \frac{\widetilde{W}+\widetilde{P}}{\widetilde{P}} \times \frac{N}{K} G = a \times \varphi$$

M, where N is a code length of the inner code, K is an information bit length of the inner code, and a is a positive integer. G represents 10^9, and M represents 10^6. In this case, the implementation of performing clock extraction and clock synchronization by the receiver is simple, the fast phase locking can be implemented, and the PLL complexity and jitter are low. One Ethernet common reference clock frequency is 156.25 MHz. In some 800GbE scenarios, considering a baud rate of 112.5G,

$$\frac{\widetilde{W}+\widetilde{P}}{\widetilde{P}} \times \frac{N}{K} = \frac{18}{17}$$

. In this case, overall PLL implementation is simpler.

Further, when $\widetilde{P}$ is a multiple of the inner code information length K, and $\widetilde{W}$ is a multiple of the inner code information length K, in other words, $\widetilde{P} = K \times b$, and $\widetilde{W} = K \times e$, where b and e are positive integers, in a data stream obtained by performing second FEC encoding on the second data stream, W bits at a fixed position in every P+W bits are the second marker, and the second marker corresponds to the $\widetilde{W}$-bit first marker, where P= N $\times$ b, W = N $\times$ e, and every N bits in the P+W bits are one inner codeword. In some specific embodiments, the P+W bits are referred to as a frame, and the W-bit second marker is referred to as a frame header. The receiver may first perform inner codeword synchronization on a received data stream, to identify a boundary of the inner codeword. With reference to a fixed position of a 1st bit of the first marker or the second marker in the inner codeword, simple frame synchronization may be performed by using the first marker or the second marker, to identify the first marker or the second marker. When the receiver processing module performs frame synchronization (namely, frame synchronization of the P+W bits, also referred to as the alignment marker lock operation) on the received data, it is unnecessary to perform complex bit-by-bit marker identification.

It should be noted that, considering that the channel interleaving is first performed and then the modulation is performed on every $n_{HM}$ third data streams in the m third data streams to obtain the m/$n_{HM}$ modulated symbol data streams in total, $n_{HM} \times \widetilde{W} \times N/K$ bits at a fixed position in every $n_{HM} \times \widetilde{P} \times N/K + n_{HM} \times \widetilde{W} \times N/K$ bits in the channel interleaved data stream are the frame synchronization sequence, and the frame synchronization sequence corresponds to $n_{HM}$ first markers of $n_{HM} \times \widetilde{W}$ bits.

Further, because the transmitter processing module applies the concatenated interleaving including the convolutional interleaving, to ensure convolutional de-interleaving synchronization during the frame synchronization, the receiver processing module should meet a condition that a start position of each frame (the W+P bits or the $n_{HM} \times \widetilde{P} \times N/K + n_{HM} \times \widetilde{W} \times N/K$ bits) corresponds to start positions of input and output switches (input and output switches) of a convolutional de-interleaver, and the start positions are usually topmost positions (topmost positions), for example positions of the delay line 0 shown in FIG. 4(a) and FIG. 4(b). More specifically, input and output switches of a convolution interleaver are at topmost positions each time the convolution interleaver output f bits, and the input and output switches of the convolution de-interleaver are at the topmost positions each time the convolution de-interleaver output f bits, and K$\times$b is exactly divisible by f, so that synchronization performed by the convolution de-interleaver can be ensured during the frame synchronization. In a specific manner, r*d*c=K $\times$ b, where r is a quantity of delay lines in each of the convolution interleaver and the convolutional de-interleaver, d is a quantity of bits stored in a storage unit in each of the convolution interleaver and the convolutional de-interleaver, and c is a positive integer. In this way, based on the improvement of the transmitter processing module in this application, the receiver processing module can implement the frame synchronization and the codeword synchronization with low complexity. In addition, the frame synchronization of the received data ensures convolutional de-interleaving synchronization, simplifies operations such as the frame synchronization, the inner codeword synchronization, and the concatenated interleaving synchronization at the receiver, and achieves low implementation complexity.

It should be noted that, in the data processing operation in this embodiment, the $\widetilde{W}$-bit first marker is first periodically inserted into the data stream, and then the inner-code encoding is performed. In a 1st embodiment of this application, the inner-code encoding is first performed on the data stream, and then the W-bit alignment marker is periodically inserted into the inner-code encoded data stream. In a 2nd embodiment, the inner-code encoding is performed on the $\widetilde{W}$-bit first marker to obtain the W-bit second marker. When the second marker is the same as the W-bit alignment

marker in the 1st embodiment, effects achieved in the two embodiments are the same, in other words, the two embodiments are equivalent.

The following provides several implementations based on different inner-code encoding schemes to describe possible values of $\tilde{W}$ and $\tilde{P}$.

Implementation 1: A FEC code with an information length of K=140 bits and a codeword length of N=148 bits is used for the inner-code encoding.

It is considered that the inner code is the FEC code, for example, Hamming(148,140), with an information length of K=140 bits and a codeword length of N=148 bits.

FIG. 10 is a diagram of an implementation of inner-code encoding according to an embodiment of this application. For another example, an encoding scheme shown in FIG. 10 is used, to-be-encoded 140-bit data is represented by B [139:0], bitwise exclusive OR is performed on every two consecutive bits in the 140-bit data to obtain one-bit data C[i], and 70-bit data is obtained in total, and is represented by C[69:0], where C[i]=B[2*i]^B[2*i+1], where $0 \leq i \leq 69$. Then, Hamming(78,70) encoding is performed on C[69:0] as information data to obtain eight-bit parity data that is represented by P[7:0]. Finally, 148 bits of B[139:0] and P[7:0] in total are concatenated into an output of the inner-code encoding, where the output is represented by D[147:0]. D[139:0] is from B[139:0], and D[147:140] is from P[7:0].

Considering an 800GbE scenario, the baud rate of the PAM4 modulated symbol stream is $\frac{850}{2\times4} \times \frac{148}{140} \times \frac{\tilde{W}+\tilde{P}}{\tilde{P}}$ Gbaud. Assuming that the value $\frac{850}{2\times4} \times \frac{148}{140} \times \frac{\tilde{W}+\tilde{P}}{\tilde{P}}$ Gbaud of the baud rate is an integer multiple of the Ethernet common reference clock frequency (156.25 MHz), in other words, $\frac{850}{2\times4} \times \frac{148}{140} \times \frac{\tilde{W}+\tilde{P}}{\tilde{P}}G = 156.25 \times aM$, where a is a positive integer, G represents 10^9, and M represents 10^6. $a = \frac{5032}{7} \times \frac{\tilde{W}+\tilde{P}}{\tilde{P}}$, and a is an integer. The implementation of performing clock extraction and clock synchronization by the receiver is simple, the fast phase locking can be implemented, and the PLL complexity and jitter are low.

When $\tilde{P}$ and $\tilde{W}$ are multiples of the inner code information length K, in other words, $\tilde{P} = K \times b$, and $\tilde{W} = K \times e$, the receiver performs the frame synchronization and inner codeword synchronization operations with low complexity. In this case, $a = \frac{5032}{7} \times \frac{140\times b+140\times e}{140\times b} = \frac{5032+(\frac{5032\times e}{b})}{7}$, the positive integer $5032 \times e$ is exactly divisible by the positive integer b, and the positive integer $5032 + (\frac{5032\times e}{b})$ is exactly divisible by 7. Table 11 enumerates some parameter combinations and corresponding baud rates.

Table 11

| $\tilde{W}$ | $\tilde{P}$ | a | b | e | Baud rate (Gbaud) |
|---|---|---|---|---|---|
| 140 | 4760 | 740 | 34 | 1 | 115.625 |
| 140 | 88060 | 720 | 629 | 1 | 112.5 |
| 140 | 704480 | 719 | 5032 | 1 | 112.34375 |
| 280 | 9520 | 740 | 68 | 2 | 115.625 |
| 280 | 176120 | 720 | 1258 | 2 | 112.5 |
| 280 | 1408960 | 719 | 10064 | 2 | 112.34375 |

The parameter combination $\tilde{W}$, $\tilde{P}$, b, and e in Table 11 may also be used in a 1.6TbE scenario. For the 1.6TbE scenario with the PAM4 modulation, a corresponding parameter a and a corresponding baud rate are twice the parameter a and the baud rate in the 800GbE scenario. In some 800GbE scenarios with the PAM4 modulation and the baud rate of 112.5G or 1.6TbE scenarios with the PAM4 modulation and the baud rate of 225G, $\frac{\tilde{W}+\tilde{P}}{\tilde{P}} \times \frac{N}{K} = \frac{18}{17}$, and b = 629 × e.

The inner code information length is K=140 bits, and one RS symbol of an outer KP4 code includes 10 bits. For the convolution interleaver between the inner code and the outer code, there is a convolution interleaver whose input and output switches are at topmost positions each time the convolution interleaver outputs 140 bits. For example, a quantity r of delay lines of the convolution interleaver is 7, and each storage unit of the convolution interleaver stores d=20 bits. In this case, the receiver processing module can implement the frame synchronization and the codeword synchronization with low complexity. In addition, the convolutional de-interleaving synchronization can be ensured through the frame synchronization of the received data, in other words, positions of input and output switches (input and output switches) of convolutional de-interleaving are obtained. This simplifies operations such as the frame synchronization, the inner codeword synchronization, and the concatenated interleaving synchronization at the receiver, and achieves low implementation complexity.

Implementation 2: A FEC code with an information length of K=120 bits and a codeword length of N=127 bits is used for the inner-code encoding.

It is considered that the inner code is the FEC code, for example, Hamming(127,120), with an information length of K=120 bits and a codeword length of N=127 bits.

FIG. 11 is a diagram of another implementation of inner-code encoding according to an embodiment of this application. For another example, an encoding scheme shown in FIG. 11 is used, to-be-encoded 120-bit data is represented by B[119:0], bitwise exclusive OR is performed on every two consecutive bits in the 120-bit data to obtain one-bit data C[i], and 60-bit data is obtained in total, and is represented by C[59:0], where C[i]= B[2*i]^B[2*i+1], where $0 \leq i \leq$ 59. Then, Hamming(67,60) encoding is performed on C[59:0] as information data to obtain seven-bit parity data that is represented by P[6:0]. Finally, 127 bits of B[119:0] and P[6:0] in total are concatenated into an output of the inner-code encoding, where the output is represented by D[126:0]. D[119:0] is from B[119:0], and D[126:120] is from P[6:0].

Considering an 800GbE scenario, the baud rate of the PAM4 modulated symbol stream is $\frac{850}{2 \times 4} \times \frac{127}{120} \times \frac{\widetilde{W}+\widetilde{P}}{\widetilde{P}}$

Gbaud. Assuming that the value $\frac{850}{2 \times 4} \times \frac{127}{120} \times \frac{\widetilde{W}+\widetilde{P}}{\widetilde{P}}$ Gbaud of the baud rate is an integer multiple of the Ethernet common reference clock frequency (156.25 MHz), in other words, $\frac{850}{2 \times 4} \times \frac{127}{120} \times \frac{\widetilde{W}+\widetilde{P}}{\widetilde{P}} G = 156.25 \times aM$ , where a is a positive integer, G represents 10^9, and M represents 10^6. $a = \frac{2159}{3} \times \frac{\widetilde{W}+\widetilde{P}}{\widetilde{P}}$, and a is an integer. The implementation of performing clock extraction and clock synchronization by the receiver is simple, the fast phase locking can be implemented, and the PLL complexity and jitter are low.

When $\widetilde{P}$ and $\widetilde{W}$ are multiples of the inner code information length K, in other words, $\widetilde{P} = K \times b$, and $\widetilde{W} = K \times e$, the receiver performs the frame synchronization and inner codeword synchronization operations with low complexity. In this case, $a = \frac{2159}{3} \times \frac{120 \times b + 120 \times e}{120 \times b} = \frac{2159+(\frac{2159 \times e}{b})}{3}$ , the positive integer $2159 \times e$ is exactly divisible by the positive integer b, and the positive integer $2159 + (\frac{2159 \times e}{b})$ is exactly divisible by 3. Table 12 enumerates some parameter combinations and corresponding baud rates.

Table 12

| $\widetilde{W}$ | $\widetilde{P}$ | a | b | e | Baud rate (Gbaud) |
|---|---|---|---|---|---|
| 120 | 2040 | 762 | 17 | 1 | 119.0625 |
| 120 | 259080 | 720 | 2159 | 1 | 112.5 |
| 240 | 4080 | 762 | 34 | 2 | 119.0625 |
| 240 | 518160 | 720 | 4318 | 2 | 112.5 |

In some 800GbE scenarios with the PAM4 modulation and the baud rate of 112.5G or 1.6TbE scenarios with the PAM4 modulation and the baud rate of 225G, $\frac{\widetilde{W}+\widetilde{P}}{\widetilde{P}} \times \frac{N}{K} = \frac{18}{17}$ , and b = 2159 × e. In this case, overall PLL implementation is simpler.

The inner code information length is K=120 bits, and one RS symbol of an outer KP4 code includes 10 bits. For the convolution interleaver between the inner-code encoding and the outer-code encoding, there is a convolution interleaver whose input and output switches are at topmost positions each time the convolution interleaver outputs 120 bits. For example, a quantity r of delay lines of the convolution interleaver is 3, and each storage unit of the convolution interleaver stores d=40 bits. For another example, a quantity r of delay lines of the convolution interleaver is 6, and each storage unit of the convolution interleaver stores d=20 bits. In this case, the receiver processing module can implement the frame synchronization and the codeword synchronization with low complexity. In addition, the convolutional de-interleaving synchronization can be ensured through the frame synchronization of the received data, in other words, positions of input and output switches (input and output switches) of convolutional de-interleaving are obtained. This simplifies operations such as the frame synchronization, the inner codeword synchronization, and the concatenated interleaving synchronization at the receiver, and achieves low implementation complexity.

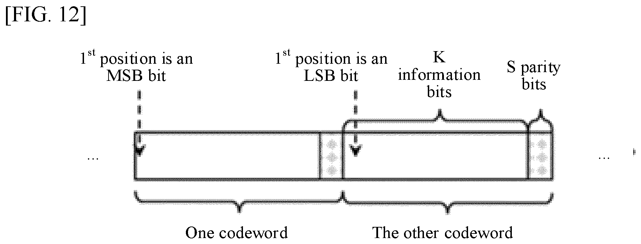

It should be noted that when the PAM4 modulation is applied, each PAM4 symbol corresponds to two bits, and a bit error rate of an MSB (Most Significant Bit) is different from that of an LSB (Least Significant Bit). When the bit length N of the codeword (for example, the FEC code with a code length of 127 bits used in the implementation 2) is an odd number, two inner codewords are consecutive. FIG. 12 is a diagram of a structure of a codeword. As shown in FIG. 12, a 1st bit in a K-bit information sequence (also referred to as K information bits for short) of one codeword is an MSB, and a 1st bit in a K-bit information sequence of the other codeword is an LSB. This is not conducive to hardware implementation of inner-code decoding performed by the receiver.

To resolve the foregoing problem, in some possible application scenarios, inner codeword interleaving processing may be performed on t inner-code encoded inner codewords, where t is an even number, for example, 2, 4, 8, or 16. The following describes the inner codeword interleaving processing in detail.

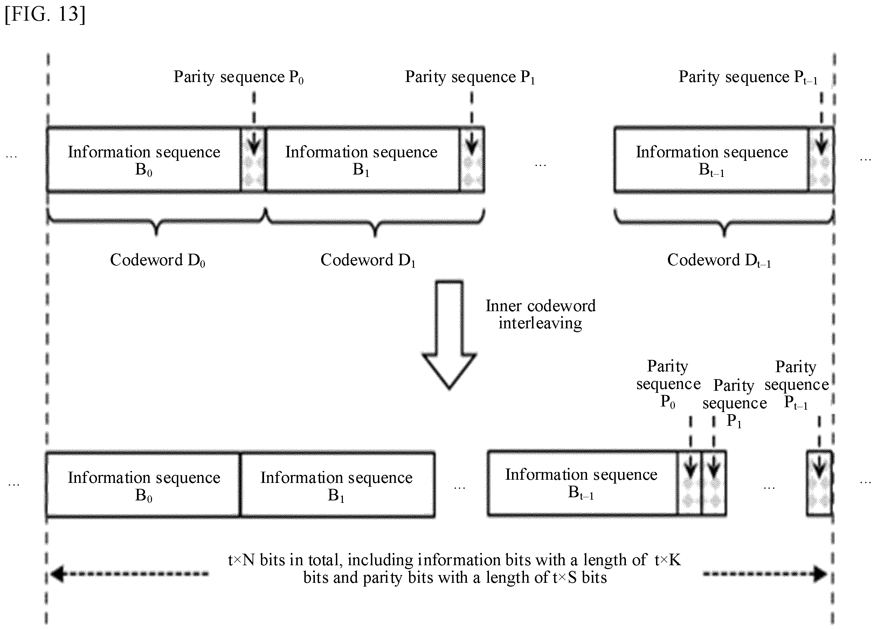

FIG. 13 is another diagram of a structure of a codeword. As shown in FIG. 13, t inner codewords, namely, $D_0$, $D_1$, $D_2$, ..., $D_{t-1}$, are considered, where a codeword $D_i$ ($0 \leq i \leq t - 1$) includes a K-bit information sequence $B_i$ and an S-bit parity sequence $P_i$. More specifically, there are t information sequences, namely, $B_0$, $B_1$, $B_2$, ..., $B_{t-1}$, and there are t parity sequences, namely, $P_0$, $P_1$, $P_2$, ..., $P_{t-1}$. A total of t $\times$ N bits in the t inner codewords are interleaved through the inner-code interleaving to obtain an interleaved sequence with a length of t $\times$ N bits, where the interleaved sequence includes two subsequences whose bits are consecutive, namely, a first subsequence with a length of t $\times$ K bits and a second subsequence with a length of t $\times$ S bits. The first subsequence whose bits are consecutive includes the t information sequences, namely, $B_0$, $B_1$, $B_2$, ..., $B_{t-1}$, and the second subsequence whose bits are consecutive includes the t parity sequences, namely, $P_0$, $P_1$, $P_2$, ..., $P_{t-1}$. For understanding, refer to FIG. 13. The foregoing codeword interleaving is also a specific implementation solution to the channel interleaving.

It should be noted that the inner-code encoding is performed on the t information sequences, namely, $B_0$, $B_1$, $B_2$, ..., $B_{t-1}$, with t $\times$ K bits, to obtain the t inner codewords, namely, $D_0$, $D_1$, $D_2$, ..., $D_{t-1}$, with t $\times$ N bits, and then the inner codeword interleaving is performed to obtain interleaved sequences, namely, $B_0$, $B_1$, $B_2$, ..., $B_{t-1}$, $P_0$, $P_1$, $P_2$, ..., $P_{t-1}$, with t $\times$ N bits. In some possible scenarios, the foregoing inner-code (N,K) encoding and interleaving of the t inner codewords are jointly referred to as an inner-code (t $\times$ N, t $\times$ K) encoding. A person of ordinary skill in the art may distinguish the (N,K) encoding and the (t $\times$ N, t $\times$ K) encoding based on the context, and details are not described herein again.

It should be noted that, the foregoing t codewords, namely, $D_0$, $D_1$, $D_2$, ..., $D_{t-1}$, on which the inner codeword interleaving is performed are obtained by performing inner-code encoding on t $\times$ K bits in a same second data stream, or may be obtained by performing inner-code encoding on t $\times$ K bits in a plurality of second data streams. For example, t/2 inner codewords are obtained by performing inner-code encoding on t/2 $\times$ K bits in one second data stream, and the other t/2 inner codewords are obtained by performing inner-code encoding on t/2 $\times$ K bits in another second data stream. A specific implementation is known to a person of ordinary skill in the art, and details are not described herein.

Implementation 3: A FEC code with an information length of K=120 bits and a codeword length of N=128 bits is used for the inner-code encoding.

It is considered that the inner code is the FEC code, for example, a Hamming(128,120) code, with an information length of K=120 bits and a codeword length of N=128 bits. For another example, to-be-encoded 120-bit data is represented by B[119:0], bitwise exclusive OR is performed on every two consecutive bits of the 120-bit data to obtain one-bit data C[i], and 60-bit data is obtained in total, and is represented by C[59:0]. C[i]=B[2*i]^B[2*i+1], where $0 \leq i \leq 59$. Then, Hamming(68,60) encoding is performed on C[59:0] as information data to obtain eight-bit parity data that is represented by P[7:0]. Finally, 128 bits of B[119:0] and P[7:0] in total are concatenated into an output of the inner-code encoding, where the output is represented by D[127:0]. D[119:0] is from B[119:0], and D[127:120] is from P[7:0].

Considering the 800GE scenario and that the PAM4 modulation is applied, four PAM modulated symbol streams are obtained through data processing. When the periodically inserted first marker with a length of $\tilde{W}$ bits is not considered, a baud rate of the PAM4 modulated symbol stream is $\dfrac{850}{2 \times 4} \times \dfrac{N}{K}$ Gbaud $\approx 113.3333$ Gbaud, and the value of the baud rate is approximately 725.3333 times the value of the reference clock frequency (156.25M). Considering that 725.3333 is not an integer, and a minimum positive integer greater than 725.3333 is 726, when the first marker with a length of $\tilde{W}$ bits inserted into every $\tilde{P}$ bits is considered, a baud rate of the PAM4 modulated symbol stream is 113.4375 Gbaud, and the value of the baud rate is 726 times the value of the reference clock frequency (156.25M).

Considering that in the 800GbE scenario, the baud rate of the PAM4 modulated symbol stream is

$$\frac{850}{2\times4} \times \frac{128}{120} \times \frac{\tilde{W}+\tilde{P}}{\tilde{P}}$$ Gbaud, $$\frac{850}{2\times4} \times \frac{128}{120} \times \frac{\tilde{W}+\tilde{P}}{\tilde{P}} = 113.4375$$ . In this case, $\tilde{P} = 1088 \times \tilde{W}$. Considering that $\tilde{P}$ and $\tilde{W}$ are integer multiples of the inner code information length K, the receiver performs the frame synchronization and inner codeword synchronization operations with low complexity. Typically, $\tilde{W} = 120$, and $\tilde{P} = 1088 \times \tilde{W} = 130560$.

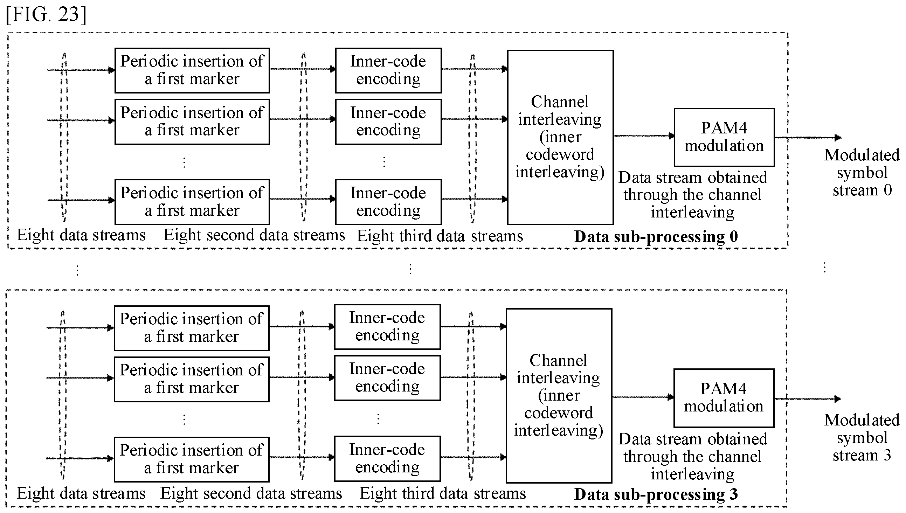

FIG. 23 is a diagram of another implementation of data processing according to an embodiment of this application. With reference to FIG. 23, the following describes a specific data processing procedure.

The first marker is periodically inserted into each of m=32 data streams obtained through first FEC encoding, to obtain a total of m=32 second data streams. Specifically, $\tilde{P}$ bits are periodically obtained from each data stream, and the first marker with a length of $\tilde{W}$ bits is inserted, so that the first marker with a length of $\tilde{W}$ bits exists in every $\tilde{P}+\tilde{W}$ bits in each of the second data streams.

Inner-code encoding is performed on each data stream in the m=32 second data streams to obtain m=32 third data streams. Specifically, the inner-code encoding is performed on every K=120 information bits in each of the second data streams, to be specific, S=8 parity bits are added to obtain an inner codeword with a total of N=128 bits.

Third data processing including PAM4 modulation is performed on every $n_{HM} = 8$ third data stream in the m=32 third data streams to obtain a total of $Y = m/n_{HM} = 4$ modulated symbol streams. More specifically, channel interleaving is first performed on every eight third data streams in the 32 third data streams to obtain one channel interleaved data stream, to obtain a total of four channel interleaved data streams. Refer to FIG. 23. In the 800GE scenario, the data processing includes four pieces of data sub-processing, namely, data sub-processing 0, data sub-processing 1, data sub-processing 2, and data sub-processing 3 in FIG. 23. Each piece of data sub-processing includes one channel interleaving operation. One inner codeword with a length of 128 bits is obtained through the channel interleaving from each of the eight input third data streams, to obtain a total of eight inner codewords, and two bits are obtained, as bits in the channel interleaved data stream, from each inner codeword in a round-robin (Round-Robin) fashion, to obtain 1024 consecutive bits in the channel interleaved data stream. The channel interleaving is also referred to as eight-way Hamming codeword interleaving (eight-way Hamming codeword interleaving), or referred to as inner codeword interleaving. Then, the PAM4 modulation is performed on the four channel interleaved data streams, to obtain Y=4 modulated symbol streams.

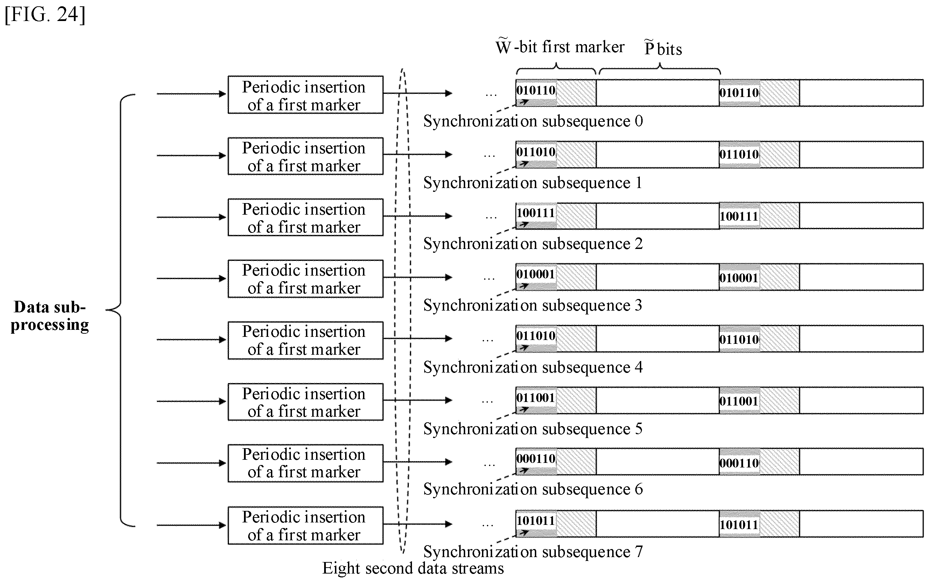

FIG. 24 is a diagram of a structure of a first marker according to an embodiment of this application. In this embodiment, a specific structure of the periodically inserted first marker with a length of $\tilde{W}$=120 bits is described by using $\tilde{W}$ = 120 and $\tilde{P} = 1088 \times \tilde{W} = 130560$ as an example. As shown in FIG. 24, the $\tilde{W}$-bit first marker is periodically inserted into each of m=32 data streams obtained through first FEC encoding, to obtain a total of m=32 second data streams. The $\tilde{W}$-bit first marker includes a synchronization subsequence with a bit length of $\tilde{W}_s$. A total of $8 \times \tilde{W}_s$ bits in a combination of synchronization subsequences, namely, a synchronization subsequence 0, a synchronization subsequence 1, ..., a synchronization subsequence 7 in FIG. 24, included in eight first markers in eight second data streams corresponding to each piece of data sub-processing may be for the receiver to perform frame synchronization.

In some specific applications, the $\tilde{W}_s$-bit synchronization subsequence is first $\tilde{W}_s$ consecutive bits in the $\tilde{W}$-bit first marker of the second data stream. As shown in FIG. 24, $\tilde{W}_s = 6$ is used as an example in this embodiment for description. Specific bit patterns of the eight synchronization subsequences are enumerated in Table 14.

Table 14

| Specific value of each bit | Bits in the $\tilde{W}$-bit first marker | | | | | |
| --- | --- | --- | --- | --- | --- | --- |
| | 0th bit | 1st bit | 2nd bit | 3rd bit | 4th bit | 5th bit |
| Synchronization subsequence 0 | 0 | 1 | 0 | 1 | 1 | 0 |
| Synchronization subsequence 1 | 0 | 1 | 1 | 0 | 1 | 0 |
| Synchronization subsequence 2 | 1 | 0 | 0 | 1 | 1 | 1 |
| Synchronization subsequence 3 | 0 | 1 | 0 | 0 | 0 | 1 |
| Synchronization subsequence 4 | 0 | 1 | 1 | 0 | 1 | 0 |
| Synchronization subsequence 5 | 0 | 1 | 1 | 0 | 0 | 1 |
| Synchronization subsequence 6 | 0 | 0 | 0 | 1 | 1 | 0 |

(continued)

| Specific value of each bit | Bits in the W̃-bit first marker | | | | | |
|---|---|---|---|---|---|---|
| | 0th bit | 1st bit | 2nd bit | 3rd bit | 4th bit | 5th bit |
| Synchronization subsequence 7 | 1 | 0 | 1 | 0 | 1 | 1 |

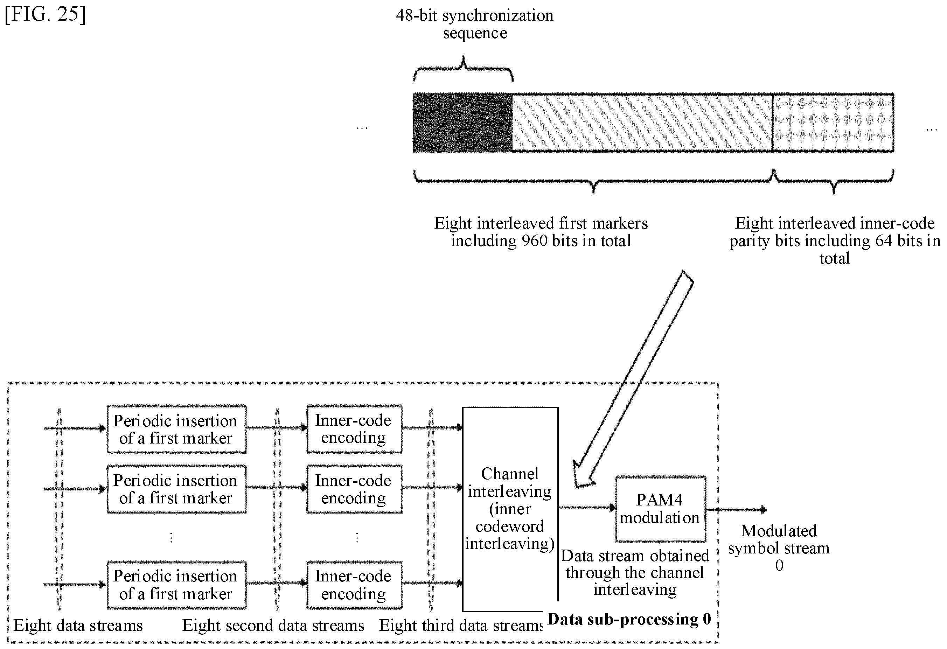

FIG. 25 is a diagram of a structure of a channel interleaved synchronization sequence according to an embodiment of this application. It should be noted that the specific bit patterns of the eight synchronization subsequences are not completely the same. Refer to FIG. 25. Through inner-code encoding and inner codeword interleaving, a total of $8 \times \tilde{W}_s = 48$ bits in the eight synchronization subsequences are consecutive in a channel interleaved data stream, and a specific bit pattern of the 48 bits is 010110010101001001100100101001101010110110011011 (transmitted from left to right). The 48 bits may be for the receiver to perform frame synchronization, and are also referred to as a frame synchronization sequence, referred to as a synchronization sequence for short. A leftmost bit in the bit pattern herein is first sent in actual transmission. The synchronization sequence with the 48 consecutive bits in the corresponding channel interleaved data stream may be represented in hexadecimal notation by 0x9A, 0x4A, 0x26, 0x65, 0xB5, and 0xD9 (where an LSB in eight bits in one byte is transmitted first). It should be noted that, although the specific bit patterns of the eight synchronization subsequences are not completely the same, specific bit patterns of four synchronization sequences corresponding to the four channel interleaved data streams are the same, and are all 0x9A, 0x4A, 0x26, 0x65, 0xB5, and 0xD9.

Implementation 4

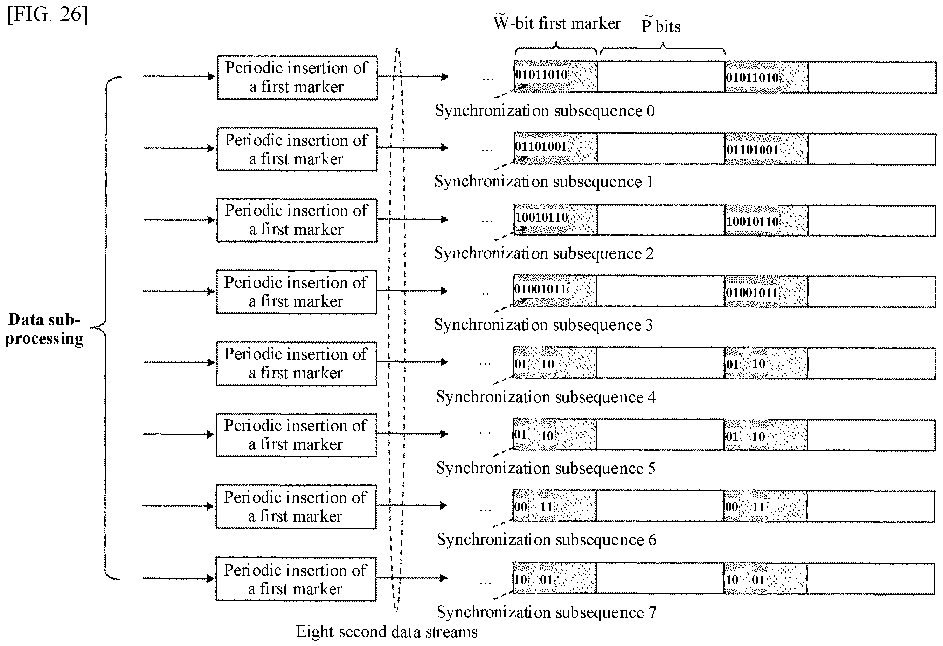

FIG. 26 is another diagram of a structure of a first marker according to an embodiment of this application. Based on the implementation 3, the W̃-bit first marker is periodically inserted into each of the m=32 data streams obtained through the first FEC encoding, to obtain a total of the m=32 second data streams. Lengths of synchronization subsequences included in first markers periodically inserted into the m=32 second data stream are not completely equal. FIG. 26 shows specific structures of eight synchronization subsequences in each piece of data sub-processing.

Specific bit patterns of the eight synchronization subsequences are enumerated in Table 15. Lengths of the eight synchronization subsequences are not completely the same. Bit lengths of a synchronization subsequence 0, a synchronization subsequence 1, a synchronization subsequence 2, and a synchronization subsequence 3 are 8, and bit lengths of a synchronization subsequence 4, a synchronization subsequence 5, a synchronization subsequence 6, and a synchronization subsequence 7 are 4.

Table 15

| Specific value of each bit | Bit length | Bits in the W̃-bit first marker | | | | | | | |
|---|---|---|---|---|---|---|---|---|---|
| | | 0th bit | 1st bit | 2nd bit | 3rd bit | 4th bit | 5th bit | 6th bit | 7th bit |
| Synchronization subsequence 0 | 8 | 0 | 1 | 0 | 1 | 1 | 0 | 1 | 0 |
| Synchronization subsequence 1 | 8 | 0 | 1 | 1 | 0 | 1 | 0 | 0 | 1 |
| Synchronization subsequence 2 | 8 | 1 | 0 | 0 | 1 | 0 | 1 | 1 | 0 |
| Synchronization subsequence 3 | 8 | 0 | 1 | 0 | 0 | 1 | 0 | 1 | 1 |
| Synchronization subsequence 4 | 4 | 0 | 1 | | | 1 | 0 | | |
| Synchronization subsequence 5 | 4 | 0 | 1 | | | 1 | 0 | | |
| Synchronization subsequence 6 | 4 | 0 | 0 | | | 1 | 1 | | |
| Synchronization subsequence 7 | 4 | 1 | 0 | | | 0 | 1 | | |

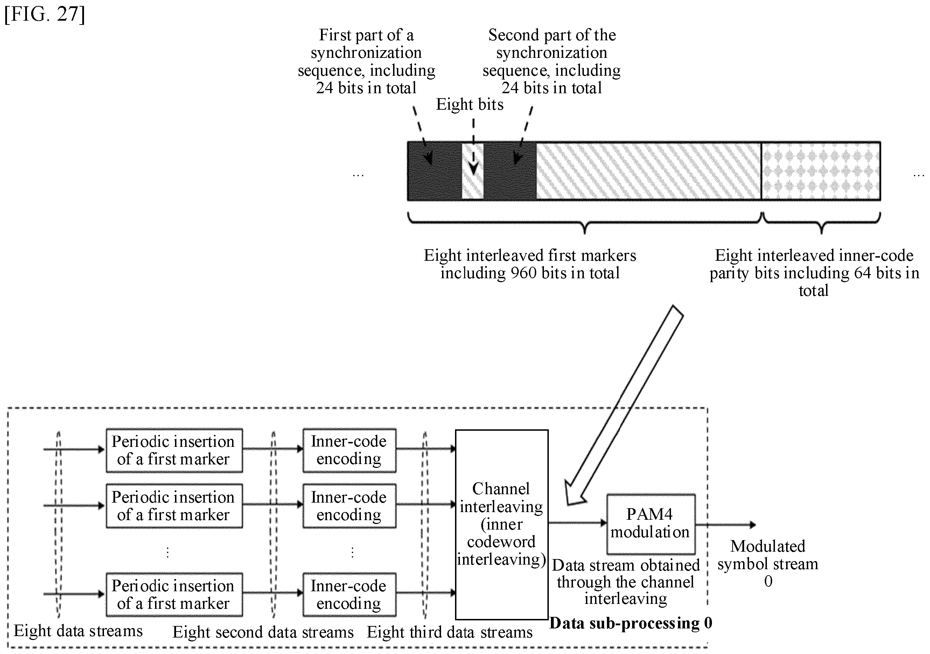

FIG. 27 is another diagram of a structure of a channel interleaved synchronization sequence according to an embodiment of this application. Refer to FIG. 27. Through inner-code encoding and inner codeword interleaving, a total of 48 bits in the eight synchronization subsequences correspond to 48 bits in a corresponding channel interleaved data stream. The 48 bits may be for the receiver to perform frame synchronization, and are also referred to as a frame synchronization sequence, referred to as a synchronization sequence for short. The 48-bit synchronization sequence is not completely consecutively arranged in the channel interleaved data stream, and includes two bit sequence parts, where a first bit sequence part includes 24 bits, and a second bit sequence part includes 24 bits. The first bit sequence part and the second bit sequence part are separated by eight bits (namely, one byte). Herein, an interval between two consecutive bits is defined as zero bits.

In some specific applications, specific values of the 24-bit first bit sequence part are 01011001 01010010 01100100 (transmitted from left to right), and specific values of the 24-bit second bit sequence part are 10100110 10101101 10011011 (transmitted from left to right). A leftmost bit in the bit pattern herein is first sent in actual transmission. Both the first bit sequence part and the second bit sequence part may be represented in hexadecimal notation. The first bit sequence part is 0x9A, 0x4A, and 0x26, and the second bit sequence part is 0x65, 0xB5, and 0xD9. It should be noted that, specific bit patterns of four synchronization sequences corresponding to the four channel interleaved data streams are the same, and are all 0x9A, 0x4A, 0x26, 0x65, 0xB5, and 0xD9.

It should be noted that, in the 48-bit synchronization sequence, the first bit sequence part includes 24 bits, the second bit sequence part includes 24 bits, and the first bit sequence part and the second bit sequence part are separated by eight bits (one byte). Refer to FIG. 16. It can be learned that, according to the data processing method in this embodiment, a synchronization hardware implementation architecture in existing 100GE 802.3bj and 400GE 802.3bs standards may be reused for a related calculator architecture for the receiver to perform synchronization, to facilitate implementation.

Implementation 5

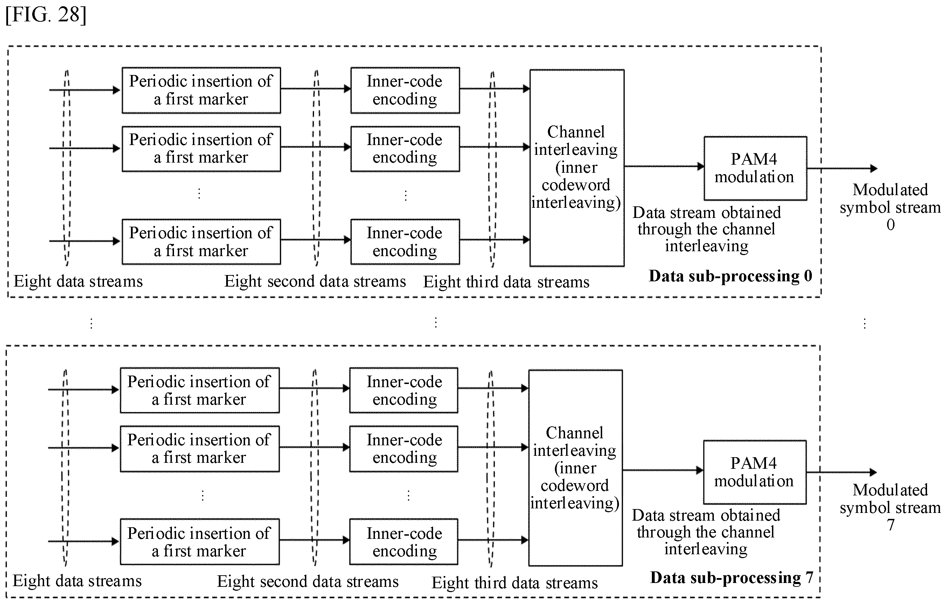

FIG. 28 is a diagram of another implementation of data processing according to an embodiment of this application. Based on the implementation 3, considering the 1.6TE scenario and that the PAM4 modulation is applied, eight PAM modulated symbol streams are obtained through the data processing. When the periodically inserted first marker with a length of $\tilde{W}$ bits is not considered, a baud rate of the PAM4 modulated symbol stream is $\frac{1700}{2\times8} \times \frac{N}{K}$ Gbaud $\approx 113.3333$ Gbaud, and the value of the baud rate is approximately 725.3333 times the value of the reference clock frequency (156.25M). Considering that 725.3333 is not an integer, and a minimum positive integer greater than 725.3333 is 726, when the periodically inserted first marker with a length of $\tilde{W}$ is considered, a baud rate of the PAM4 modulated symbol stream is 113.4375 Gbaud, and the value of the baud rate is 726 times the value of the reference clock frequency (156.25M).

Considering that in the 1.6TE scenario, the baud rate of the PAM4 modulated symbol stream is $\frac{1700}{2\times8} \times \frac{128}{120} \times \frac{\tilde{W}+\tilde{P}}{\tilde{P}}$ Gbaud, $\frac{1700}{2\times8} \times \frac{128}{120} \times \frac{\tilde{W}+\tilde{P}}{\tilde{P}} = 113.4375$. In this case, $\tilde{P} = 1088 \times \tilde{W}$. Considering that $\tilde{P}$ and $\tilde{W}$ are integer multiples of the inner code information length K, the receiver performs the frame synchronization and inner codeword synchronization operations with low complexity. Typically, $\tilde{W} = 120$, and $\tilde{P} = 1088 \times \tilde{W} = 130560$. For a specific data processing procedure, refer to FIG. 28 for understanding. The data processing includes eight pieces of data sub-processing, namely, data sub-processing 0 to data sub-processing 7. For a specific operation of each piece of data sub-processing, refer to the implementation 3 for understanding.

Implementation 6

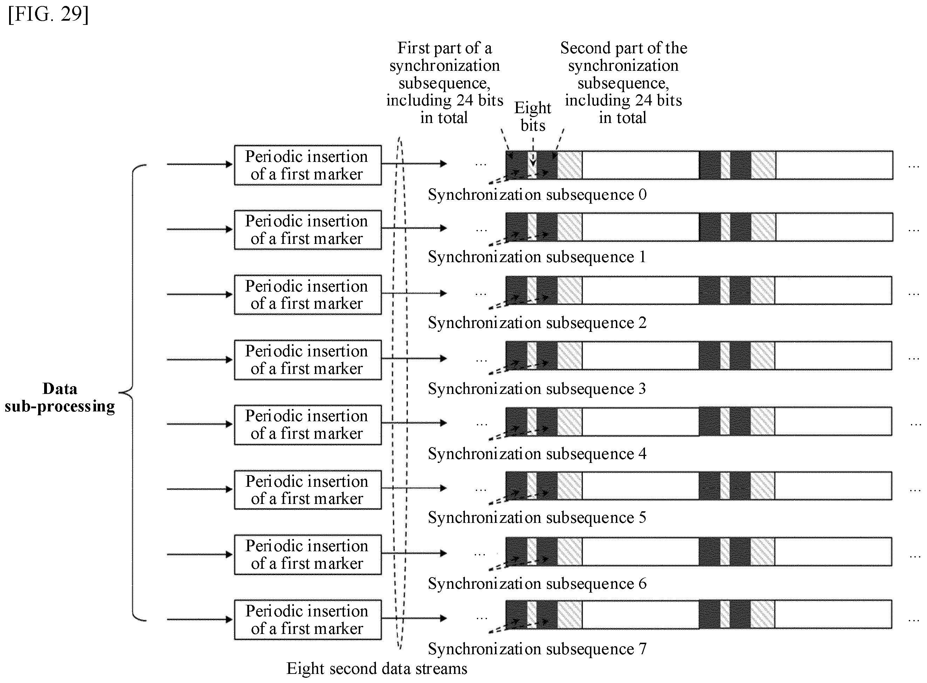

FIG. 29 is another diagram of a structure of a first marker according to an embodiment of this application. Based on the implementation 3, the $\tilde{W}$-bit first marker is periodically inserted into each of the m=32 data streams obtained through the first FEC encoding, to obtain a total of the m=32 second data streams. As shown in FIG. 29, the $\tilde{W}$-bit first marker of each of the second data streams includes a synchronization subsequence with a bit length of $\tilde{W}_s$. $\tilde{W}$-bit first markers in eight second data streams corresponding to each piece of data sub-processing include synchronization subsequences, namely, a synchronization subsequence 0, a synchronization subsequence 1, ..., a synchronization subsequence 7 in FIG. 29, with a bit length of $\tilde{W}_s$. Specific bit patterns of the eight synchronization subsequences are the same. It should be noted that, based on the implementation 6, the channel interleaving operation does not necessarily need to be performed in the data processing process, in other words, the implementation 6 is decoupled from the channel interleaving operation.

More specifically, a bit length of each synchronization subsequence is $\tilde{W}_s = 48$, and the synchronization subsequence is not completely consecutively arranged in the first marker. Each synchronization subsequence includes two bit sequence parts, a first bit sequence part includes 24 bits, a second bit sequence part includes 24 bits, and the first bit sequence part and the second bit sequence part are separated by eight bits. Herein, an interval between two consecutive bits is defined as zero bits.

In some specific applications, specific values of the first bit sequence part with a length of 24 bits are 0x9A, 0x4A, and 0x26, and specific values of the second bit sequence part with a length of 24 bits are 0x65, 0xB5, and 0xD9.

In some specific applications, according to the specific data processing solution of the present invention, the receiver may perform frame synchronization based on a total of 384 bits of the eight synchronization subsequences, in other words, the receiver performs frame synchronization based on a received data stream at a rate of approximately 200G per second. In some other specific applications, the receiver may first perform channel de-interleaving on the received data stream at the rate of approximately 200G according to a channel interleaving rule to obtain eight channel de-interleaved data streams, where each channel de-interleaved data stream has a rate of approximately 25G. Then, the receiver performs, based on the known synchronization subsequence, synchronization on each channel de-interleaved data stream. It should be noted that, when the receiver applies the foregoing synchronization solution that is based on the rate of 25G, the eight channel de-interleaved data streams are not completely aligned, and an order of each channel de-interleaved data stream in the eight channel de-interleaved data streams may be determined based on a position of a synchronized synchronization subsequence of each channel de-interleaving data stream, to correctly recover the order of the data stream and implement synchronization alignment.

Implementation 7

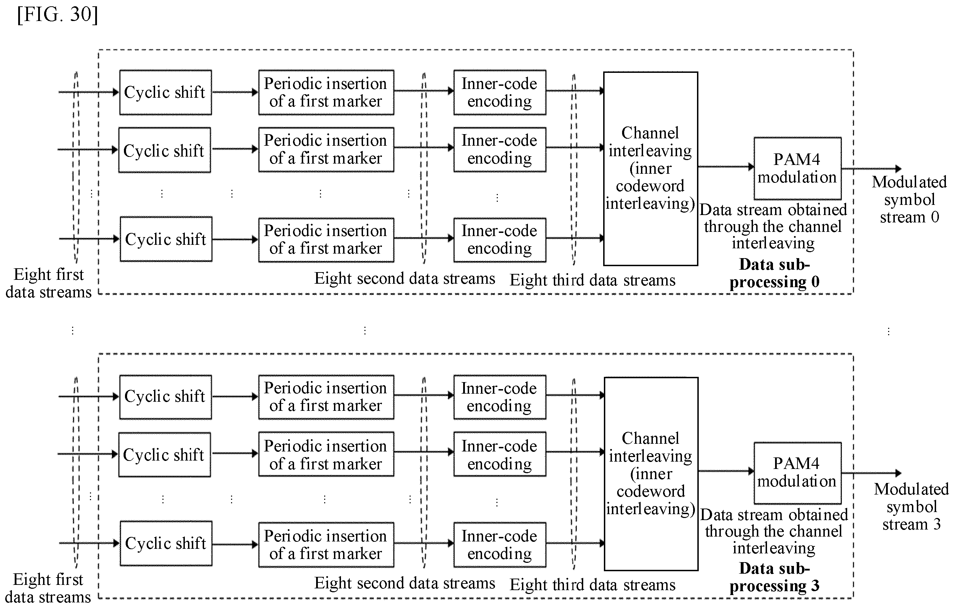

FIG. 30 is a diagram of another implementation of data processing according to an embodiment of this application. Based on the implementation 3, before the $\tilde{W}$-bit first marker is periodically inserted, a cyclic shift operation is further performed on data in the data stream. As shown in FIG. 30, in the cyclic shift operation, right cyclic shift is performed on every K=120 bits, to improve anti-burst performance of a whole concatenated code.

Implementation 8

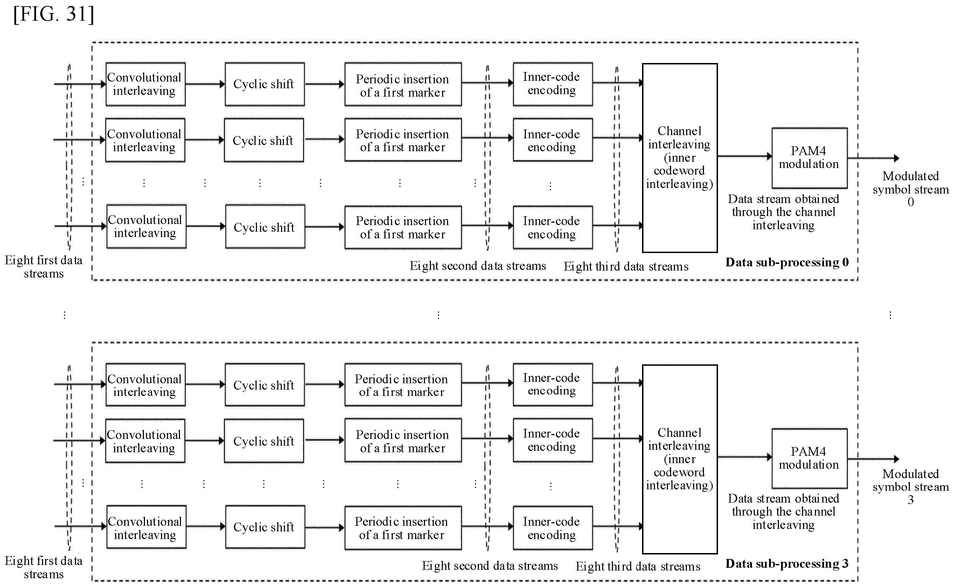

FIG. 31 is a diagram of another implementation of data processing according to an embodiment of this application. Based on the implementation 3, before the $\tilde{W}$-bit first marker is periodically inserted, a convolutional interleaving operation is further performed on data in the data stream. As shown in FIG. 31, the convolutional interleaving is first performed on every eight first data streams in the 32 first data streams separately to obtain eight convolutional interleaved data streams, cyclic shift is performed on every K=120 bits, the first marker is periodically inserted to obtain eight second data streams, inner-code encoding is performed to obtain eight third data streams, and then channel interleaving (inner codeword interleaving) is performed to obtain one channel interleaved data stream. The convolutional interleaving is further performed before the inner-code encoding, so that performance of a whole concatenated code in AWGN is improved.

Implementation 9

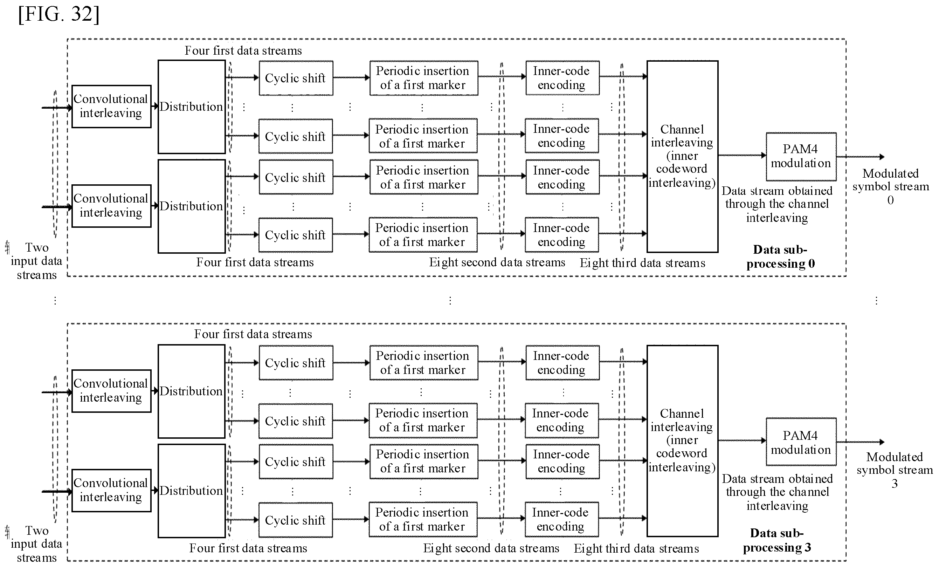

FIG. 32 is a diagram of another implementation of data processing according to an embodiment of this application. Based on the implementation 8, in each piece of data sub-processing, the convolutional interleaving is separately performed on two input data streams to obtain two convolutional interleaved data streams. Data distribution (distribution) is performed on each convolutional interleaved data stream, to obtain four distributed first data streams, and eight distributed first data streams are obtained in total. The data distribution is performed at a granularity of $\alpha_0$ bits. As shown in FIG. 32, when $\alpha_0$ bits in the convolutional interleaved data stream are grouped together, for four groups of $4 \times \alpha_0$ consecutive bits in total, a $0^{th}$ group of $\alpha_0$ bits is sent to a $0^{th}$ data stream in the four distributed first data streams, a $1^{st}$ group of $\alpha_0$ bits is sent to a $1^{st}$ data stream in the four distributed first data streams, a $2^{nd}$ group of $\alpha_0$ bits is sent to a $2^{nd}$ data stream in the four distributed first data streams, and a $3^{rd}$ group of $\alpha_0$ bits is sent to a $3^{rd}$ data stream in the four distributed first data streams. Typically, the distribution bit granularity is $\alpha_0$ = 120.

It should be noted that, in the 800GE scenario, the data processing includes four pieces of data sub-processing, as shown in FIG. 32. Each piece of data sub-processing corresponds to two input data streams. The two input data streams correspond to a rate of approximately 200G bits per second, in other words, each input data stream corresponds to a rate of approximately 100G bits per second. Correspondingly, the distributed first data stream corresponds to a rate of approximately 25G bits per second.

It should be further noted that when the distribution bit granularity is $\alpha_0$ = 120, the data processing shown in FIG. 32 may be described as: The convolutional interleaving is separately performed on the two input data streams, to obtain a total of two convolutional interleaved data streams. Four bit groups are obtained from each convolutional interleaved data stream, and a length of each bit group is 120 bits. The cyclic shift and the inner-code encoding are separately performed on each bit group to obtain four inner codewords. A total of eight bit groups are obtained from the two convolutional interleaved data streams, a total of eight inner codewords are obtained separately through the cyclic shift and the inner-code encoding, and then the channel interleaving is performed to obtain 1024 bits in the channel interleaved data stream.

It should be noted that, in the 1.6TE scenario, the data processing includes eight pieces of data sub-processing, and each piece of data sub-processing corresponds to two input data streams. The two input data streams correspond to a rate of approximately 200G bits per second, in other words, each input data stream corresponds to a rate of approximately 100G bits per second. Correspondingly, the distributed first data stream corresponds to a rate of approximately 25G bits per second.

Implementation 10

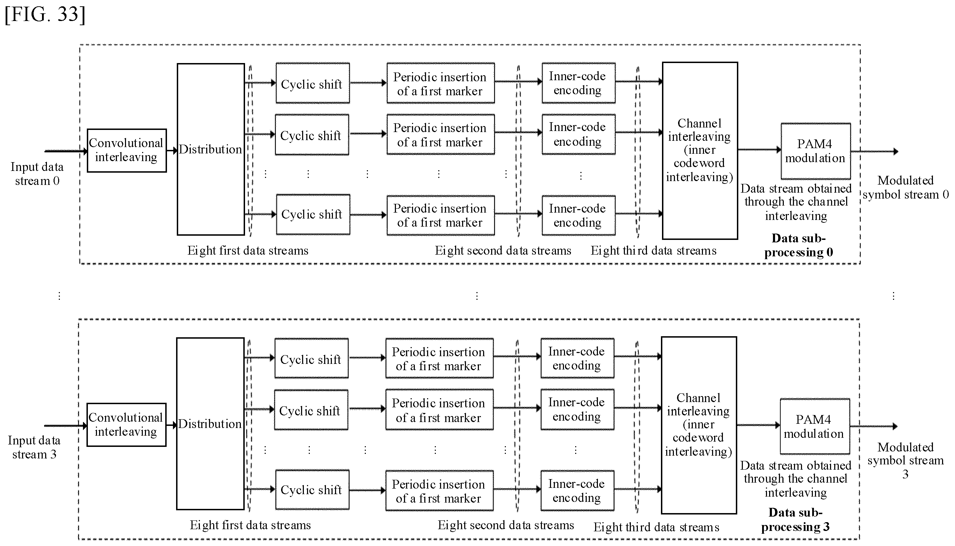

FIG. 33 is a diagram of another implementation of data processing according to an embodiment of this application. Based on the implementation 8, the data processing includes four input data streams, and each piece of data sub-processing includes one input data stream. The convolutional interleaving is performed on each input data stream to obtain one convolutional interleaved data stream. Data distribution (distribution) is performed on the convolutional interleaved data stream, to obtain eight distributed first data streams. The data distribution is performed at a granularity of $\alpha_0$ bits. As shown in FIG. 33, when $\alpha_0$ bits in the convolutional interleaved first data stream are grouped together, for eight groups of consecutive $8 \times \alpha_0$ bits in total, a $0^{th}$ group of $\alpha_0$ bits is sent to a $0^{th}$ data stream in the eight distributed first data streams, a $1^{st}$ group of $\alpha_0$ bits is sent to a $1^{st}$ data stream in the eight distributed first data streams, ..., and a $7^{th}$ group of $\alpha_0$ bits is sent to a $7^{th}$ data stream in the eight distributed first data streams. Typically, the distribution bit granularity is $\alpha_0$ = 120.

It should be noted that, in the 800GE scenario, the data processing includes four pieces of data sub-processing, as shown in FIG. 33. A data stream input of each piece of data sub-processing is one data stream, and the data stream corresponds to a rate of approximately 200G bits per second. Correspondingly, the distributed first data stream corresponds to a rate of approximately 25G bits per second.

It should be noted that, in the 1.6TE scenario, the data processing includes eight pieces of data sub-processing, a data stream input of each piece of data sub-processing is one data stream, and the data stream corresponds to a rate of approximately 200G bits per second. Correspondingly, the distributed first data stream corresponds to a rate of approximately 25G bits per second.

It should be noted that, as shown in FIG. 32, the convolutional interleaving and the distribution are performed on the input data stream to obtain four first data streams; and as shown in FIG. 33, the convolutional interleaving and the distribution are performed on the input data stream to obtain eight first data streams. Both may be understood as that each first data stream is obtained through the convolutional interleaving.

It should be noted that, in the implementation 3 to the implementation 10, each of the eight second data streams includes the periodically inserted $\tilde{W}$-bit first marker, and a total length is $8 \times \tilde{W}$ bits. A part of the $8 \times \tilde{W}$ bits are for the receiver to perform frame synchronization, in other words, are used as the foregoing frame synchronization sequence. Remaining bits may be for transferring link information and/or control information, includes a receiver status, a FEC status, and the like, and is also referred to as a status field (status field). Specifically, to improve accuracy of the transferred link information and/or control information, in the remaining bits other than the foregoing frame synchronization sequence in the $8 \times \tilde{W}$ bits, $\overline{W}_1$ bits indicate a type of the link information and/or a type of the control information, $\overline{W}_2$ bits indicate specific content of the link information and/or control information, and $\overline{W}_3$ bits are for cyclic redundancy check (Cyclic Redundancy Check, CRC). Typically, $\overline{W}_1$ = 8, and a value of $\overline{W}_3$ is 8, 16, or 32. In some other specific applications, the indicated link information and/or control information needs to be transferred in a coordinated manner by using a plurality of frames, to further improve the accuracy of the transferred information. In this case, $\overline{W}_4$ bits in the $8 \times \tilde{W}$ bits indicate the plurality of frames, and the $\overline{W}_4$ bits are also referred to as a multi-frame synchronization signal. Typically, $\overline{W}_4$ = 8.

In some specific applications, as shown in FIG. 26, a total of 48 bits in eight synchronization subsequences are used as the frame synchronization sequence, and are distributed in eight second data streams, where each of the second data streams in four second data streams includes eight bits (namely, synchronization subsequences 0 to 3) in the frame synchronization sequence, and each of the second data streams in the other four second data streams includes four bits (namely, synchronization subsequences 4 to 7) in the frame synchronization sequence. Four bits in each synchronization subsequence in the synchronization subsequences 4 to 7 are a $0^{th}$ bit, a $1^{st}$ bit, a $4^{th}$ bit, and a $5^{th}$ bit in the $\tilde{W}$-bit first marker (namely, a first marker 4, a first marker 5, a first marker 6, and a first marker 7). For understanding, refer to Table 15. There are a total of 16 bits including $2^{nd}$, $3^{rd}$, $6^{th}$ and $7^{th}$ bits in the first marker 4, the first marker 5, the first marker 6, and the first marker 7, where eight bits are used as eight bits for the CRC8 check, eight bits indicating the type of the link information and/or the control information, or eight bits for the multi-frame synchronization signal.

It should be noted that, according to the data processing method applied to the transmitter shown in FIG. 7, correspondingly, a data processing method applied to a receiver includes the following steps. First, fourth data processing is performed on received Y modulated symbol streams to obtain m fourth data streams. For a feature of the modulated symbol stream and a manner of generating the modulated symbol stream, refer to the related descriptions in the embodiment shown in FIG. 7. Details are not described herein again. The fourth data processing including demodulation is performed on the Y modulated symbol streams to obtain the m fourth data streams, where the fourth data processing performed by the receiver is an inverse operation of the third data processing performed by the transmitter. Then, frame synchronization is performed on each of the fourth data streams. It should be understood that the receiver performs alignment marker lock based on the marker added by the transmitter to the data stream, to determine a boundary (boundary) of each frame (P+W bits) in the fourth data stream, so that codeword synchronization and/or the frame synchronization are/is implemented.

It should be understood that, after completing the codeword synchronization and/or the frame synchronization, the receiver further performs fifth data processing on the m fourth data streams. The fifth data processing may be understood as an inverse operation of the second data processing performed by the transmitter. For example, the fifth data processing includes but is not limited to inner-code decoding and concatenated de-interleaving, where the concatenated de-interleaving includes convolutional de-interleaving. Details are not described herein one by one again.

The following describes a data processing apparatus provided in embodiments of this application.

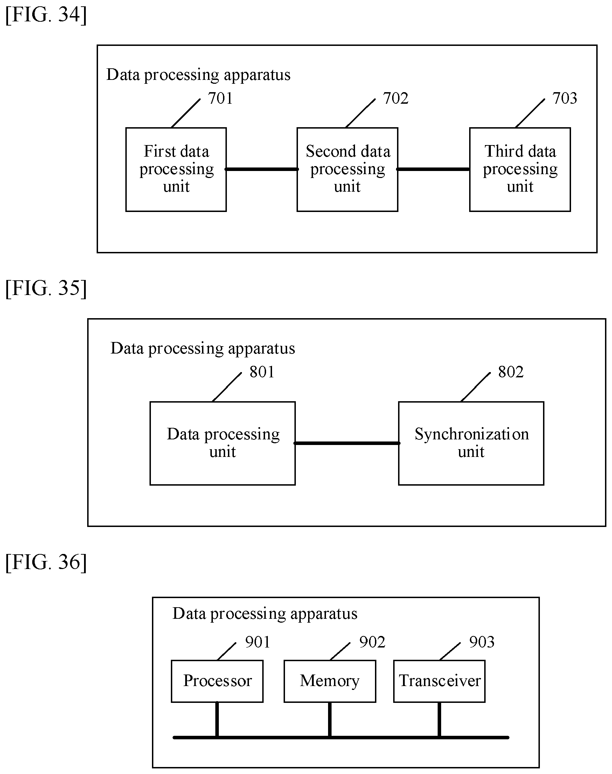

FIG. 34 is a diagram of a structure of a data processing apparatus used in a transmitter according to an embodiment of this application. As shown in FIG. 34, the data processing apparatus includes a first data processing unit 701, a second data processing unit 702, and a third data processing unit 703. The first data processing unit 701 is configured to perform the operation in step 301 in the embodiment shown in FIG. 3 or the operation in step 401 in the embodiment shown in FIG. 7. The second data processing unit 702 is configured to perform the operation in step 302 in the embodiment shown in FIG. 3 or the operation in step 402 in the embodiment shown in FIG. 7. The third data processing unit 703 is configured to perform the operation in step 303 in the embodiment shown in FIG. 3 or the operation in step 403 in the embodiment shown in FIG. 7. For specific operations, refer to the related descriptions in the embodiments shown in FIG. 3 and FIG. 7. Details are not described herein again.

FIG. 35 is a diagram of a structure of a data processing apparatus used in a receiver according to an embodiment of this application. As shown in FIG. 35, the data processing apparatus includes a data processing unit 801 and a synchronization unit 802. The data processing unit 801 is configured to perform the operation in step 601 in the embodiment shown in FIG. 6. The synchronization unit 802 is configured to perform the operation in step 602 in the embodiment shown in FIG. 6. For specific operations, refer to the related descriptions in the embodiment shown in FIG. 6. Details are not described herein again.

It should be understood that the apparatus provided in this application may alternatively be implemented in another manner. For example, the division into the units in the foregoing apparatus is merely logical function division, and may be other division during actual implementation. For example, a plurality of units or components may be combined or integrated into another system. In addition, the functional units in embodiments of this application may be integrated into one processing unit, or may be independent physical units, or two or more functional units may be integrated into one processing unit. The integrated unit may be implemented in a form of hardware, or may be implemented in a form of a software functional unit.

FIG. 36 is another diagram of a structure of a data processing apparatus according to an embodiment of this application. As shown in FIG. 36, the data processing apparatus includes a processor 901, a memory 902, and a transceiver 903. The processor 901, the memory 902, and the transceiver 903 are interconnected through lines. The memory 902 is configured to store program instructions and data. Specifically, the processor 901 is configured to perform a data processing operation, and the transceiver 903 is configured to perform data receiving and sending operations. In a possible implementation, the processor 901 may include the first data processing unit 701, the second data processing unit 702, and the third data processing unit 703 shown in FIG. 34. In another possible implementation, the processor 901 may include the data processing unit 801 and the synchronization unit 802 shown in FIG. 35.

It should be noted that the processor shown in FIG. 36 may be a general-purpose central processing unit (Central Processing Unit, CPU), a general-purpose processor, a digital signal processor (DSP), an application-specific integrated circuit (ASIC), a field programmable gate array (FPGA) or another programmable logic device, a transistor logic device, a hardware component, or any combination thereof. The memory shown in FIG. 36 may store an operating system and another application program. When the technical solutions provided in embodiments of this application are implemented through software or firmware, program code used for implementing the technical solutions provided in embodiments of this application is stored in the memory and is executed by the processor. In an embodiment, the processor may include the memory inside. In another embodiment, the processor and the memory are two independent structures.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

A person of ordinary skill in the art may understand that all or some of the steps in the foregoing embodiments may be implemented through hardware or a program instructing related hardware. The program may be stored in a computer-readable storage medium. The storage medium above may be a read-only memory, a random access memory, or the like. Whether the functions are performed through hardware or software depends on particular applications and design constraints of the technical solutions. A person skilled in the art may use different methods to implement the described functions for each particular application, but it should not be considered that the implementation goes beyond the scope of this application.

When software is used to implement the functions, all or some of the method steps described in the foregoing embodiments may be implemented in a form of a computer program product. The computer program product includes one or more computer instructions. When the computer program instructions are loaded and executed on a computer, the procedures or functions according to embodiments of this application are all or partially generated. The computer may be a general-purpose computer, a special-purpose computer, a computer network, or other programmable apparatuses. The computer instructions may be stored in a computer-readable storage medium or may be sent from a computer-readable storage medium to another computer-readable storage medium. For example, the computer instructions may be sent from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible to the computer, or a data storage device, for example, a server or a data center, integrating one or more usable media. The usable medium may be a magnetic medium (for example, a floppy disk, a hard disk, or a magnetic tape), an optical medium (for example, DVD), a semiconductor medium (for example, a solid-state drive (Solid-State drive, SSD)), or the like.

**Claims**

1. A data processing method, comprising:

   performing first data processing on a plurality of first data streams obtained through first forward error correction FEC encoding, to obtain m second data streams, wherein m is an integer greater than 1; and second FEC encoding has been performed for each of the second data streams, and each codeword obtained through the second FEC encoding comprises N bits, wherein N=K+S, K represents a quantity of information bits, S represents a quantity of parity bits, K is an integer greater than or equal to 1, and S is an integer greater than or equal to 1; separately performing second data processing on the m second data streams to obtain m third data streams, wherein each of the third data streams comprises at least one bit sequence, each bit sequence comprises P+W bits, the P bits in each bit sequence are from the second data stream, and the W bits in each bit sequence are an added alignment marker, wherein P=N×b, and b is an integer greater than or equal to 1; and performing third data processing on the m third data streams to obtain Y modulated symbol streams, wherein Y is an integer greater than or equal to 1, modulation has been performed for each of the modulated symbol streams, and a value of a baud rate of each of the modulated symbol streams is an integer multiple of a value of a reference clock frequency.

2. The method according to claim 1, wherein the value of the baud rate of each of the modulated symbol streams is an integer multiple of 156.25M.

3. The method according to claim 1 or 2, wherein convolutional interleaving is performed for each of the second data streams before the second FEC encoding, and the convolutional interleaving comprises delaying an input data stream based on r delay lines, wherein r is an integer greater than 1; the delay lines comprise different quantities of storage units, a delay line with a smallest quantity of storage units comprises zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving comprise d bits output from each delay line, wherein Q is an integer greater than or equal to 1, and d is an integer greater than or equal to 1.

4. The method according to claim 3, wherein input and output switches corresponding to the convolutional interleaving are in a 0$^{\text{th}}$ delay line each time f bits are output through the convolutional interleaving, wherein K×b is exactly divisible by f.

5. The method according to claim 3 or 4, wherein r×d×c=K×b, and c is an integer greater than or equal to 1.

6. The method according to any one of claims 1 to 5, wherein a rate of the first data stream is 850 Gbps,

   $$\frac{850}{8} \times \frac{N}{K} \times \frac{P+W}{P} G = a \times 156.25M$$ , a is an integer greater than or equal to 1, G represents 10^9, and M represents 10^6.

7. The method according to claim 6, wherein N=128, K=120, and $a = \frac{2176}{3} \times \frac{P+W}{P}$ .

**8.** The method according to claim 7, wherein W=48, P=13056, a=728, b=102, and the baud rate=113.75 Gbaud;

W=48, P=52224, a=726, b=408, and the baud rate=113.4375 Gbaud;
W=56, P=15232, a=728, b=119, and the baud rate=113.75 Gbaud;
W=56, P=60928, a=726, b=476, and the baud rate=113.4375 Gbaud;
W=64, P=13056, a=728, b=102, and the baud rate=113.75 Gbaud;
W=64, P=69632, a=726, b=544, and the baud rate=113.4375 Gbaud;
W=120, P=32640, a=728, b=255, and the baud rate=113.75 Gbaud;
W=120, P=52224, a=727, b=408, and the baud rate=113.5938 Gbaud;
W=120, P=130560, a=726, b=1020, and the baud rate=113.4375 Gbaud;
W=128, P=34816, a=728, b=272, and the baud rate=113.75 Gbaud; or
W=128, P=139264, a=726, b=1088, and the baud rate=113.4375 Gbaud.

**9.** The method according to claim 6, wherein N=170, K=160, and $a = \dfrac{1445}{2} \times \dfrac{P+W}{P}$.

**10.** The method according to claim 9, wherein W=48, P=23120, a=724, b=136, and the baud rate=113.125 Gbaud;

W=48, P=69360, a=723, b=408, and the baud rate=112.9688 Gbaud;
W=56, P=11560, a=726, b=68, and the baud rate=113.4375 Gbaud;
W=56, P=80920, a=723, b=476, and the baud rate=112.9688 Gbaud;
W=64, P=92480, a=723, b=544, and the baud rate=112.9688 Gbaud;
W=120, P=34680, a=725, b=204, and the baud rate=113.2813 Gbaud;
W=120, P=57800, a=724, b=340, and the baud rate=113.125 Gbaud;
W=120, P=173400, a=723, b=1020, and the baud rate=112.9688 Gbaud;
W=170, P=49130, a=725, b=289, and the baud rate=113.2813 Gbaud; or
W=170, P=245650, a=723, b=1445, and the baud rate=112.9688 Gbaud.

**11.** The method according to claim 6, wherein N=144, K=136, and $a = 720 \times \dfrac{P+W}{P}$.

**12.** The method according to claim 11, wherein W=48, P=5760, a=726, b=40, and the baud rate=113.4375 Gbaud;

W=48, P=8640, a=724, b=60, and the baud rate=113.125 Gbaud;
W=48, P=11520, a=723, b=80, and the baud rate=112.9688 Gbaud;
W=48, P=17280, a=722, b=120, and the baud rate=112.8125 Gbaud;
W=48, P=34560, a=721, b=240, and the baud rate=112.6563 Gbaud;
W=56, P=5760, a=727, b=40, and the baud rate=113.5938 Gbaud;
W=56, P=20160, a=722, b=140, and the baud rate=112.8125 Gbaud;
W=56, P=40320, a=721, b=280, and the baud rate=112.6563 Gbaud;
W=64, P=5760, a=728, b=40, and the baud rate=113.75 Gbaud;
W=64, P=11520, a=724, b=80, and the baud rate=113.125 Gbaud;
W=64, P=23040, a=722, b=160, and the baud rate=112.8125 Gbaud;
W=64, P=46080, a=721, b=320, and the baud rate=112.6563 Gbaud;
W=120, P=14400, a=726, b=100, and the baud rate=113.4375 Gbaud;
W=120, P=17280, a=725, b=120, and the baud rate=113.2813 Gbaud;
W=120, P=28800, a=723, b=200, and the baud rate=112.9688 Gbaud;
W=120, P=43200, a=722, b=300, and the baud rate=112.8125 Gbaud;
W=120, P=86400, a=721, b=600, and the baud rate=112.6563 Gbaud;
W=144, P=11520, a=729, b=80, and the baud rate=113.9063 Gbaud;
W=144, P=17280, a=726, b=120, and the baud rate=113.4375 Gbaud;
W=144, P=25920, a=724, b=180, and the baud rate=113.125 Gbaud;
W=144, P=34560, a=723, b=240, and the baud rate=112.9688 Gbaud;
W=144, P=51840, a=723, b=360, and the baud rate=112.8125 Gbaud; or
W=144, P=103680, a=721, b=720, and the baud rate=112.6563 Gbaud.

**13.** The method according to claim 11, wherein W=56, P=5040, a=728, b=35, and the baud rate=113.75 Gbaud;

W=56, P=10080, a=724, b=70, and the baud rate=113.125 Gbaud;
W=56, P=20160, a=722, b=140, and the baud rate=112.8125 Gbaud; or
W=56, P=40320, a=721, b=280, and the baud rate=112.6563 Gbaud.

14. The method according to any one of claims 1 to 5, wherein N=148, K=140, W is a multiple of 4, and b is a multiple of 17.

15. The method according to any one of claims 1 to 5, wherein N=128, K=120, and the baud rate of the modulated symbol stream is 113.4375 Gbaud.

16. The method according to claim 15, wherein P = 1088 $\times$ W.

17. The method according to claim 1, 2, 3, 4, 5, 15, or 16, wherein the alignment marker comprises at least one frame synchronization sequence with a length of 48 bits.

18. The method according to claim 17, wherein the 48 bits of the frame synchronization sequence are consecutive in the alignment marker.

19. The method according to claim 18, wherein values of the 48 bits of the frame synchronization sequence comprise 0x9A, 0x4A, 0x26, 0x65, 0xB5, and 0xD9.

20. The method according to claim 17, wherein the frame synchronization sequence comprises two frame synchronization subsequences, a bit length of each of the frame synchronization subsequences is 24 bits, and the two frame synchronization subsequences are separated by eight bits in the alignment marker.

21. The method according to claim 20, wherein values of 24 bits of one of the two frame synchronization subsequences comprise 0x9A, 0x4A, and 0x26, and values of 24 bits of the other of the two frame synchronization subsequences comprise 0x65, 0xB5, and 0xD9.

22. The method according to any one of claims 1 to 21, wherein the alignment marker comprises a padding bit and/or a status field.

23. The method according to any one of claims 1 to 22, wherein W is exactly divisible by N.

24. The method according to any one of claims 1 to 23, wherein at least one of the

    following operations is performed for each of the second data streams before the second FEC encoding: alignment marker lock, lane de-skewing, and lane reordering; and/or
    at least one of the following operations is further performed for each of the second data streams after the second FEC encoding: channel interleaving and scrambling.

25. The method according to any one of claims 1 to 23, wherein the performing first data processing on a plurality of first data streams to obtain m second data streams comprises:

    separately performing second FEC encoding on each group of eight first data streams in the plurality of first data streams to obtain each group of eight encoded data streams; and
    performing channel interleaving on each group of eight encoded data streams to obtain one second data stream, to obtain the m second data streams.

26. The method according to claim 25, wherein N=128, K=120, and the performing channel interleaving on each group of eight encoded data streams to obtain one second data stream comprises:

    obtaining one inner codeword with a length of 128 bits from each encoded data stream in each group of eight encoded data streams, to obtain eight inner codewords in total; and
    obtaining two bits from each of the eight inner codewords in a round-robin fashion, to obtain 1024 consecutive bits in the second data stream.

27. The method according to any one of claims 1 to 26, wherein cyclic shift is performed for each of the second data streams before the second FEC encoding.

28. The method according to claim 27, wherein the performing first data processing on a plurality of first data streams comprises:

separately performing convolutional interleaving on $8\times m$ first data streams;
separately performing cyclic shift on $8\times m$ convolutional interleaved first data streams; and
separately performing second FEC encoding on $8\times m$ cyclic shifted first data streams.

29. The method according to claim 27, wherein the performing first data processing on a plurality of first data streams comprises:

separately performing convolutional interleaving on $2\times m$ first data streams;
distributing each convolutional interleaved first data stream, to obtain four distributed first data streams, so as to obtain $8\times m$ distributed first data streams in total;
separately performing cyclic shift on the $8\times m$ distributed first data streams; and
separately performing second FEC encoding on $8\times m$ cyclic shifted first data streams.

30. The method according to claim 27, wherein the performing first data processing on a plurality of first data streams comprises:

separately performing convolutional interleaving on m first data streams;
distributing each convolutional interleaved first data stream, to obtain eight distributed first data streams, so as to obtain $8\times m$ distributed first data streams in total;
separately performing cyclic shift on the $8\times m$ distributed first data streams; and
separately performing second FEC encoding on $8\times m$ cyclic shifted first data streams.

31. The method according to claim 1, 2, 6, 7, 8, 9, 10, 11, 12, 13, 14, 15, 16, 17, 18, 19, 20, 21, 22, or 23, wherein the performing first data processing on a plurality of first data streams to obtain m second data streams comprises:

distributing each of m first data streams to obtain eight distributed first data streams, so as to obtain $8\times m$ distributed first data streams in total;
separately performing second FEC encoding on the $8\times m$ distributed first data streams to obtain $8\times m$ encoded data streams; and
performing codeword merging on every eight encoded data streams in the $8\times m$ encoded data streams to obtain one second data stream, so as to obtain the m second data streams in total.

32. The method according to any one of claims 1 to 31, wherein the alignment marker comprises at least one target codeword, and the target codeword comprises N bits.

33. The method according to claim 32, wherein the target codeword is obtained by performing second FEC encoding on K-bit alignment marker information.

34. The method according to claim 32 or 33, wherein the alignment marker is obtained by performing codeword interleaving on a plurality of target codewords, or is obtained by performing codeword merging on a plurality of target codewords.

35. A data processing method, comprising:

performing fourth data processing on received Y modulated symbol streams to obtain m fourth data streams, wherein demodulation has been performed for each of the fourth data streams, the Y modulated symbol streams are obtained by performing third data processing on m third data streams, modulation has been performed for each of the modulated symbol streams, the m third data streams are obtained by separately performing second data processing on m second data streams,
and the m second data streams are obtained by performing first data processing on a plurality of first data streams obtained through first forward error correction FEC encoding, wherein Y is an integer greater than or equal to 1, and m is an integer greater than 1; second FEC encoding has been performed for each of the second data streams, and each codeword obtained through the second FEC encoding comprises N bits, wherein N=K+S, K represents a quantity of information bits, S represents a quantity of parity bits, K is an integer greater than or equal to 1, and S is an integer greater than or equal to 1; and each of the third data streams comprises at least one bit sequence, each bit sequence comprises P+W bits, the P bits in each bit sequence are from the second data stream, and the W bits in each bit sequence are an added alignment marker, wherein P=N×b, b is an integer greater than or equal to 1, and a value of a baud rate of each of the modulated symbol streams is an integer multiple of a value of a reference clock frequency; and

performing frame synchronization on each of the fourth data streams based on an alignment marker in each of the fourth data streams.

36. A data processing apparatus, comprising a first data processing unit, a second data

processing unit, and a third data processing unit, wherein
the first data processing unit is configured to perform first data processing on a plurality of first data streams obtained through first forward error correction FEC encoding, to obtain m second data streams, wherein m is an integer greater than 1; and second FEC encoding has been performed for each of the second data streams, and each codeword obtained through the second FEC encoding comprises N bits, wherein N=K+S, K represents a quantity of information bits, S represents a quantity of parity bits, K is an integer greater than or equal to 1, and S is an integer greater than or equal to 1;
the second data processing unit is configured to separately perform second data processing on the m second data streams to obtain m third data streams, wherein each of the third data streams comprises at least one bit sequence, each bit sequence comprises P+W bits, the P bits in each bit sequence are from the second data stream, and the W bits in each bit sequence are an added alignment marker, wherein P=N×b, and b is an integer greater than or equal to 1; and
the third data processing unit is configured to perform third data processing on the m third data streams to obtain Y modulated symbol streams, wherein Y is an integer greater than or equal to 1, modulation has been performed for each of the modulated symbol streams, and a value of a baud rate of each of the modulated symbol streams is an integer multiple of a value of a reference clock frequency.

37. The data processing apparatus according to claim 36, wherein the value of the baud rate of each of the modulated symbol streams is an integer multiple of 156.25M.

38. The data processing apparatus according to claim 36 or 37, wherein convolutional interleaving is performed for each of the second data streams before the second FEC encoding, and the convolutional interleaving comprises delaying an input data stream based on r delay lines, wherein r is an integer greater than 1; the delay lines comprise different quantities of storage units, a delay line with a smallest quantity of storage units comprises zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving comprise d bits output from each delay line, wherein Q is an integer greater than or equal to 1, and d is an integer greater than or equal to 1.

39. The data processing apparatus according to claim 38, wherein input and output switches corresponding to the convolutional interleaving are in a 0th delay line each time f bits are output through the convolutional interleaving, wherein K×b is exactly divisible by f.

40. The data processing apparatus according to claim 38 or 39, wherein r×d×c=K×b, and c is an integer greater than or equal to 1.

41. The data processing apparatus according to any one of claims 36 to 40, wherein a rate of the first data stream is 850 Gbps, $\frac{850}{8} \times \frac{N}{K} \times \frac{P+W}{P} G = a \times 156.25M$, a is an integer greater than or equal to 1, G represents 10^9, and M represents 10^6.

42. The data processing apparatus according to claim 41, wherein N=128, K=120, and $a = \frac{2176}{3} \times \frac{P+W}{P}$.

**43.** The data processing apparatus according to claim 42, wherein W=48, P=13056,

a=728, b=102, and the baud rate=113.75 Gbaud;
W=48, P=52224, a=726, b=408, and the baud rate=113.4375 Gbaud;
W=56, P=15232, a=728, b=119, and the baud rate=113.75 Gbaud;
W=56, P=60928, a=726, b=476, and the baud rate=113.4375 Gbaud;
W=64, P=13056, a=728, b=102, and the baud rate=113.75 Gbaud;
W=64, P=69632, a=726, b=544, and the baud rate=113.4375 Gbaud;
W=120, P=32640, a=728, b=255, and the baud rate=113.75 Gbaud;
W=120, P=52224, a=727, b=408, and the baud rate=113.5938 Gbaud;
W=120, P=130560, a=726, b=1020, and the baud rate=113.4375 Gbaud;
W=128, P=34816, a=728, b=272, and the baud rate=113.75 Gbaud; or
W=128, P=139264, a=726, b=1088, and the baud rate=113.4375 Gbaud.

**44.** The data processing apparatus according to claim 41, wherein N=170, K=160, and $a = \frac{1445}{2} \times \frac{P+W}{P}$.

**45.** The data processing apparatus according to claim 44, wherein W=48, P=23120,

a=724, b=136, and the baud rate=113.125 Gbaud;
W=48, P=69360, a=723, b=408, and the baud rate=112.9688 Gbaud;
W=56, P=11560, a=726, b=68, and the baud rate=113.4375 Gbaud;
W=56, P=80920, a=723, b=476, and the baud rate=112.9688 Gbaud;
W=64, P=92480, a=723, b=544, and the baud rate=112.9688 Gbaud;
W=120, P=34680, a=725, b=204, and the baud rate=113.2813 Gbaud;
W=120, P=57800, a=724, b=340, and the baud rate=113.125 Gbaud;
W=120, P=173400, a=723, b=1020, and the baud rate=112.9688 Gbaud;
W=170, P=49130, a=725, b=289, and the baud rate=113.2813 Gbaud; or
W=170, P=245650, a=723, b=1445, and the baud rate=112.9688 Gbaud.

**46.** The data processing apparatus according to claim 41, wherein N=144, K=136, and $a = 720 \times \frac{P+W}{P}$.

**47.** The data processing apparatus according to claim 46, wherein W=48, P=5760, a=726, b=40, and the baud rate=113.4375 Gbaud;

W=48, P=8640, a=724, b=60, and the baud rate=113.125 Gbaud;
W=48, P=11520, a=723, b=80, and the baud rate=112.9688 Gbaud;
W=48, P=17280, a=722, b=120, and the baud rate=112.8125 Gbaud;
W=48, P=34560, a=721, b=240, and the baud rate=112.6563 Gbaud;
W=56, P=5760, a=727, b=40, and the baud rate=113.5938 Gbaud;
W=56, P=20160, a=722, b=140, and the baud rate=112.8125 Gbaud;
W=56, P=40320, a=721, b=280, and the baud rate=112.6563 Gbaud;
W=64, P=5760, a=728, b=40, and the baud rate=113.75 Gbaud;
W=64, P=11520, a=724, b=80, and the baud rate=113.125 Gbaud;
W=64, P=23040, a=722, b=160, and the baud rate=112.8125 Gbaud;
W=64, P=46080, a=721, b=320, and the baud rate=112.6563 Gbaud;
W=120, P=14400, a=726, b=100, and the baud rate=113.4375 Gbaud;
W=120, P=17280, a=725, b=120, and the baud rate=113.2813 Gbaud;
W=120, P=28800, a=723, b=200, and the baud rate=112.9688 Gbaud;
W=120, P=43200, a=722, b=300, and the baud rate=112.8125 Gbaud;
W=120, P=86400, a=721, b=600, and the baud rate=112.6563 Gbaud;
W=144, P=11520, a=729, b=80, and the baud rate=113.9063 Gbaud;
W=144, P=17280, a=726, b=120, and the baud rate=113.4375 Gbaud;
W=144, P=25920, a=724, b=180, and the baud rate=113.125 Gbaud;
W=144, P=34560, a=723, b=240, and the baud rate=112.9688 Gbaud;

W=144, P=51840, a=723, b=360, and the baud rate=112.8125 Gbaud; or
W=144, P=103680, a=721, b=720, and the baud rate=112.6563 Gbaud.

48. The data processing apparatus according to claim 46, wherein W=56, P=5040, a=728, b=35, and the baud rate=113.75 Gbaud;

W=56, P=10080, a=724, b=70, and the baud rate=113.125 Gbaud;
W=56, P=20160, a=722, b=140, and the baud rate=112.8125 Gbaud; or
W=56, P=40320, a=721, b=280, and the baud rate=112.6563 Gbaud.

49. The data processing apparatus according to any one of claims 36 to 40, wherein N=148, K=140, W is a multiple of 4, and b is a multiple of 17.

50. The data processing apparatus according to any one of claims 36 to 40, wherein N=128, K=120, and the baud rate of the modulated symbol stream is 113.4375 Gbaud.

51. The data processing apparatus according to claim 50, wherein P = 1088 × W.

52. The data processing apparatus according to claim 36, 37, 38, 39, 40, 50, or 51, wherein the alignment marker comprises at least one frame synchronization sequence with a length of 48 bits.

53. The data processing apparatus according to claim 52, wherein the 48 bits of the frame synchronization sequence are consecutive in the alignment marker.

54. The data processing apparatus according to claim 53, wherein values of the 48 bits of the frame synchronization sequence comprise 0x9A, 0x4A, 0x26, 0x65, 0xB5, and 0xD9.

55. The data processing apparatus according to claim 52, wherein the frame synchronization sequence comprises two frame synchronization subsequences, a bit length of each of the frame synchronization subsequences is 24 bits, and the two frame synchronization subsequences are separated by eight bits in the alignment marker.

56. The data processing apparatus according to claim 55, wherein values of 24 bits of one of the two frame synchronization subsequences comprise 0x9A, 0x4A, and 0x26, and values of 24 bits of the other of the two frame synchronization subsequences comprise 0x65, 0xB5, and 0xD9.

57. The data processing apparatus according to any one of claims 36 to 56, wherein the alignment marker comprises a padding bit and/or a status field.

58. The data processing apparatus according to any one of claims 36 to 57, wherein W is exactly divisible by N.

59. The data processing apparatus according to any one of claims 36 to 58, wherein at

least one of the following operations is performed for each of the second data streams before the second FEC encoding: alignment marker lock, lane de-skewing, and lane reordering; and/or
at least one of the following operations is further performed for each of the second data streams after the second FEC encoding: channel interleaving and scrambling.

60. The data processing apparatus according to any one of claims 36 to 58, wherein the first data processing unit is specifically configured to:

separately perform second FEC encoding on each group of eight first data streams in the plurality of first data streams to obtain each group of eight encoded data streams; and
perform channel interleaving on each group of eight encoded data streams to obtain one second data stream, to obtain the m second data streams.

61. The data processing apparatus according to claim 60, wherein N=128, K=120, and the first data processing unit is specifically configured to:

obtain one inner codeword with a length of 128 bits from each encoded data stream in each group of eight encoded data streams, to obtain eight inner codewords in total; and

obtain two bits from each of the eight inner codewords in a round-robin fashion, to obtain 1024 consecutive bits in the second data stream.

62. The data processing apparatus according to any one of claims 36 to 61, wherein cyclic shift is performed for each of the second data streams before the second FEC encoding.

63. The data processing apparatus according to claim 62, wherein the first data processing unit is specifically configured to:

separately perform convolutional interleaving on 8×m first data streams;
separately perform cyclic shift on 8×m convolutional interleaved first data streams; and
separately perform second FEC encoding on 8×m cyclic shifted first data streams.

64. The data processing apparatus according to claim 62, wherein the first data processing unit is specifically configured to:

separately perform convolutional interleaving on 2×m first data streams;
distribute each convolutional interleaved first data stream, to obtain four distributed first data streams, so as to obtain 8×m distributed first data streams in total;
separately perform cyclic shift on the 8×m distributed first data streams; and
separately perform second FEC encoding on 8×m cyclic shifted first data streams.

65. The data processing apparatus according to claim 62, wherein the first data processing unit is specifically configured to:

separately perform convolutional interleaving on m first data streams;
distribute each convolutional interleaved first data stream, to obtain eight distributed first data streams, so as to obtain 8×m distributed first data streams in total;
separately perform cyclic shift on the 8×m distributed first data streams; and
separately perform second FEC encoding on 8×m cyclic shifted first data streams.

66. The data processing apparatus according to claim 36, 37, 41, 42, 43, 44, 45, 46, 47, 48, 49, 50, 51, 52, 53, 54, 55, 56, 57, or 58, wherein the first data processing unit is specifically configured to:

distribute each of m first data streams to obtain eight distributed first data streams, so as to obtain 8×m distributed first data streams in total;
separately perform second FEC encoding on the 8×m distributed first data streams to obtain 8×m encoded data streams; and
perform codeword merging on every eight encoded data streams in the 8×m encoded data streams to obtain one second data stream, so as to obtain the m second data streams in total.

67. The data processing apparatus according to any one of claims 36 to 66, wherein the alignment marker comprises at least one target codeword, and the target codeword comprises N bits.

68. The data processing apparatus according to claim 67, wherein the target codeword is obtained by performing second FEC encoding on K-bit alignment marker information.

69. The data processing apparatus according to claim 67 or 68, wherein the alignment marker is obtained by performing codeword interleaving on a plurality of target codewords, or is obtained by performing codeword merging on a plurality of target codewords.

70. A data processing apparatus, comprising a data processing unit and a synchronization unit, wherein

the data processing unit is configured to perform fourth data processing on received Y modulated symbol streams to obtain m fourth data streams, wherein demodulation has been performed for each of the fourth data streams, the Y modulated symbol streams are obtained by performing third data processing on m third data streams, modulation has been performed for each of the modulated symbol streams, the m third data streams are obtained by separately performing second data processing on m second data streams, and the m second data streams are obtained by performing first data processing on a plurality of first data streams obtained through first forward error correction FEC encoding, wherein Y is an integer greater than or equal to 1, and m is an integer greater than 1; second FEC encoding has been performed for each of the second data streams, and each codeword obtained through the second FEC encoding comprises N bits, wherein N=K+S, K represents a quantity of information bits, S represents a quantity of parity bits, K is an integer greater than or equal to 1, and S is an integer greater than or equal to 1; and each of the third data streams comprises at least one bit sequence, each bit sequence comprises P+W bits, the P bits in each bit sequence are from the second data stream, and the W bits in each bit sequence are an added alignment marker, wherein $P=N\times b$, b is an integer greater than or equal to 1, and a value of a baud rate of each of the modulated symbol streams is an integer multiple of a value of a reference clock frequency; and the synchronization unit is configured to perform frame synchronization on each of the fourth data streams based on an alignment marker in each of the fourth data streams.

71. A data processing method, comprising:

    performing first data processing on m first data streams obtained through first forward error correction FEC encoding, to obtain m second data streams, wherein
    m is an integer greater than 1, each of the second data streams comprises at least one first bit sequence, each first bit sequence comprises $\tilde{P}+\tilde{W}$ bits, the $\tilde{P}$ bits in each first bit sequence are from the first data stream, and the $\tilde{W}$ bits in each first bit sequence are an added first marker;
    performing second data processing on the m second data streams to obtain m third data streams, wherein the second data processing comprises second FEC encoding, and each codeword obtained through the second FEC encoding comprises N bits,
    wherein N=K+S, K represents a quantity of information bits, S represents a quantity of parity bits, K is an integer greater than or equal to 1, S is an integer greater than or equal to 1, $\tilde{P}=K\times b$, $\tilde{W}=K\times e$, b is an integer greater than or equal to 1, and e is an integer greater than or equal to 1; and
    performing third data processing on the m third data streams to obtain Y modulated symbol streams, wherein Y is an integer greater than or equal to 1, modulation has been performed for each of the modulated symbol streams, and a value of a baud rate of each of the modulated symbol streams is an integer multiple of a value of a reference clock frequency.

72. The method according to claim 71, wherein each of the third data streams comprises at least one second bit sequence, each second bit sequence comprises P+W bits, the P bits in each second bit sequence are obtained by performing second FEC encoding on the $\tilde{P}$ bits, the W bits in each second bit sequence are a second marker, and the second marker is obtained by performing second FEC encoding on the first marker, wherein $P=N\times b$, and $W=N\times e$.

73. The method according to claim 71 or 72, wherein the value of the baud rate of each of the modulated symbol streams is an integer multiple of 156.25M.

74. The method according to any one of claims 71 to 73, wherein the first marker comprises a padding bit and/or a status field.

75. The method according to any one of claims 71 to 74, wherein convolutional interleaving is further performed for each of the first data streams, and the convolutional interleaving comprises delaying an input data stream based on r delay lines, wherein r is an integer greater than 1; the delay lines comprise different quantities of storage units, a delay line with a smallest quantity of storage units comprises zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving comprise d bits output from each delay line, wherein Q is an integer greater than or equal to 1, and d is an integer greater than or equal to 1.

76. The method according to claim 75, wherein input and output switches corresponding to the convolutional interleaving are in a $0^{th}$ delay line each time f bits are output through the convolutional interleaving, wherein $K\times b$ is exactly divisible by f.

**77.** The method according to claim 75 or 76, wherein r×d×c=K×b, and c is an integer greater than or equal to 1.

**78.** The method according to any one of claims 71 to 77, wherein $\frac{\widetilde{W}+\widetilde{P}}{\widetilde{P}} \times \frac{N}{K} = \frac{18}{17}$.

**79.** The method according to any one of claims 71 to 78, wherein N=148, K=140, 5032 × e is exactly divisible by b, and $5032 + (\frac{5032 \times e}{b})$ is exactly divisible by 7.

**80.** The method according to claim 79, wherein b = 629 × e.

**81.** The method according to claim 80, wherein KP4 encoding is used for the first FEC encoding, and Hamming(148,140) is used for the second FEC encoding; or
KP4 encoding is used for the first FEC encoding; and the second FEC encoding is performing bitwise exclusive OR on every two consecutive information bits in K=140 information bits to obtain 70 bits, and performing Hamming(78,70) encoding on the 70 bits to obtain S=8 parity bits, and the codeword with a length of 148 bits that is obtained through the second FEC encoding comprises the K=140 information bits and the S=8 parity bits.

**82.** The method according to any one of claims 71 to 78, wherein N=127, K=120, 2159 × e is exactly divisible by b, and $2159 + (\frac{2159 \times e}{b})$ is exactly divisible by 3.

**83.** The method according to claim 82, wherein b = 2159 × e.

**84.** The method according to claim 83, wherein KP4 encoding is used for the first FEC encoding, and Hamming(127,120) is used for the second FEC encoding; or
KP4 encoding is used for the first FEC encoding; and the second FEC encoding is performing bitwise exclusive OR on every two consecutive information bits in K=120 information bits to obtain 60 bits, and performing Hamming(67,60) encoding on the 60 bits to obtain S=7 parity bits, and the codeword with a length of 127 bits that is obtained through the second FEC encoding comprises the K=120 information bits and the S=7 parity bits.

**85.** The method according to any one of claims 71 to 84, wherein the first data processing further comprises scrambling.

**86.** The method according to any one of claims 71 to 85, wherein the third data processing further comprises codeword interleaving, and the codeword interleaving is performed on t codewords to obtain an interleaved sequence comprising t × N bits, wherein an $i^{th}$ codeword in the t codewords comprises a K-bit information sequence $B_i$ and an S-bit parity sequence $P_i$, $0 \leq i \leq t-1$, the interleaved sequence comprises a first subsequence with t × K consecutive bits and a second subsequence with t × S consecutive bits, the first subsequence comprises a total of t information sequences that are $B_0$, $B_1$, $B_2$, ..., $B_{t-1}$, and the second subsequence comprises a total of t parity sequences that are $P_0$, $P_1$, $P_2$, ..., $P_{t-1}$.

**87.** The method according to any one of claims 71 to 86, wherein the baud rate of the modulated symbol stream is $\frac{850}{2\times4} \times \frac{\widetilde{W}+\widetilde{P}}{\widetilde{P}} \times \frac{N}{K}$ Gbaud, and the value of the baud rate is $\frac{850}{2\times4} \times \frac{\widetilde{W}+\widetilde{P}}{\widetilde{P}} \times \frac{N}{K}G = a \times 156.25M$, wherein a is an integer greater than or equal to 1, G represents 10^9, and M represents 10^6.

**88.** The method according to claim 71, 72, 73, 74, 75, 76, 77, 85, 86, or 87, wherein N=128, K=120, and the baud rate of the modulated symbol stream is 113.4375 Gbaud.

**89.** The method according to claim 88, wherein $\widetilde{P} = 1088 \times \widetilde{W}$.

**90.** The method according to any one of claims 71 to 89, wherein the performing third data processing on the m third data streams to obtain Y modulated symbol streams comprises:

performing channel interleaving on each group of eight third data streams in the m third data streams to obtain one

68

fourth data stream, so as to obtain Y fourth data streams in total; and

separately modulating the Y fourth data streams to obtain the Y modulated symbol streams.

91. The method according to claim 90, wherein the first marker in each of the second data streams comprises a synchronization subsequence with a length of $\tilde{W}_s$ bits, wherein the synchronization subsequence is $\tilde{W}_s$ consecutive bits starting from a start position in the first marker.

92. The method according to claim 91, wherein $\tilde{W}_s = 6$, one group of eight third data streams in the m third data streams is obtained by performing second FEC encoding on one group of eight second data streams in the m second data streams, one fourth data stream obtained by performing channel interleaving on the group of eight third data streams comprises a synchronization sequence with a length of 48 bits, the synchronization sequence with a length of 48 bits is consecutive in the fourth data stream, and the synchronization sequence with a length of 48 bits comprises a total of eight synchronization subsequences respectively comprised in the group of eight second data streams.

93. The method according to claim 92, wherein values of the 48 bits of the synchronization sequence comprise 0x9A, 0x4A, 0x26, 0x65, 0xB5, and 0xD9.

94. The method according to claim 92 or 93, wherein a synchronization subsequence 0

comprised in a $0^{th}$ second data stream in the group of eight second data streams is 010110;

a synchronization subsequence 1 comprised in a $1^{st}$ second data stream in the group of eight second data streams is 011010;

a synchronization subsequence 2 comprised in a $2^{nd}$ second data stream in the group of eight second data streams is 100111;

a synchronization subsequence 3 comprised in a $3^{rd}$ second data stream in the group of eight second data streams is 010001;

a synchronization subsequence 4 comprised in a $4^{th}$ second data stream in the group of eight second data streams is 011010;

a synchronization subsequence 5 comprised in a $5^{th}$ second data stream in the group of eight second data streams is 011001;

a synchronization subsequence 6 comprised in a $6^{th}$ second data stream in the group of eight second data streams is 000110; and

a synchronization subsequence 7 comprised in a $7^{th}$ second data stream in the group of eight second data streams is 101011.

95. The method according to claim 90, wherein one group of eight third data streams

in the m third data streams is obtained by performing second FEC encoding on one group of eight second data streams in the m second data streams;

a $0^{th}$ second data stream, a $1^{st}$ second data stream, a $2^{nd}$ second data stream, and a $3^{rd}$ second data stream in the group of eight second data streams each comprise a synchronization subsequence with a length of eight bits; and

a $4^{th}$ second data stream, a $5^{th}$ second data stream, a $6^{th}$ second data stream, and a $7^{th}$ second data stream in the group of eight second data streams each comprise a synchronization subsequence with a length of four bits, wherein first two bits and last two bits in the synchronization subsequence with a length of four bits are separated by two bits.

96. The method according to claim 95, wherein one fourth data stream obtained by performing channel interleaving on the group of eight third data streams comprises a synchronization sequence with a length of 48 bits, the synchronization sequence with a length of 48 bits comprises a total of eight synchronization subsequences respectively comprised in the group of eight second data streams, and first 24 bits and last 24 bits in the synchronization sequence with a length of 48 bits are separated by eight bits.

97. The method according to claim 96, wherein values of the first 24 bits in the synchronization sequence with a length of 48 bits comprise 0x9A, 0x4A, and 0x26, and values of the last 24 bits in the synchronization sequence with a length of 48 bits comprise 0x65, 0xB5, and 0xD9.

98. The method according to any one of claims 95 to 97, wherein a synchronization

subsequence 0 comprised in the $0^{th}$ second data stream in the group of eight second data streams is 01011010; a synchronization subsequence 1 comprised in the $1^{st}$ second data stream in the group of eight second data streams is 01101001; a synchronization subsequence 2 comprised in the $2^{nd}$ second data stream in the group of eight second data streams is 10010110; a synchronization subsequence 3 comprised in the $3^{rd}$ second data stream in the group of eight second data streams is 01001011; a synchronization subsequence 4 comprised in the $4^{th}$ second data stream in the group of eight second data streams is 0110; a synchronization subsequence 5 comprised in the $5^{th}$ second data stream in the group of eight second data streams is 0110; a synchronization subsequence 6 comprised in the $6^{th}$ second data stream in the group of eight second data streams is 0011; and a synchronization subsequence 7 comprised in the $7^{th}$ second data stream in the group of eight second data streams is 1001.

99. The method according to any one of claims 71 to 90, wherein the first marker in each of the second data streams comprises a synchronization subsequence with a length of 48 bits, and first 24 bits and last 24 bits in the synchronization subsequence are separated by eight bits.

100.
The method according to claim 99, wherein values of the first 24 bits in the synchronization subsequence with a length of 48 bits comprise 0x9A, 0x4A, and 0x26, and values of the last 24 bits in the synchronization subsequence with a length of 48 bits comprise 0x65, 0xB5, and 0xD9.

101.
The method according to any one of claims 90 to 98, wherein N=128, K=120, and the performing channel interleaving on each group of eight third data streams to obtain one fourth data stream comprises:

obtaining one inner codeword with a length of 128 bits from each of the third data streams in each group of eight third data streams, to obtain eight inner codewords in total; and
obtaining two bits from each of the eight inner codewords in a round-robin fashion, to obtain 1024 consecutive bits in the fourth data stream.

102.
The method according to any one of claims 71 to 101, wherein the performing first data processing on m first data streams comprises:
separately performing cyclic shift on the m first data streams.

103.
The method according to claim 102, wherein before the separately performing cyclic shift on the m first data streams, the performing first data processing on m first data streams comprises:
separately performing convolutional interleaving on the m first data streams.

104.
The method according to claim 102, wherein before the separately performing cyclic shift on the m first data streams, the method further comprises:

separately performing convolutional interleaving on m/4 input data streams; and
distributing, to obtain four first data streams, each input convolutional interleaved data stream, to obtain the m first data streams in total.

105.
The method according to claim 102, wherein before the separately performing cyclic shift on the m first data streams, the method further comprises:

separately performing convolutional interleaving on m/8 input data streams; and
distributing, to obtain eight first data streams, each input convolutional interleaved data stream, to obtain the m first data streams in total.

**106.**
A data processing method, comprising:

performing fourth data processing on received Y modulated symbol streams to obtain m fourth data streams, wherein Y is an integer greater than or equal to 1;
demodulation has been performed for each of the fourth data streams, a value of a baud rate of each of the modulated symbol streams is an integer multiple of a value of a reference clock frequency, the Y modulated symbol streams are obtained by performing third data processing on m third data streams, modulation has been performed for each of the modulated symbol streams, the m third data streams are obtained by performing second data processing on m second data streams, and the m second data streams are obtained by performing first data processing on m first data streams obtained through first forward error correction FEC encoding, wherein m is an integer greater than 1; and each of the second data streams comprises at least one first bit sequence, each first bit sequence comprises $\tilde{P} + \tilde{W}$ bits, the $\tilde{P}$ bits in each first bit sequence are from the first data stream, the $\tilde{W}$ bits in each first bit sequence are an added first marker, the second data processing comprises second FEC encoding, and each codeword obtained through the second FEC encoding comprises N bits, wherein N=K+S, K represents a quantity of information bits, S represents a quantity of parity bits, K is an integer greater than or equal to 1, S is an integer greater than or equal to 1, $\tilde{P}=K \times b$, $\tilde{W} = K \times e$, b is an integer greater than or equal to 1, and e is an integer greater than or equal to 1; and
performing codeword synchronization and/or frame synchronization on each of the fourth data streams.

**107.**
A data processing apparatus, comprising a first data processing unit, a second data

processing unit, and a third data processing unit, wherein
the first data processing unit is configured to perform first data processing on m first data streams obtained through first forward error correction FEC encoding, to obtain m second data streams, wherein m is an integer greater than 1, each of the second data streams comprises at least one first bit sequence, each first bit sequence comprises $\tilde{P} + \tilde{W}$ bits, the $\tilde{P}$ bits in each first bit sequence are from the first data stream, and the $\tilde{W}$ bits in each first bit sequence are an added first marker;
the second data processing unit is configured to perform second data processing on the m second data streams to obtain m third data streams, wherein the second data processing comprises second FEC encoding, and each codeword obtained through the second FEC encoding comprises N bits, wherein N=K+S, K represents a quantity of information bits, S represents a quantity of parity bits, K is an integer greater than or equal to 1, S is an integer greater than or equal to 1, $\tilde{P}=K \times b$, $\tilde{W} = K \times e$, b is an integer greater than or equal to 1, and e is an integer greater than or equal to 1; and
the third data processing unit is configured to perform third data processing on the m third data streams to obtain Y modulated symbol streams, wherein Y is an integer greater than or equal to 1, modulation has been performed for each of the modulated symbol streams, and a value of a baud rate of each of the modulated symbol streams is an integer multiple of a value of a reference clock frequency.

**108.**
The data processing apparatus according to claim 107, wherein each of the third data streams comprises at least one second bit sequence, each second bit sequence comprises P+W bits, the P bits in each second bit sequence are obtained by performing second FEC encoding on the $\tilde{P}$ bits, the W bits in each second bit sequence are a second marker, and the second marker is obtained by performing second FEC encoding on the first marker, wherein P=N$\times$b, and W=N$\times$e.

**109.**
The data processing apparatus according to claim 107 or 108, wherein the value of the baud rate of each of the modulated symbol streams is an integer multiple of 156.25M.

**110.**
The data processing apparatus according to any one of claims 107 to 109, wherein the first marker comprises a padding bit and/or a status field.

**111.** The data processing apparatus according to any one of claims 107 to 110, wherein convolutional interleaving is further performed for each of the first data streams, and the convolutional interleaving comprises delaying an input data stream based on r delay lines, wherein r is an integer greater than 1; the delay lines comprise different quantities of storage units, a delay line with a smallest quantity of storage units comprises zero storage units, a difference between quantities of storage units in every two adjacent delay lines is Q, and each storage unit is for storing d bits; bits in the input data stream are sequentially input into the r delay lines based on sequence numbers of the r delay lines, d bits are input into each delay line for a single time, and d bits are output from each delay line for a single time; and r*d consecutive bits in a data stream that is output through the convolutional interleaving comprise d bits output from each delay line, wherein Q is an integer greater than or equal to 1, and d is an integer greater than or equal to 1.

**112.**

The data processing apparatus according to claim 111, wherein input and output switches corresponding to the convolutional interleaving are in a $0^{th}$ delay line each time f bits are output through the convolutional interleaving, wherein K×b is exactly divisible by f.

**113.**

The data processing apparatus according to claim 111 or 112, wherein r×d×c=K×b, and c is an integer greater than or equal to 1.

**114.**

The data processing apparatus according to any one of claims 111 to 113, wherein $\dfrac{\widetilde{W}+\widetilde{P}}{\widetilde{P}} \times \dfrac{N}{K} = \dfrac{18}{17}$.

**115.**

The data processing apparatus according to any one of claims 107 to 114, wherein N=148, K=140, 5032 × e is exactly divisible by b, and $5032 + (\dfrac{5032 \times e}{b})$ is exactly divisible by 7.

**116.**

The data processing apparatus according to claim 115, wherein b = 629 × e.

**117.**

The data processing apparatus according to claim 116, wherein KP4 encoding is

used for the first FEC encoding, and Hamming(148,140) is used for the second FEC encoding; or
KP4 encoding is used for the first FEC encoding; and the second FEC encoding is performing bitwise exclusive OR on every two consecutive information bits in K=140 information bits to obtain 70 bits, and performing Hamming(78,70) encoding on the 70 bits to obtain S=8 parity bits, and the codeword with a length of 148 bits that is obtained through the second FEC encoding comprises the K=140 information bits and the S=8 parity bits.

**118.**

The data processing apparatus according to any one of claims 107 to 114, wherein N=127, K=120, 2159 × e is exactly divisible by b, and $2159 + (\dfrac{2159 \times e}{b})$ is exactly divisible by 3.

**119.**

The data processing apparatus according to claim 118, wherein b = 2159 × e.

**120.**

The data processing apparatus according to claim 119, wherein KP4 encoding is

used for the first FEC encoding, and Hamming(127,120) is used for the second FEC encoding; or
KP4 encoding is used for the first FEC encoding; and the second FEC encoding is performing bitwise exclusive OR on every two consecutive information bits in K=120 information bits to obtain 60 bits, and performing Hamming(67,60) encoding on the 60 bits to obtain S=7 parity bits, and the codeword with a length of 127 bits that is obtained through the second FEC encoding comprises the K=120 information bits and the S=7 parity bits.

**121.**

The data processing apparatus according to any one of claims 107 to 120, wherein the first data processing further comprises scrambling.

**122.**

The data processing apparatus according to any one of claims 107 to 121, wherein the third data processing further comprises codeword interleaving, and the codeword interleaving is performed on t codewords to obtain an interleaved sequence comprising $t \times N$ bits, wherein an $i^{th}$ codeword in the t codewords comprises a K-bit information sequence $B_i$ and an S-bit parity sequence $P_i$, $0 \leq i \leq t - 1$, the interleaved sequence comprises a first subsequence with $t \times K$ consecutive bits and a second subsequence with $t \times S$ consecutive bits, the first subsequence comprises a total of t information sequences that are $B_0$, $B_1$, $B_2$, ..., $B_{t-1}$, and the second subsequence comprises a total of t parity sequences that are $P_0$, $P_1$, $P_2$, ..., $P_{t-1}$.

**123.**

The data processing apparatus according to any one of claims 107 to 122, wherein the baud rate of the modulated symbol stream is $\frac{850}{2 \times 4} \times \frac{\widetilde{W} + \tilde{P}}{\tilde{P}} \times \frac{N}{K}$ Gbaud, and the value of the baud rate is $\frac{850}{2 \times 4} \times \frac{\widetilde{W} + \tilde{P}}{\tilde{P}} \times \frac{N}{K} G = a \times 156.25M$, wherein a is an integer greater than or equal to 1, G represents 10^9, and M represents 10^6.

**124.**

The data processing apparatus according to claim 107, 108, 109, 110, 111, 112, 113, 121, 122 or 123, wherein N=128, K=120, and the baud rate of the modulated symbol stream is 113.4375 Gbaud.

**125.**

The data processing apparatus according to claim 124, wherein $\tilde{P} = 1088 \times \tilde{W}$.

**126.**

The data processing apparatus according to any one of claims 107 to 125, wherein the third data processing unit is specifically configured to:

perform channel interleaving on each group of eight third data streams in the m third data streams to obtain one fourth data stream, so as to obtain Y fourth data streams in total; and
separately modulate the Y fourth data streams to obtain the Y modulated symbol streams.

**127.**

The data processing apparatus according to claim 126, wherein the first marker in each of the second data streams comprises a synchronization subsequence with a length of $\tilde{W}_s$ bits, wherein the synchronization subsequence is $\tilde{W}_s$ consecutive bits starting from a start position in the first marker.

**128.**

The data processing apparatus according to claim 127, wherein $\tilde{W}_s = 6$, one group of eight third data streams in the m third data streams is obtained by performing second FEC encoding on one group of eight second data streams in the m second data streams, one fourth data stream obtained by performing channel interleaving on the group of eight third data streams comprises a synchronization sequence with a length of 48 bits, the synchronization sequence with a length of 48 bits is consecutive in the fourth data stream, and the synchronization sequence with a length of 48 bits comprises a total of eight synchronization subsequences respectively comprised in the group of eight second data streams.

**129.**

The data processing apparatus according to claim 128, wherein values of the 48 bits of the synchronization sequence comprise 0x9A, 0x4A, 0x26, 0x65, 0xB5, and 0xD9.

**130.**

The data processing apparatus according to claim 128 or 129, wherein a

synchronization subsequence 0 comprised in a $0^{th}$ second data stream in the group of eight second data streams is 010110;
a synchronization subsequence 1 comprised in a $1^{st}$ second data stream in the group of eight second data streams is 011010;

a synchronization subsequence 2 comprised in a 2nd second data stream in the group of eight second data streams is 100111;

a synchronization subsequence 3 comprised in a 3rd second data stream in the group of eight second data streams is 010001;

a synchronization subsequence 4 comprised in a 4th second data stream in the group of eight second data streams is 011010;

a synchronization subsequence 5 comprised in a 5th second data stream in the group of eight second data streams is 011001;

a synchronization subsequence 6 comprised in a 6th second data stream in the group of eight second data streams is 000110; and

a synchronization subsequence 7 comprised in a 7th second data stream in the group of eight second data streams is 101011.

**131.**

The data processing apparatus according to claim 126, wherein one group of eight

third data streams in the m third data streams is obtained by performing second FEC encoding on one group of eight second data streams in the m second data streams; a 0th second data stream, a 1st second data stream, a 2nd second data stream, and a 3rd second data stream in the group of eight second data streams each comprise a synchronization subsequence with a length of eight bits; and

a 4th second data stream, a 5th second data stream, a 6th second data stream, and a 7th second data stream in the group of eight second data streams each comprise a synchronization subsequence with a length of four bits, wherein first two bits and last two bits in the synchronization subsequence with a length of four bits are separated by two bits.

**132.**

The data processing apparatus according to claim 131, wherein one fourth data stream obtained by performing channel interleaving on the group of eight third data streams comprises a synchronization sequence with a length of 48 bits, the synchronization sequence with a length of 48 bits comprises a total of eight synchronization subsequences respectively comprised in the group of eight second data streams, and first 24 bits and last 24 bits in the synchronization sequence with a length of 48 bits are separated by eight bits.

**133.**

The data processing apparatus according to claim 132, wherein values of the first 24 bits in the synchronization sequence with a length of 48 bits comprise 0x9A, 0x4A, and 0x26, and values of the last 24 bits in the synchronization sequence with a length of 48 bits comprise 0x65, 0xB5, and 0xD9.

**134.**

The data processing apparatus according to any one of claims 131 to 133, wherein

a synchronization subsequence 0 comprised in the 0th second data stream in the group of eight second data streams is 01011010;

a synchronization subsequence 1 comprised in the 1st second data stream in the group of eight second data streams is 01101001;

a synchronization subsequence 2 comprised in the 2nd second data stream in the group of eight second data streams is 10010110;

a synchronization subsequence 3 comprised in the 3rd second data stream in the group of eight second data streams is 01001011;

a synchronization subsequence 4 comprised in the 4th second data stream in the group of eight second data streams is 0110;

a synchronization subsequence 5 comprised in the 5th second data stream in the group of eight second data streams is 0110;

a synchronization subsequence 6 comprised in the 6th second data stream in the group of eight second data streams is 0011; and

a synchronization subsequence 7 comprised in the 7th second data stream in the group of eight second data streams is 1001.

**135.**

The data processing apparatus according to any one of claims 107 to 126, wherein the first marker in each of the second data streams comprises a synchronization subsequence with a length of 48 bits, and first 24 bits and last 24 bits in the synchronization subsequence are separated by eight bits.

**136.**
The data processing apparatus according to claim 135, wherein values of the first 24 bits in the synchronization subsequence with a length of 48 bits comprise 0x9A, 0x4A, and 0x26, and values of the last 24 bits in the synchronization subsequence with a length of 48 bits comprise 0x65, 0xB5, and 0xD9.

**137.**
The data processing apparatus according to any one of claims 126 to 136, wherein N=128, K=120, and the third data processing unit is specifically configured to:

    obtain one inner codeword with a length of 128 bits from each of the third data streams in each group of eight third data streams, to obtain eight inner codewords in total; and
    obtain two bits from each of the eight inner codewords in a round-robin fashion, to obtain 1024 consecutive bits in the fourth data stream.

**138.**
The data processing apparatus according to any one of claims 107 to 137, wherein the first data processing unit is specifically configured to:
separately perform cyclic shift on the m first data streams.

**139.**
The data processing apparatus according to claim 138, wherein before the cyclic shift is separately performed on the m first data streams, the first data processing unit is specifically configured to:
separately perform convolutional interleaving on the m first data streams.

**140.**
The data processing apparatus according to claim 138, wherein the data processing

    apparatus further comprises a convolutional-interleaving unit and a distribution unit; and before the cyclic shift is separately performed on the m first data streams, the convolutional-interleaving unit is configured to separately perform convolutional interleaving on m/4 input data streams; and
    the distribution unit is configured to distribute, to obtain four first data streams, each input convolutional interleaved data stream, to obtain the m first data streams in total.

**141.**
The data processing apparatus according to claim 138, wherein the data processing

    apparatus further comprises a convolutional-interleaving unit and a distribution unit; and before the cyclic shift is separately performed on the m first data streams, the convolutional-interleaving unit is configured to separately perform convolutional interleaving on m/8 input data streams; and
    the distribution unit is configured to distribute, to obtain eight first data streams, each input convolutional interleaved data stream, to obtain the m first data streams in total.

**142.**
A data processing apparatus, comprising a data processing unit and a

    synchronization unit, wherein
    the data processing unit is configured to perform fourth data processing on received Y modulated symbol streams to obtain m fourth data streams, wherein Y is an integer greater than or equal to 1; demodulation has been performed for each of the fourth data streams, a value of a baud rate of each of the modulated symbol streams is an integer multiple of a value of a reference clock frequency, the Y modulated symbol streams are obtained by performing third data processing on m third data streams, modulation has been performed for each of the modulated symbol streams,
    the m third data streams are obtained by performing second data processing on m second data streams, and the m second data streams are obtained by performing first data processing on m first data streams obtained through first forward error correction FEC encoding, wherein m is an integer greater than 1; and each of the second data streams comprises at least one first bit sequence, each first bit sequence comprises $\tilde{P} + \tilde{W}$ bits, the $\tilde{P}$ bits in each first bit sequence are from the first data stream, the $\tilde{W}$ bits in each first bit sequence are an added first marker, the second data processing comprises second FEC encoding, and each codeword obtained through the second FEC encoding comprises N bits, wherein N=K+S, K represents a quantity of information bits, S represents a quantity of parity bits, K is an integer greater than or equal to 1, S is an integer greater than or equal to 1, $\tilde{P}=K\times b$, $\tilde{W} = K \times e$, b is an integer greater than or equal to 1, and e is an integer greater than or equal to 1; and

the synchronization unit is configured to perform codeword synchronization and/or frame synchronization on each of the fourth data streams.

[FIG. 1]

| Transmitter device 01 | Attachment unit interface AUI | Transmitter processing module 02 | Channel transmission medium 03 | Receiver processing module 04 | Attachment unit interface AUI | Receiver device 05 |

[FIG. 2(a)]

Transmitter device 01 → Outer-code encoded data → Transmitter processing module 02 → Outer-code encoded and inner-code encoded data → Channel transmission medium 03

Receiver device 05 ← Inner-code decoded data ← Receiver processing module 04 ← Outer-code encoded and inner-code encoded data ← Channel transmission medium 03

[FIG. 2(b)]

Transmitter device 01

Outer-code encoding → Inner-code encoding

Channel transmission medium 03

Receiver device 05

Inner-code decoding → Outer-code decoding

[FIG. 3]

Perform first data processing on a plurality of first data streams to obtain m second data streams — 301

Separately perform second data processing on the m second data streams to obtain m third data streams — 302

Perform third data processing on the m third data streams to obtain Y modulated symbol streams — 303

[FIG. 4(a)]

[FIG. 4(b)]

[FIG. 5(a)]

W-bit alignment marker   P bits   W-bit alignment marker   P bits

[FIG. 5(b)]

Padding bit    Status field        Padding bit    Status field

W-bit alignment marker      P bits    W-bit alignment marker    P bits

[FIG. 6]

| Perform fourth data processing on received Y modulated symbol streams to obtain m fourth data streams | 601 |
|---|---|
| Perform frame synchronization on each of the fourth data streams based on an alignment marker in each of the fourth data streams | 602 |

[FIG. 7]

| Perform first data processing on m first data streams to obtain m second data streams | 401 |
|---|---|
| Perform second data processing on the m second data streams to obtain m third data streams | 402 |
| Perform third data processing on the m third data streams to obtain Y modulated symbol streams | 403 |

[FIG. 8]

Padding bit   Status field          Padding bit   Status field

$\widetilde{W}$ -bit first marker     $\widetilde{P}$ bits     $\widetilde{W}$ -bit first marker     $\widetilde{P}$ bits

[FIG. 9]

Padding bit    Status field        Padding bit    Status field

$\widetilde{W}$-bit first marker    $\widetilde{P}$ bits    $\widetilde{W}$-bit first marker    $\widetilde{P}$ bits

Inner-code encoding

S    Padding                    S    Padding
K information parity  bit   Status   N-bit          K information parity  bit  Status   N-bit
bits          bits         field    codeword        bits          bits       field    codeword

W-bit second marker           P bits          W-bit second marker          P bits
(also referred to as a
frame header)

Frame

[FIG. 10]

```
                                                    B[119:0]
     ┌─────────────────────────────────────────────────┐
     │                                                  │
─────┤──────┬──────────────┬─────────────────┐         ╲
B[119:0]     │              │                 │          ╲
       ┌─────┴──────┐   C[59:0]  ┌────────────┴─┐    ╲     ╲
       │B[2*i]^B[2*i+1]│────────→│Hamming(67,60)│──────╲────→  D[126:0]
       └────────────┘         └──────────────┘  P[6:0] ╱
                                                      ╱
```

B[119:0]  ·  B[2*i]^B[2*i+1]  ·  C[59:0]  ·  Hamming(67,60)  ·  P[6:0]  ·  D[126:0]

[FIG. 11]

```
                                                    B[119:0]
     ┌─────────────────────────────────────────────────┐
     │                                                  │
─────┤──────┬──────────────┬─────────────────┐         ╲
B[119:0]     │              │                 │          ╲
       ┌─────┴──────┐   C[59:0]  ┌────────────┴─┐    ╲     ╲
       │B[2*i]^B[2*i+1]│────────→│Hamming(67,60)│──────╲────→  D[126:0]
       └────────────┘         └──────────────┘  P[6:0] ╱
                                                      ╱
```

[FIG. 12]

1<sup>st</sup> position is an MSB bit

1<sup>st</sup> position is an LSB bit

K information bits

S parity bits

One codeword

The other codeword

[FIG. 13]

Parity sequence $P_0$      Parity sequence $P_1$      Parity sequence $P_{t-1}$

...

| Information sequence $B_0$ | Information sequence $B_1$ | ... | Information sequence $B_{t-1}$ |

... Codeword $D_0$      Codeword $D_1$      Codeword $D_{t-1}$

Inner codeword interleaving

Parity sequence $P_0$   Parity sequence $P_1$   Parity sequence $P_{t-1}$

| Information sequence $B_0$ | Information sequence $B_1$ | ... | Information sequence $B_{t-1}$ | ... |

$t \times N$ bits in total, including information bits with a length of $t \times K$ bits and parity bits with a length of $t \times S$ bits

[FIG. 14]

Data sub-processing 0

- Eight data streams
- Inner-code encoding
- Inner-code encoding
- Inner-code encoding
- Eight encoded data streams
- Channel interleaving (inner codeword interleaving)
- Second data stream
- Periodic insertion of an alignment marker
- Third data stream
- PAM4 modulation
- Modulated symbol stream 0

Data sub-processing 3

- Eight data streams
- Inner-code encoding
- Inner-code encoding
- Inner-code encoding
- Eight encoded data streams
- Channel interleaving (inner codeword interleaving)
- Second data stream
- Periodic insertion of an alignment marker
- Third data stream
- PAM4 modulation
- Modulated symbol stream 3

[FIG. 15]

One group of frame
synchronization sequences
including 48 bits in total

One group of frame
synchronization sequences
including 48 bits in total

Eight bits

W-bit alignment marker     P bits     W-bit alignment marker     P bits

(a)

Frame synchronization
subsequence 1 including
24 bits in total

Eight
bits

Frame synchronization
subsequence 2 including
24 bits in total

0x9A 0x4A 0x26     0x65 0xB5 0xD9

W-bit alignment marker

(b)

[FIG. 16]

[FIG. 17]

(a)

(b)

(c)

[FIG. 18]

EP 4 593 321 A1

[FIG. 19]

[FIG. 20]

Eight first data streams | Eight data streams that are not encoded | Eight encoded data streams | **Data sub-processing 0**

Eight first data streams | Eight data streams that are not encoded | Eight encoded data streams | **Data sub-processing 3**

[FIG. 21]

[FIG. 22(a)]

[FIG. 22(b)]

First data stream 0

Distribution

Eight distributed data streams

Inner-code encoding

Inner-code encoding

Inner-code encoding

Eight encoded data streams

Codeword merging

Second data stream

Periodic insertion of an alignment marker

Third data stream

PAM4 modulation

Modulated symbol stream 0

Data sub-processing 0

First data stream 3

Distribution

Eight distributed data streams

Inner-code encoding

Inner-code encoding

Inner-code encoding

Eight encoded data streams

Codeword merging

Second data stream

Periodic insertion of an alignment marker

Third data stream

PAM4 modulation

Modulated symbol stream 3

Data sub-processing 3

[FIG. 22(c)]

Data sub-processing 0

First data stream 0 → Inner-code encoding → Periodic insertion of an alignment marker → PAM4 modulation → Modulated symbol stream 0

Second data stream    Third data stream

**Data sub-processing 0**

Data sub-processing 3

First data stream 3 → Inner-code encoding → Periodic insertion of an alignment marker → PAM4 modulation → Modulated symbol stream 3

Second data stream    Third data stream

**Data sub-processing 3**

[FIG. 22(d)]

Manner 0 of generating an alignment marker

Perform inner-code encoding on alignment marker information including $b_0 \times K$ target bits to obtain $b_0$ target codewords

↓

Perform eight-way codeword interleaving on the $b_0$ target codewords to obtain the alignment marker

Manner 1 of generating an alignment marker

Perform inner-code encoding on alignment marker information including $b_1 \times K$ target bits to obtain $b_1$ target codewords

↓

Perform codeword merging on the $b_1$ target codewords to obtain the alignment marker

Periodic insertion of an alignment marker → PAM4 modulation →

Second data stream    Third data stream

[FIG. 23]

Data sub-processing 0: Eight data streams → Periodic insertion of a first marker (×8) → Eight second data streams → Inner-code encoding (×8) → Eight third data streams → Channel interleaving (inner codeword interleaving) → Data stream obtained through the channel interleaving → PAM4 modulation → Modulated symbol stream 0

Data sub-processing 3: Eight data streams → Periodic insertion of a first marker (×8) → Eight second data streams → Inner-code encoding (×8) → Eight third data streams → Channel interleaving (inner codeword interleaving) → Data stream obtained through the channel interleaving → PAM4 modulation → Modulated symbol stream 3

EP 4 593 321 A1

[FIG. 24]

$\widetilde{W}$-bit first marker   $\widetilde{P}$ bits

Data sub-processing

Periodic insertion of a first marker → ... 010110 ... 010110
Synchronization subsequence 0

Periodic insertion of a first marker → ... 011010 ... 011010
Synchronization subsequence 1

Periodic insertion of a first marker → ... 100111 ... 100111
Synchronization subsequence 2

Periodic insertion of a first marker → ... 010001 ... 010001
Synchronization subsequence 3

Periodic insertion of a first marker → ... 011010 ... 011010
Synchronization subsequence 4

Periodic insertion of a first marker → ... 011001 ... 011001
Synchronization subsequence 5

Periodic insertion of a first marker → ... 000110 ... 000110
Synchronization subsequence 6

Periodic insertion of a first marker → ... 101011 ... 101011
Synchronization subsequence 7

Eight second data streams

EP 4 593 321 A1

[FIG. 25]

48-bit synchronization
sequence

Eight interleaved first markers
including 960 bits in total

Eight interleaved inner-code
parity bits including 64 bits in
total

EP 4 593 321 A1

| Periodic insertion of a first marker | → | Inner-code encoding | → |
| Periodic insertion of a first marker | → | Inner-code encoding | → |
| ⋮ | | ⋮ | |
| Periodic insertion of a first marker | → | Inner-code encoding | → |

Channel
interleaving
(inner
codeword
interleaving)

PAM4
modulation

Data stream obtained
through the channel
interleaving

Modulated
symbol stream
0

Eight data streams        Eight second data streams    Eight third data streams    **Data sub-processing 0**

100

[FIG. 26]

$\widetilde{W}$-bit first marker    $\widetilde{P}$ bits

Data sub-processing

Periodic insertion of a first marker

... 01011010    01011010

Synchronization subsequence 0

Periodic insertion of a first marker

... 01101001    01101001

Synchronization subsequence 1

Periodic insertion of a first marker

... 10010110    10010110

Synchronization subsequence 2

Periodic insertion of a first marker

... 01001011    01001011

Synchronization subsequence 3

Periodic insertion of a first marker

... 01 10    01 10

Synchronization subsequence 4

Periodic insertion of a first marker

... 01 10    01 10

Synchronization subsequence 5

Periodic insertion of a first marker

... 00 11    00 11

Synchronization subsequence 6

Periodic insertion of a first marker

... 10 01    10 01

Synchronization subsequence 7

Eight second data streams

EP 4 593 321 A1

[FIG. 27]

First part of a
synchronization
sequence, including
24 bits in total

Second part of the
synchronization
sequence, including
24 bits in total

Eight bits

...

...

Eight interleaved first markers
including 960 bits in total

Eight interleaved inner-code
parity bits including 64 bits in
total

EP 4 593 321 A1

Periodic insertion
of a first marker

Inner-code
encoding

Periodic insertion
of a first marker

Inner-code
encoding

⋮

⋮

Periodic insertion
of a first marker

Inner-code
encoding

Channel
interleaving
(inner
codeword
interleaving)

PAM4
modulation

Data stream obtained
through the channel
interleaving

Modulated
symbol stream
0

Eight data streams     Eight second data streams   Eight third data streams   **Data sub-processing 0**

[FIG. 28]

Data sub-processing 0

Eight data streams    Eight second data streams    Eight third data streams

Data sub-processing 7

Eight data streams    Eight second data streams    Eight third data streams

EP 4 593 321 A1

[FIG. 29]

First part of a synchronization subsequence, including 24 bits in total

Eight bits

Second part of the synchronization subsequence, including 24 bits in total

Data sub-processing

Periodic insertion of a first marker → Synchronization subsequence 0

Periodic insertion of a first marker → Synchronization subsequence 1

Periodic insertion of a first marker → Synchronization subsequence 2

Periodic insertion of a first marker → Synchronization subsequence 3

Periodic insertion of a first marker → Synchronization subsequence 4

Periodic insertion of a first marker → Synchronization subsequence 5

Periodic insertion of a first marker → Synchronization subsequence 6

Periodic insertion of a first marker → Synchronization subsequence 7

Eight second data streams

[FIG. 30]

EP 4 593 321 A1

[FIG. 31]

[FIG. 32]

Four first data streams

Convolutional interleaving → Distribution

Cyclic shift → Periodic insertion of a first marker → Inner-code encoding

Cyclic shift → Periodic insertion of a first marker → Inner-code encoding

Convolutional interleaving → Distribution

Cyclic shift → Periodic insertion of a first marker → Inner-code encoding

Cyclic shift → Periodic insertion of a first marker → Inner-code encoding

Channel interleaving (inner codeword interleaving) → PAM4 modulation → Modulated symbol stream 0

Two input data streams

Four first data streams      Eight second data streams      Eight third data streams

Data stream obtained through the channel interleaving

**Data sub-processing 0**

Four first data streams

Convolutional interleaving → Distribution

Cyclic shift → Periodic insertion of a first marker → Inner-code encoding

Cyclic shift → Periodic insertion of a first marker → Inner-code encoding

Convolutional interleaving → Distribution

Cyclic shift → Periodic insertion of a first marker → Inner-code encoding

Cyclic shift → Periodic insertion of a first marker → Inner-code encoding

Channel interleaving (inner codeword interleaving) → PAM4 modulation → Modulated symbol stream 3

Two input data streams

Four first data streams      Eight second data streams      Eight third data streams

Data stream obtained through the channel interleaving

**Data sub-processing 3**

EP 4 593 321 A1

[FIG. 33]

Input data stream 0 → Convolutional interleaving → Distribution → Eight first data streams

Cyclic shift → Periodic insertion of a first marker → Inner-code encoding

Cyclic shift → Periodic insertion of a first marker → Inner-code encoding

Cyclic shift → Periodic insertion of a first marker → Inner-code encoding

Eight second data streams    Eight third data streams

Channel interleaving (inner codeword interleaving) → PAM4 modulation → Modulated symbol stream 0

Data stream obtained through the channel interleaving

**Data sub-processing 0**

Input data stream 3 → Convolutional interleaving → Distribution → Eight first data streams

Cyclic shift → Periodic insertion of a first marker → Inner-code encoding

Cyclic shift → Periodic insertion of a first marker → Inner-code encoding

Cyclic shift → Periodic insertion of a first marker → Inner-code encoding

Eight second data streams    Eight third data streams

Channel interleaving (inner codeword interleaving) → PAM4 modulation → Modulated symbol stream 3

Data stream obtained through the channel interleaving

**Data sub-processing 3**

EP 4 593 321 A1

108

[FIG. 34]

Data processing apparatus

701 First data processing unit — 702 Second data processing unit — 703 Third data processing unit

[FIG. 35]

Data processing apparatus

801 Data processing unit — 802 Synchronization unit

[FIG. 36]

Data processing apparatus

901 Processor — 902 Memory — 903 Transceiver

## INTERNATIONAL SEARCH REPORT

| International application No. |
| --- |
| **PCT/CN2023/108745** |

| A. | CLASSIFICATION OF SUBJECT MATTER |
| --- | --- |

H04L 7/033(2006.01)i

According to International Patent Classification (IPC) or to both national classification and IPC

| B. | FIELDS SEARCHED |
| --- | --- |

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

CNABS, CNTXT, VEN, DWPI, ENTXT, 3GPP: 前向纠错, FEC, 编码, 数据流, 码字, 比特序列, 调制符号, 波特率, 参考时钟频率, 卷积交织, 延迟线, 帧同步; Forward Error Correction, encoding, data stream, codeword, bit sequence, modulation symbol, baud rate, reference clock frequency, convolutional interleaving, delay line, frame synchronization

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 114430278 A (HUAWEI TECHNOLOGIES CO., LTD.) 03 May 2022 (2022-05-03) description, paragraphs [0005]-[0044] | 1-142 |
| A | CN 113875177 A (HUAWEI TECHNOLOGIES CO., LTD.) 31 December 2021 (2021-12-31) entire document | 1-142 |
| A | US 2022302928 A1 (MARVELL ASIAN PTE. LTD.) 22 September 2022 (2022-09-22) entire document | 1-142 |
| A | WO 2022088709 A1 (HUAWEI TECHNOLOGIES CO., LTD.) 05 May 2022 (2022-05-05) entire document | 1-142 |
| A | WO 2022156767 A1 (HUAWEI TECHNOLOGIES CO., LTD.) 28 July 2022 (2022-07-28) entire document | 1-142 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **06 November 2023** | **07 November 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/108745**

| Patent document cited in search report | | | Publication date (day/month/year) | Patent family member(s) | | | Publication date (day/month/year) |
|---|---|---|---|---|---|---|---|
| CN | 114430278 | A | 03 May 2022 | None | | | |
| CN | 113875177 | A | 31 December 2021 | US | 2022077875 | A1 | 10 March 2022 |
| | | | | US | 2022077958 | A1 | 10 March 2022 |
| | | | | BR | 112021022737 | A2 | 15 February 2022 |
| | | | | CA | 3178909 | A1 | 19 November 2020 |
| | | | | WO | 2020227976 | A1 | 19 November 2020 |
| | | | | CA | 3177569 | A1 | 19 November 2020 |
| | | | | JP | 2022533326 | A | 22 July 2022 |
| | | | | EP | 3965325 | A1 | 09 March 2022 |
| | | | | EP | 3965325 | A4 | 26 October 2022 |
| | | | | BR | 112021022883 | A2 | 04 January 2022 |
| | | | | JP | 2022533081 | A | 21 July 2022 |
| | | | | EP | 3958485 | A1 | 23 February 2022 |
| | | | | EP | 3958485 | A4 | 23 March 2022 |
| | | | | WO | 2020228126 | A1 | 19 November 2020 |
| US | 2022302928 | A1 | 22 September 2022 | US | 11575391 | B2 | 07 February 2023 |
| WO | 2022088709 | A1 | 05 May 2022 | US | 2023268932 | A1 | 24 August 2023 |
| | | | | EP | 4228160 | A1 | 16 August 2023 |
| WO | 2022156767 | A1 | 28 July 2022 | AU | 2022211512 | A1 | 10 August 2023 |
| | | | | KR | 20230129554 | A | 08 September 2023 |
| | | | | CA | 3206435 | A1 | 28 July 2022 |

Form PCT/ISA/210 (patent family annex) (July 2022)

**REFERENCES CITED IN THE DESCRIPTION**

**Patent documents cited in the description**

- CN 202211307290
- CN 202211559068

- CN 202310631032